# EUROPEAN PATENT APPLICATION

(11) **EP 3 439 282 A1**
(43) Date of publication of application: **06.02.2019**
(21) Application number: 17775250.8
(22) Date of filing: 29.03.2017
(51) Int. Cl.: H04N 5/232, G02B 7/28, G03B 7/091, G03B 13/36, H01L 27/14, H04N 5/345, H04N 5/374

(54) **IMAGE PICKUP DEVICE, IMAGE PROCESSING DEVICE, AND ELECTRONIC APPARATUS**

(30) Priority: 31.03.2016 JP 2016071974
(71) Applicant: Nikon Corporation, Tokyo 108-6290 (JP)
(72) Inventor: SEKIGUCHI, Naoki, Tokyo 108-6290 (JP); SHIONOYA, Takashi, Tokyo 108-6290 (JP); KANBARA, Toshiyuki, Tokyo 108-6290 (JP)
(74) Representative: Hoffmann Eitle
(86) International application number: PCT/JP2017/012957
(87) International publication number: WO 2017/170716

(57) **Abstract**

An imaging device includes: an image capture unit having a first image capture region that performs image capture under first image capture conditions, and a second image capture region that performs image capture under second image capture conditions that are different from the first image capture conditions; and a generation unit that generates an image of a photographic subject captured in the first image capture region according to image data based on light captured under the second image capture conditions.

## Description

### TECHNICAL FIELD

The present invention relates to an imaging device, to an image processing device, and to an electronic apparatus.

### BACKGROUND ART

An imaging device equipped with image processing technology for generating an image based on a signal from an imaging element is per se known (refer to PTL1).

From the past, there have been demands for improvement of imaging quality.

### CITATION LIST

### PATENT LITERATURE

PTL 1: Japanese Laid-Open Patent Publication No. 2006-197192.

### SUMMARY OF INVENTION

According to a first aspect, an imaging device comprises: an image capture unit having a first image capture region that performs image capture under first image capture conditions, and a second image capture region that performs image capture under second image capture conditions that are different from the first image capture conditions; and a generation unit that generates an image of a photographic subject captured in the first image capture region according to image data based on light captured under the second image capture conditions.

According to a second aspect, an imaging device comprises: an image capture unit having a first image capture region that performs image capture under first image capture conditions, and a second image capture region that performs image capture under second image capture conditions that are different from the first image capture conditions; and a generation unit that generates image data for a photographic subject captured in the first image capture region according to image data based on light captured under the second image capture conditions.

According to a third aspect, an imaging device comprises: an image capture unit having a first image capture region that performs image capture under first image capture conditions, and a second image capture region that performs image capture under second image capture conditions that are different from said first image capture conditions; and a generation unit that generates an image of a photographic subject captured in the first image capture region according to image data based on light captured under image capture conditions that are different from the first image capture conditions.

According to a fourth aspect, an image processing device comprises: an input unit that receives image data from an image capture unit having a first image capture region that performs image capture under first image capture conditions, and a second image capture region that performs image capture under second image capture conditions that are different from the first image capture conditions; and a generation unit that generates an image of a photographic subject captured in the first image capture region according to image data based on light captured under the second image capture conditions.

According to a fifth aspect, an image processing device comprises: an input unit that receives image data from an image capture unit having a first image capture region that performs image capture under first image capture conditions, and a second image capture region that performs image capture under second image capture conditions that are different from the first image capture conditions; and a generation unit that generates image data for a photographic subject captured in the first image capture region according to image data based on light captured under the second image capture conditions.

According to a sixth aspect, an image processing device comprises: an input unit that receives image data from an image capture unit having a first image capture region that performs image capture under first image capture conditions, and a second image capture region that performs image capture under second image capture conditions that are different from the first image capture conditions; and a generation unit that generates an image of a photographic subject captured in the first image capture region according to image data based on light captured under image capture conditions that are different from the first image capture conditions.

According to a seventh aspect, an electronic apparatus comprises: a first imaging element having a plurality of image capture regions that capture a photographic subject; a second imaging element that captures a photographic subject; a setting unit that sets for a first image capture region image capture conditions that are different from those set for a second image capture region among the plurality of image capture regions of the first imaging element; and a generation unit that generates an image by correcting a part of an image signal of the photographic subject from the first image capture region, among the plurality of image capture regions, captured under first image capture conditions, according to an image signal of the photographic subject captured by the second imaging element so that as if it was captured under second image capture conditions.

According to an eighth aspect, an electronic apparatus comprises: a first imaging element in which a plurality of pixels are arranged, and having a first image capture region and a second image capture region that capture a photographic subject; a second imaging element in which a plurality of pixels are arranged, and that captures a photographic subject; a setting unit that sets for the first image capture region image capture conditions that are different from image capture conditions set for the second image capture region; and a generation unit that generates an image of the photographic subject captured in the first image capture region, according to a signal from a pixel, among the pixels arranged in the first image capture region of the first imaging element and the pixels arranged in the second imaging element, that is selected by employing a signal from the pixels arranged in the first image capture region.

According to a ninth aspect, an electronic apparatus comprises: an imaging element having a plurality of image capture regions that capture a photographic subject; a setting unit that sets for a first image capture region image capture conditions that are different from those set for a second image capture region among the plurality of image capture regions of the imaging element; and a generation unit that generates an image by correcting a part of an image signal of the photographic subject from the first image capture region, among the plurality of image capture regions, captured under first image capture conditions, according to an image signal of the photographic subject from the first image capture region captured under second image capture conditions so that as if it was captured under the second image capture conditions.

According to a tenth aspect, an electronic apparatus comprises: an imaging element upon which a plurality of pixels are arranged, and having a first image capture region and a second image capture region that capture a photographic subject; a setting unit that sets for the first image capture region image capture conditions that are different from image capture conditions set for the second image capture region; and a generation unit that generates an image of the photographic subject captured in the first image capture region according to a signal from a pixel selected from among the pixels arranged in the first image capture region for which first image capture conditions are set by the setting unit and the pixels arranged in the first image capture region for which second image capture conditions have been set by the setting unit by employing a signal from the pixels arranged in the first image capture region for which the first image capture conditions are set by the setting unit.

### BRIEF DESCRIPTION OF DRAWINGS

Fig. 1 is a block diagram showing an example of the structure of a camera according to a first embodiment;
Fig. 2 is a sectional view of a laminated type imaging element;
Fig. 3 is a figure for explanation of a pixel array upon an image capture chip, and of unit regions thereof;
Fig. 4 is a figure for explanation of circuitry in a unit region;
Fig. 5 is a figure schematically showing an image of a photographic subject formed on an imaging element of the camera;
Fig. 6 is a figure showing an example of a setting screen for image capture conditions;
Fig. 7(a) is a figure showing an example of a predetermined range in the live view image, and Fig. 7(b) is an enlarged view of that predetermined range;
Fig. 8(a) is a figure showing an example of main image data corresponding to Fig. 7(b), and Fig. 8(b) is a figure showing image data for processing corresponding to Fig. 7(b);
Fig. 9(a) is a figure showing an example of a region for attention in a live view image, and Fig. 9(b) is an enlarged view of a pixel for attention and reference pixels Pr;
Fig. 10(a) is a figure showing an example of an arrangement of photoelectrically converted signals outputted from pixels, Fig. 10(b) is a figure for explanation of interpolation of image data of the G color component, and Fig. 10(c) is a figure showing an example of image data of the G color component after interpolation;
Fig. 11(a) is a figure showing image data for the R color component extracted from Fig. 10(a), Fig. 11(b) is a figure for explanation of interpolation of the Cr color difference component, and Fig. 11(c) is a figure for explanation of interpolation of the image data for the Cr color difference component;
Fig. 12(a) is a figure showing image data for the B color component extracted from Fig. 10(a), Fig. 12(b) is a figure for explanation of interpolation of the Cb color difference component, and Fig. 12(c) is a figure for explanation of interpolation of the image data for the Cb color difference component;
Fig. 13 is a figure showing an example of positions of pixels for focus detection on an imaging surface;
Fig. 14 is a figure in which a part of the area of a focus detection pixel line is shown as enlarged;
Fig. 15 is a figure in which a point of focusing is shown as enlarged;
Fig. 16(a) is a figure showing an example of a template image representing a object to be detected, and Fig. 16(b) is a figure showing examples of a live view image and a search range;

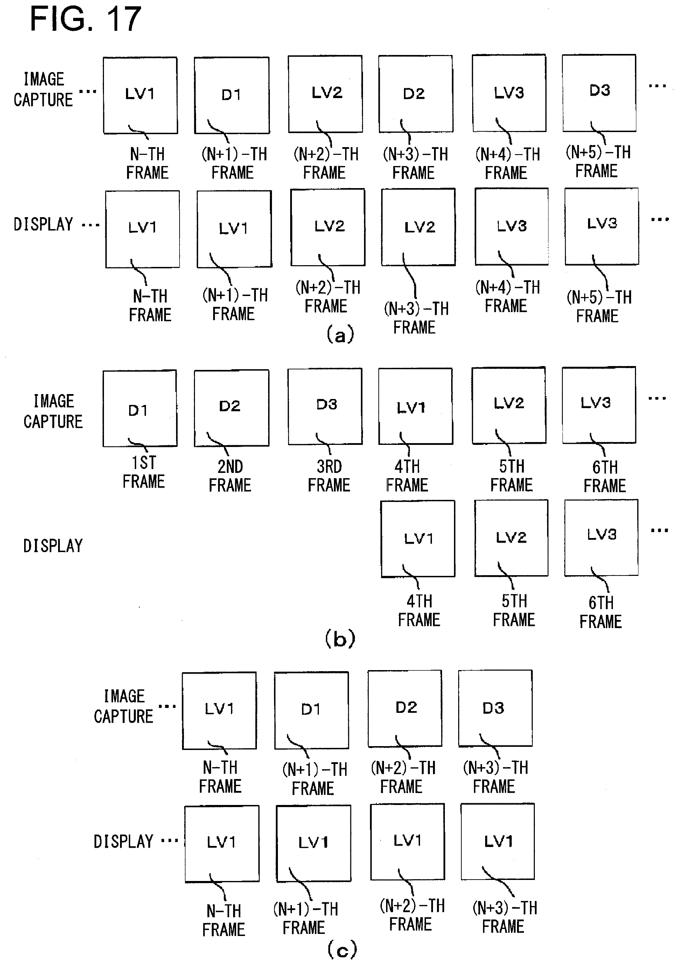

Fig. 17 shows figures showing examples of various relationships between the capture timing for a live view image and the capture timing for image data for processing: Fig. 17(a) is a figure showing an example in which capture of the live view image and capture of the image data for processing are performed alternatingly, Fig. 17(b) is a figure showing an example in which the image data for processing is captured before display of the live view image starts, and Fig. 17(c) is a figure showing an example in which the image data for processing is captured when display of the live view image terminates;
Fig. 18 is a flow chart for explanation of a processing flow for setting image capture conditions for various regions and performing image capture;
Figs. 19(a) through 19(c) are figures showing various examples of arrangement of a first image capture region and a second image capture region upon the imaging surface of the imaging element;
Fig. 20 is a block diagram showing an example of the structure of an image capturing system according to an eleventh variant embodiment;
Fig. 21 is a figure for explanation of supply of a program to a mobile device;
Fig. 22 is a block diagram showing an example of the structure of a camera according to a second embodiment;
Fig. 23 is a figure schematically showing a correspondence relationship in the second embodiment between various blocks and a plurality of correction units;
Fig. 24 is a sectional view of a laminated type imaging element;
Fig. 25 is a figure relating to image processing, schematically showing processing of first image data and second image data;
Fig. 26 is a figure relating to focus detection processing, schematically showing processing of first image data and second image data;
Fig. 27 is a figure relating to photographic subject detection processing, schematically showing processing of first image data and second image data;
Fig. 28 is a figure relating to setting of image capture conditions such as exposure calculation processing and so on, schematically showing processing of first image data and second image data; and
Fig. 29 is a figure schematically showing processing of first image data and second image data according to a thirteenth variant embodiment.

### DESCRIPTION OF EMBODIMENTS

### First Embodiment

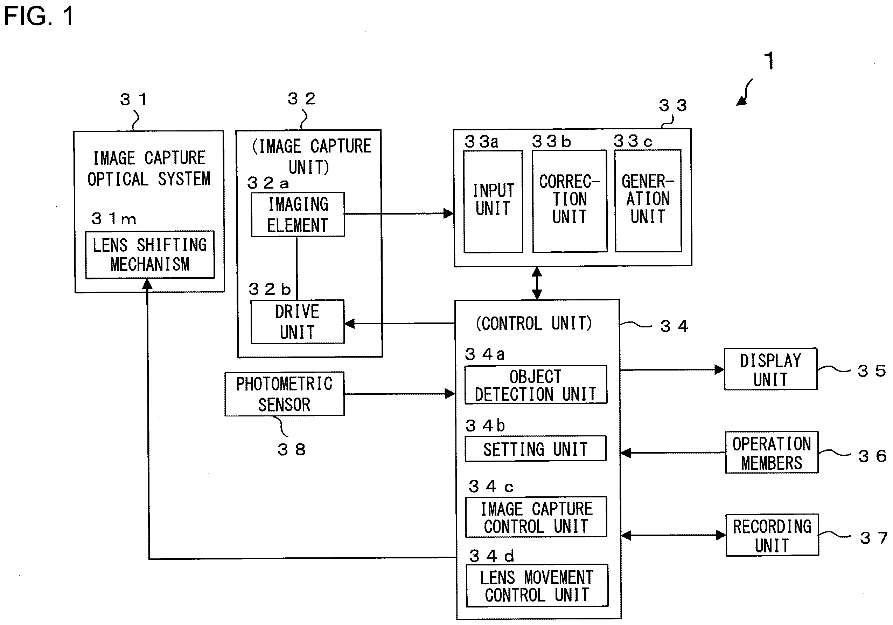

As one example of an electronic apparatus equipped with an image processing device according to a first embodiment of the present invention, a digital camera will now be explained by way of example. A camera 1 (refer to Fig. 1) is adapted to be capable of performing image capture under different conditions for each of various regions upon the imaging surface of an imaging element 32a. An image processing unit 33 performs appropriate image processing for each of these regions, for which the image capture conditions are different. The details of this type of camera 1 will now be explained with reference to the drawings.

### Explanation of the Camera

Fig. 1 is a block diagram showing an example of the structure of this camera 1 according to the first embodiment of the present invention. As shown in Fig. 1, the camera 1 comprises an image capture optical system 31, an image capture unit 32, an image processing unit 33, a control unit 34, a display unit 35, operation members 36, and a recording unit 37.

The image capture optical system 31 conducts a light flux from the photographic field to the image capture unit 32. The image capture unit 32 includes an imaging element 32a and a drive unit 32b, and photoelectrically converts an image of the photographic subject formed by the image capture optical system 31. The image capture unit 32 is capable of performing image capturing under the same image capture conditions for the entire area of the imaging surface of the imaging element 32a, and is also capable of performing image capturing under different image capture conditions for each of various regions of the imaging surface of the imaging element 32a. The details of the image capture unit 32 will be described hereinafter. The drive unit 32b generates a drive signal that is required in order for the imaging element 32a to perform accumulation control. Image capture commands for the image capture unit 32, such as the time period for charge accumulation and so on, are transmitted from the control unit 34 to the drive unit 32b.

The image processing unit 33 comprises an input unit 33a, a correction unit 33b, and a generation unit 33c. Image data acquired by the image capture unit 32 is inputted to the input unit 33a. The correction unit 33b performs pre processing in which correction is performed upon the image data that has been inputted as described above. The details of this pre processing will be described hereinafter. The generation unit 33c performs image processing upon the above-described inputted image data and the image data after pre processing, and generates an image. This image processing may include, for example, color interpolation processing, pixel defect correction processing, contour enhancement processing, noise reduction processing, white balance adjustment processing, gamma correction processing, display luminance adjustment processing, saturation adjustment processing, and so on. Furthermore, the generation unit 33c generates an image that is displayed by the display unit 35.

The control unit 34 may, for example, include a CPU, and controls the overall operation of the camera 1. For example, the control unit 34 performs predetermined exposure calculation on the basis of the photoelectrically converted signals acquired by the image capture unit 32, determines exposure conditions that are required for appropriate exposure, such as a charge accumulation time (i.e. an exposure time) for the imaging element 32a, an aperture value for the image capture optical system 31, an ISO sensitivity, and so on, and issues appropriate commands to the drive unit 32b. Moreover, the control unit 34 determines appropriate image processing conditions for adjustment of the saturation, the contrast, the sharpness and so on according to the scene imaging mode set for the camera 1 and the type of photographic subject elements that have been detected, and issues corresponding commands to the image processing unit 33. The detection of the elements of the photographic subject will be described hereinafter.

The control unit 34 comprises an object detection unit 34a, a setting unit 34b, an image capture control unit 34c, and a lens movement control unit 34d. While these are implemented in software by the control unit 34 executing programs stored in a non volatile memory not shown in the figures, alternatively they may be implemented by providing ASICs or the like.

By performing per se known object recognition processing, the object detection unit 34a detects elements of the photographic subject from the image acquired by the image capture unit 32, such as a person (i.e. the face of a person), an animal such as a dog or a cat (i.e. the face of an animal), a plant, a vehicle such as a bicycle, an automobile or a train, a building, a stationary object, a landscape such as mountains or clouds, or an object that has been specified in advance, and so on. The setting unit 34b subdivides the imaging screen from the image capture unit 32 into a plurality of regions that include the elements of the photographic subject detected as described above.

Furthermore, the setting unit 34b sets image capture conditions for the plurality of regions. These image capture conditions include the exposure conditions described above (i.e. the charge accumulation time, the gain, the ISO sensitivity, the frame rate, and so on) and the image processing conditions described above (for example, a parameter for white balance adjustment, a gamma correction curve, a parameter for display luminance adjustment, a saturation adjustment parameter, and so on). It should be noted that it would be possible for the same image capture conditions to be set for all of the plurality of regions, or it would also be possible for different image capture conditions to be set for each of the plurality of regions.

The image capture control unit 34c controls the image capture unit 32 (i.e. its imaging element 32a) and the image processing unit 33 by applying the image capture conditions that have been set by the setting unit 34b for each of the regions. Due to this, it is possible for the image capture unit 32 to perform image capture under different exposure conditions for each of the plurality of regions, and it is possible for the image processing unit 33 to perform image processing under different image processing conditions for each of the plurality of regions. The number of pixels making up each of the regions may be any desired number; for example, a thousand pixels would be acceptable, or one pixel would also be acceptable. Furthermore, the numbers of pixels in different regions may also be different.

The lens movement control unit 34d controls the automatic focus adjustment operation (auto focus: A/F) so as to set the focus at the photographic subject corresponding to a predetermined position upon the imaging screen (this point is referred to as the "point of focusing"). When the focus is adjusted, the sharpness of the image of the photographic subject is enhanced. In other words, the image formed by the image capture optical system 31 is adjusted by shifting a focusing lens of the image capture optical system 31 along the direction of the optical axis. On the basis of the result of calculation, the lens movement control unit 34d sends, to a lens shifting mechanism 31m of the image capture optical system 31, a drive signal for causing the focusing lens of the image capture optical system 31 to be shifted to a focusing position, for example a signal for adjusting the image of the photographic subject by the focusing lens of the image capture optical system 31. In this manner, the lens movement control unit 34d functions as a shifting unit that causes the focusing lens of the image capture optical system 31 to be shifted along the direction of the optical axis on the basis of the result of calculation. The processing for A/F operation performed by the lens movement control unit 34d is also referred to as focus detection processing. The details of this focus detection processing will be described hereinafter.

The display unit 35 reproduces and displays an image that has been generated or an image that has been image processed by the image processing unit 33, or an image read out by the recording unit 37 or the like. The display unit 35 also performs display of an operation menu screen, display of a setting screen for setting image capture conditions, and so on.

The operation members 36 include operation members of various types, such as a release button and a menu button and so on. Upon being operated, the operation members 36 send operation signals to the control unit 34. The operation members 36 also may include a touch operation member that is provided upon the display surface of the display unit 35.

According to a command from the control unit 34, the recording unit 37 records the image data or the like upon a recording medium such as a memory card or the like, not shown in the figures. Furthermore, the recording unit 37 reads out image data recorded upon the recording medium in response to a command from the control unit 34. A photometric sensor 38 outputs an image signal for photometry corresponding to the brightness of the image of the photographic subject. The photometric sensor 38 may, for example, is constituted with a CMOS image sensor or the like.

### Explanation of a Laminated Type Imaging Element

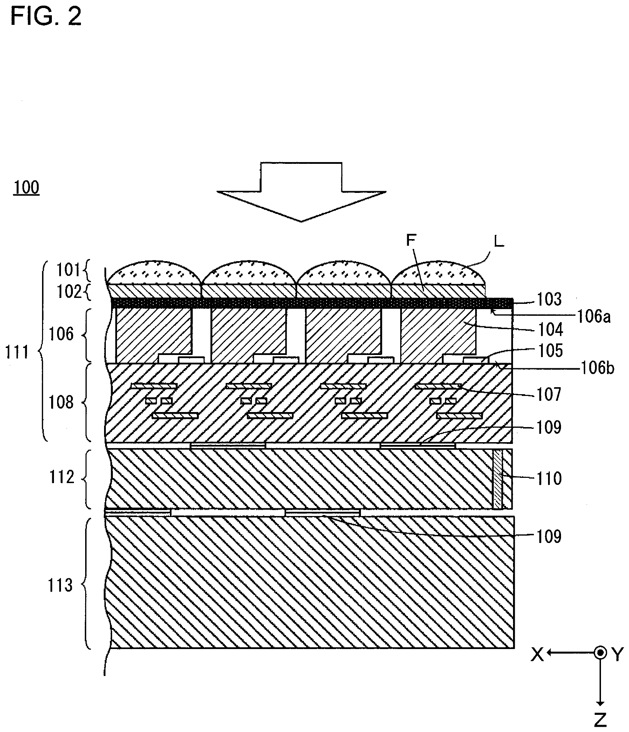

As an example of the imaging element 32a described above, a laminated type imaging element 100 will now be explained. Fig. 2 is a sectional view of this imaging element 100. The imaging element 100 comprises an image capture chip 111, a signal processing chip 112, and a memory chip 113. The image capture chip 111 is laminated upon the signal processing chip 112. And the signal processing chip 112 is laminated upon the memory chip 113. The image capture chip 111 and the signal processing chip 112 are electrically connected together by connection portions 109, and so are the signal processing chip 112 and the memory chip 113. These connection portions 109 may, for example, be bumps or electrodes. The image capture chip 111 captures an optical image of the photographic subject and generates image data. The image capture chip 111 outputs the image data from the image capture chip 111 to the signal processing chip 112. And the signal processing chip 112 performs signal processing upon the image data outputted from the image capture chip 111. The memory chip 113 includes a plurality of memories, and stores the image data. It should be understood that it would also be acceptable for the imaging element 100 to be built from an image capture chip and a signal processing chip. If the imaging element 100 is built from an image capture chip and a signal processing chip, then it will be acceptable for a storage unit for storing the image data to be provided to the signal processing chip, or to be provided separately from the imaging element 100.

As shown in Fig. 2, incident light principally enters along the +Z axis direction, as shown by the outlined white arrow sign. Moreover, as shown on the coordinate axes, the leftward direction upon the drawing paper which is orthogonal to the Z axis is taken as being the +X axis direction, and the direction perpendicular to the Z axis from the drawing paper and toward the viewer is taken as being the +Y axis direction. In some of the subsequent figures coordinate axes are displayed so that, taking the coordinate axes shown in Fig. 2 as reference, the orientation of each figure can be understood.

The image capture chip 111 may, for example, be a CMOS image sensor. In concrete terms, the image capture chip 111 is a backside illuminated type CMOS image sensor. The image capture chip 111 comprises a micro lens layer 101, a color filter layer 102, a passivation layer 103, a semiconductor layer 106, and a wiring layer 108. In this imaging chip 111, the micro lens layer 101, the color filter layer 102, the passivation layer 103, the semiconductor layer 106, and the wiring layer 108 are arranged in that order in the +Z axis direction.

The micro lens layer 101 includes a plurality of micro-lenses L. Each of these micro-lenses L condenses incident light upon one of photoelectric conversion units 104, as will be described hereinafter. A single pixel, or a single filter, corresponds to a single micro-lens L. The color filter layer 102 includes a plurality of color filters F. The color filter layer 102 includes color filters F of a plurality of types having different spectral characteristics. In concrete terms, the color filter layer 102 includes first filters (R) having a spectral characteristic of principally passing light of a red color component, second filters (Gb, Gr) having a spectral characteristic of principally passing light of a green color component, and third filters (B) having a spectral characteristic of principally passing light of a blue color component. For example, the first filters, the second filters, and the third filters may be arranged in the color filter layer 102 in a Bayer array. The passivation layer 103 is made from a nitride film or an oxide film, and protects the semiconductor layer 106.

The semiconductor layer 106 comprises a photoelectric conversion unit 104 and a readout circuit 105. The semiconductor layer 106 includes a plurality of photoelectric conversion units 104 between a first surface 106a, which is its surface upon which light is incident, and a second surface 106b, which is on its side opposite to the first surface 106a. In the semiconductor layer 106, the plurality of photoelectric conversion units 104 are arrayed along the X axis direction and the Y axis direction. The photoelectric conversion units 104 have a photoelectric conversion function of converting light into electrical charge. Moreover, the photoelectric conversion units 104 accumulate the charges of these photoelectrically converted signals. These photoelectric conversion units 104 may, for example, be photodiodes. The semiconductor layer 106 is provided with the readout circuits 105 that are positioned closer to the second surface 106b than the photoelectric conversion units 104 are. In the semiconductor layer 106, the plurality of readout circuits 105 are arrayed along the X axis direction and the Y axis direction. Each of these readout circuits 105 comprises a plurality of transistors, and they read out image data generated based on the charges having been generated by photoelectric conversion by the photoelectric conversion units 104 and output this data to the wiring layer 108.

The wiring layer 108 includes a plurality of metallic layers. These metallic layers, for example, include Al wiring, Cu wiring, or the like. The image data that has been read out by the readout circuits 105 is outputted to this wiring layer 108. The image data is outputted from the wiring layer 108 via the connection portions 109 to the signal processing chip 112.

It should be understood that each one of the connection portions 109 may be provided for one of the photoelectric conversion units 104. Alternatively, each one of the connection portions 109 may be provided for a plurality of the photoelectric conversion units 104. If each one of the connection portions 109 is provided for a plurality of the photoelectric conversion units 104, then the pitch of the connection portions 109 may be greater than the pitch of the photoelectric conversion units 104. Furthermore, the connection portions 109 may be provided in a region that is peripheral to the region in which the photoelectric conversion units 104 are disposed.

The signal processing chip 112 includes a plurality of signal processing circuits. These signal processing circuits perform signal processing upon the image data outputted from the image capture chip 111. The signal processing circuits may each, for example, include an amplification circuit that amplifies the value of the image data signal, a correlated double sampling circuit that performs noise reduction processing upon the image data, an analog/digital (A/D) conversion circuit that converts the analog signal into a digital signal, and so on. One such signal processing circuit may be provided for each of the photoelectric conversion units 104.

Alternatively, each one of the signal processing circuits may be provided for a plurality of photoelectric conversion units 104. The signal processing chip 112 includes a plurality of through electrodes or vias 110. These through electrodes 110 may, for example, be through-silicon vias. The through electrodes 110 connect circuits that are provided upon the signal processing chip 112 to each other. The through electrodes 110 may also be provided to the peripheral region of the image capture chip 111, and to the memory chip 113. It should be understood that it would also be acceptable to provide some of the elements of the signal processing circuit upon the image capture chip 111. For example, in the case of an analog/digital conversion circuit, it would be acceptable to dispose a comparator that performs comparison of the input voltage and a reference voltage upon the image capture chip 111, and dispose circuitry such as a counter circuit and/or a latch circuit upon the signal processing chip 112.

The memory chip 113 has a plurality of storage sections. These storage sections store image data upon which signal processing has been performed by the signal processing chip 112. The storage units may, for example, be volatile memories such as DRAMs or the like. Each one of the storage units may be provided for one of the photoelectric conversion units 104. Alternatively, each one of the storage units may be provided for a plurality of the photoelectric conversion units 104. The image data stored in these storage units is outputted to an image processing unit at a subsequent stage.

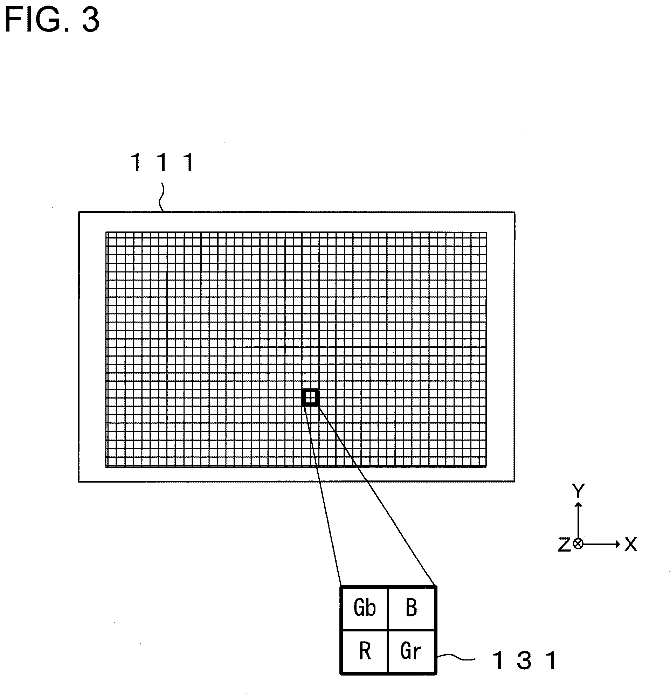

Fig. 3 is a figure for explanation of the pixel array upon the image capture chip 111 and of unit regions 131. In particular, this figure shows a situation in which the image capture chip 111 is being viewed from its back surface side (i.e. from its imaging surface side). For example, 20 million pixels or more may be arrayed in the pixel area in the form of a matrix. In the Fig. 3 example, four adjacent pixels in a 2X2 arrangement constitute a single unit region 131. The grid lines in this figure show this concept of adjacent pixels being grouped together into the unit regions 131. The number of pixels constituting each of the unit regions 131 is not limited to the above; for example, 32X32 pixels would be acceptable, and more or fewer would be acceptable-indeed a single pixel would also be acceptable.

As shown in the enlarged partial view of the pixel area, a unit region 131 in Fig. 3 is configured as a so called Bayer array, and includes four pixels: two green color pixels Gb and Gr, a blue color pixel B, and a red color pixel R. The green color pixels Gb and Gr are pixels that have green filters as their color filters F, and receive light in the green wavelength band in the incident light. In a similar manner, the blue color pixel B is a pixel that has a blue filter as its color filter F and receives light in the blue wavelength band in the incident light, and the red color pixel R is a pixel that has a red filter as its color filter F and receives light in the red wavelength band in the incident light.

In this embodiment of the present invention, a plurality of blocks are defined so as to include at least one of the unit regions 131 per each block. In other words, the minimum unit for one block is a single unit region 131. As described above, among the values that can be taken as the number of pixels constituting a single unit region 131, the smallest number of pixels is one pixel. Accordingly, when defining one block in pixel units, the minimum number of pixels among the pixels that can define one block is one pixel. Each block can control pixels included therein with the control parameters that are different from those set for another block. In each block, all of the unit regions 131 within that block, in other words all of the pixels in that block, are controlled according to the same image capture conditions. In other words, photoelectrically converted signals for which the image capture conditions are different can be acquired from a pixel group that is included in some block, and from a pixel group that is included in a different block. Examples of control parameters are frame rate, gain, decimation ratio, number of rows or number of columns whose photoelectrically converted signals are added together, charge accumulation time or number of times of accumulation, number of digitized bits (i.e. word length), and so on. The imaging element 100 can freely perform decimation, not only in the row direction (i.e. the X axis direction of the image capture chip 111), but also in the column direction (i.e. the Y axis direction of the image capture chip 111). Furthermore, the control parameter may also be a parameter that participates in the image processing.

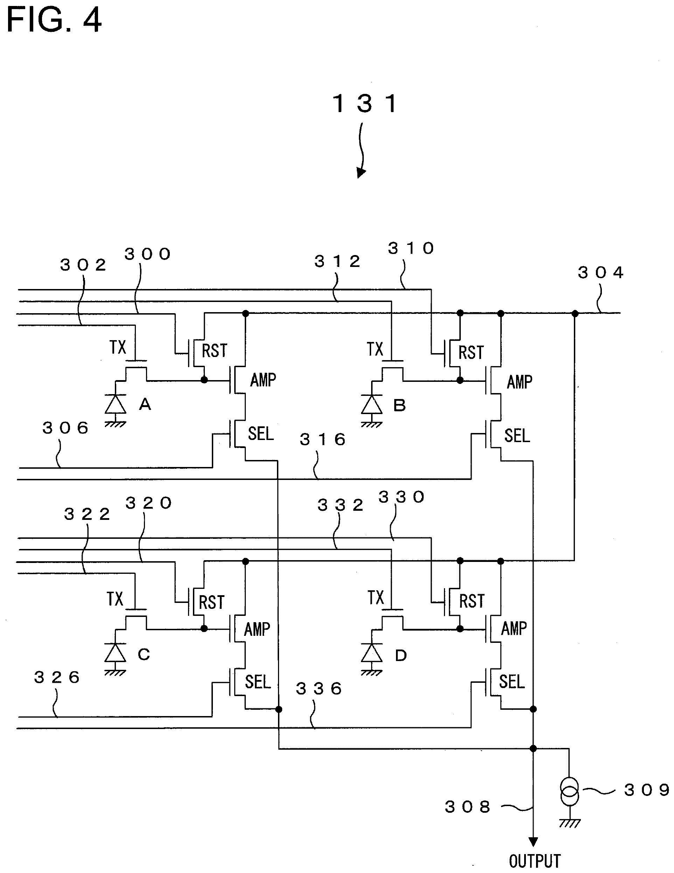

Fig. 4 is a figure for explanation of the circuitry for one of the unit regions 131. In the Fig. 4 example, a single unit region 131 is formed by four adjacent pixels in a 2X2 arrangement. It should be understood that, as described above, the number of pixels included in a unit region 131 is not limited to the above; it could be a thousand pixels or more, or at minimum it could be only one pixel. The two dimensional pixel positions in the unit region 131 are referred to by the reference symbols A through D.

Reset transistors (RST) of the pixels included in the unit region 131 can be turned on and off individually for each of the pixels. In Fig. 4, reset wiring 300 is provided for turning the reset transistor of the pixel A on and off, and reset wiring 310 for turning the reset transistor of the pixel B on and off is provided separately from the above described reset wiring 300. In a similar manner, reset wiring 320 for turning the reset transistor of the pixel C on and off is provided separately from the above described reset wiring 300 and 310. Moreover, dedicated reset wiring 330 is also provided to the other pixel D for turning its reset transistor on and off.

Transfer transistors (TX) of the pixels included in the unit region 131 can also be turned on and off individually for each of the pixels. In Fig. 4, transfer wiring 302 for turning the transfer transistor of the pixel A on and off, transfer wiring 312 for turning the transfer transistor of the pixel B on and off, and transfer wiring 322 for turning the transfer transistor of the pixel C on and off are provided separately. Dedicated transfer wiring 332 is also provided for turning the transfer transistor of the other pixel D on and off.

Furthermore, selection transistors (SEL) of the pixels included in the unit region 131 can also be turned on and off individually for each of the pixels. In Fig. 4, selection wiring 306 for turning the selection transistor of the pixel A on and off, selection wiring 316 for turning the selection transistor of the pixel B on and off, and selection wiring 326 for turning the selection transistor of the pixel C on and off are provided separately. Dedicated selection wiring 336 is also provided for turning the selection transistor of the other pixel D on and off.

It should be understood that power supply wiring 304 is connected in common for all of the pixels A through D included in the unit region 131. In a similar manner, output wiring 308 is also connected in common for all of the pixels A through D included in the unit region 131. Moreover, while the power supply wiring 304 is connected in common for a plurality of unit regions, the output wiring 308 is provided individually for each of the unit regions 131. A load current source 309 supplies current to the output wiring 308. This load current source 309 could be provided at the image capture chip 111, or could be provided at the signal processing chip 112.

By individually turning the reset transistors and the transfer transistors of the unit region 131 on and off, it is possible to control charge accumulation for each of the pixels A through D included in the unit region 131, including their starting times for accumulation of charge, their ending times for accumulation of charge, and their transfer timings. Furthermore, by individually turning the selection transistors of the unit region 131 on and off, it is possible to output the photoelectrically converted signals of each of the pixels A through D via the common output wiring 308.

Here, a so called rolling shutter method is per se known of controlling charge accumulation for the pixels A through D included in the unit region 131 in a regular sequence by rows and columns. According to the rolling shutter method, for each row, when pixels are selected and then columns are designated, in the example of Fig. 4, photoelectrically converted signals are outputted in the order "ABCD".

By building the circuitry in this manner with the unit regions 131 taken as standard, it is possible to control the charge accumulation time for each of the unit regions 131. To put it in another manner, it is possible to output photoelectrically converted signals at frame rates that are different for each of the unit regions 131. Moreover by causing charge accumulation (i.e. image capture) to be performed by unit regions 131 included in some of the blocks on the image capturing chip 111 while allowing the unit regions included in other blocks to stand by, it is possible to cause image capture to be performed only by predetermined blocks of the image capture chip 111 and to output those photoelectrically converted signals. Furthermore, by changing over the blocks for which charge accumulation (i.e. image capture) is performed (i.e. by changing over the subject blocks for charge accumulation control) between frames, it is possible to cause image capture to be performed and output of photoelectric signals to be performed sequentially by different blocks of the image capture chip 111.

As described above, the output wiring 308 is provided to correspond to each of the unit regions 131. Since, in this imaging element 100, the image capture chip 111, the signal processing chip 112, and the memory chip 113 are laminated together, accordingly it is possible to route the wiring without increasing the sizes of the chips in their planar directions by employing, as the output wiring 308, electrical connections between the chips through the connection portions 109.

### Block Control of the Imaging Element

In this embodiment of the present invention, the imaging element is arranged to be possible to set image capture conditions for each of a plurality of blocks upon the imaging element 32a. The image capture control unit 34c of the control unit 34 associates the plurality of regions described above with the blocks described above, so as to cause image capturing to be performed under the image capture conditions that have been set for each of the regions.

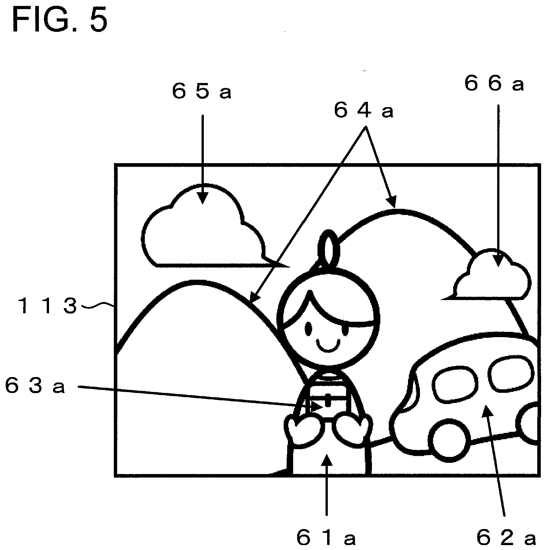

Fig. 5 is a figure schematically showing an image of a photographic subject that has been formed upon the imaging element 32a of the camera 1. Before an image capture command is issued, the camera 1 acquires a live view image by photoelectrically converting an image of the photographic subject. The term "a live view image" refers to an image for monitoring which is captured repeatedly at a predetermined frame rate (for example 60 fps).

Before subdivision into regions by the setting unit 34b, the control unit 34 sets the same image capture conditions for the entire area of the image capture chip 111 (in other words, for the entire imaging screen). By "the same image capture conditions" is meant that common image capture conditions are set over the entire imaging screen; even if there is some variation in the conditions, such as for example the apex value varying by less than around 0.3 steps, they are regarded as being the same. These image capture conditions that are set to be the same over the entire area of the image capture chip 111 are determined on the basis of exposure conditions corresponding to the photometric value of the luminance of the photographic subject, or corresponding to exposure conditions that have been manually set by the user.

In Fig. 5, an image that includes a person 61a, an automobile 62a, a bag 63a, mountains 64a, and clouds 65a and 66a is formed upon the imaging surface of the image capture chip 111. The person 61a is holding the bag 63a with both hands. And the automobile 62a is stopped to the right of the person 61a and behind her.

### Subdivision of the Regions

On the basis of the live view image, the control unit 34 subdivides the live view image screen into a plurality of regions in the following manner. First, elements of the photographic subject are detected from the live view image by the object detection unit 34a. A per se known photographic subject recognition technique may be used for this detection of the elements of the photographic subject. In the example shown in Fig. 5, the person 61a, the automobile 62a, the bag 63a, the mountains 64a, the cloud 65a, and the cloud 66a are detected as elements of the photographic subject.

Next, the setting unit 34b subdivides the live view image screen into regions that include the elements of the photographic subject described above. In this embodiment, the explanation will refer to the region that includes the person 61a as being a first region 61, the region that includes the automobile 62a as being a second region 62, the region that includes the bag 63a as being a third region 63, the region that includes the mountains 64a as being a fourth region 64, the region that includes the cloud 65a as being a fifth region 65, and the region that includes the cloud 66a as being a sixth region 66.

### Setting of the Image Capture Conditions for Each Block

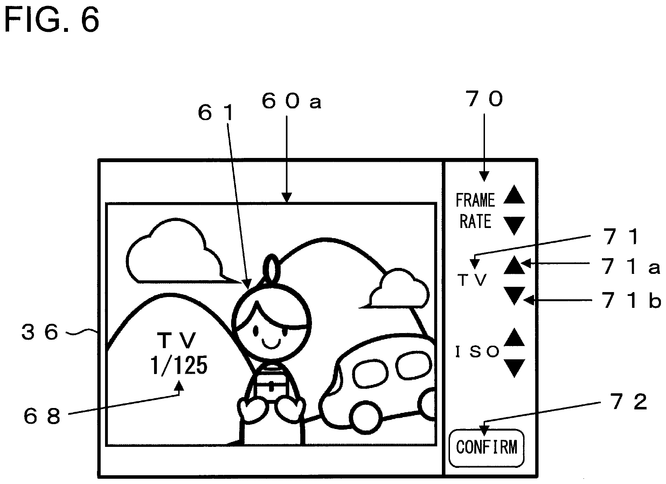

When the screen has thus been subdivided into a plurality of regions by the setting unit 34b, the control unit 34 displays a setting screen as shown by way of example in Fig. 6 upon the display unit 35. In Fig. 6, a live view image 60a is displayed, and a setting screen 70 for setting the image capture conditions are displayed to the right of the live view image 60a.

In the setting screen 70, in order from the top, frame rate, shutter speed ("TV"), and gain ("ISO") are shown as examples of image capture condition items to be set. The frame rate is the number of live view images acquired in one second, or the number of video image frames recorded by the camera 1 in one second. And the gain is the ISO sensitivity. Other setting items for image capture conditions may be added as appropriate, additionally to the ones shown by way of example in Fig. 6. It will be acceptable to arrange for other setting items to be displayed by scrolling the setting items up and down, if all of the setting items do not fit within the setting screen 70.

In this embodiment, the control unit 34 takes a region selected by the user, among the regions subdivided by the setting unit 34b, as being the subject for setting (i.e. changing) of image capture conditions. For example, in the case of the camera 1 that is capable of being operated by touch actuation, the user may perform tapping operation upon the display surface of the display unit 35 upon which the live view image 60a is being displayed at the position of display of the main photographic subject whose image capture conditions are to be set (i.e. changed). When for example tapping operation is performed at the display position of the person 61a, then the control unit 34, along with taking the first region 61 in the live view image 60a that includes the person 61a as being the subject region for setting (i.e. changing) of the image capture conditions, also displays the outline of this first region 61 as accentuated.

In Fig. 6, the fact that the first region 61 is being displayed with its contour accentuated (i.e. by being displayed thicker, by being displayed brighter, by being displayed with its color changed, by being displayed with broken lines, or the like) shows that this region is the subject of setting (i.e. of changing) its image capture conditions. In the Fig. 6 example, it will be supposed that the live view image 60a is being displayed in which the contour of the first region 61 is accentuated. In this case, this first region 61 is the subject for setting (i.e. of changing) its image capture conditions. For example, in the case of the camera 1 that can be operated by touch operation, when tapping operation is performed by the user upon the display 71 of shutter speed (i.e. "TV"), the control unit 34 causes the currently set value of shutter speed for this region that is being displayed as accentuated (i.e. for the first region 61) to be displayed upon the screen (as shown by the reference symbol 68).

While, in the explanation described below, this camera 1 is operated by touch operation, it would also be acceptable to arrange for setting (i.e. changing) of the image capture conditions to be performed by operation of buttons or the like that are included in the operation members 36.

When tapping operation is performed by the user upon an upper icon 71a or upon a lower icon 71b, the setting unit 34b increases or decreases the shutter speed display 68 according to the above described tapping operation, and also sends a command to the image capture unit 32 (refer to Fig. 1) to change the image capture conditions for the unit regions 131 (refer to Fig. 3) of the imaging element 32a that correspond to the region that is being displayed as accentuated (i.e. the first region 61) according to the above described tapping operation. A confirm icon 72 is an operating icon for the user to confirm the image capture conditions that have been set. The setting unit 34b also performs setting (changing) of the frame rate or of the gain ("ISO") in a similar manner to performing setting (changing) of the shutter speed ("TV").

It should be understood that, although this explanation has presumed that the image capture conditions are set on the basis of operation by the user, this should not be considered as being limitative. It would also be acceptable to arrange for the setting unit 34b to set image capture conditions, not on the basis of operation by the user, but rather according to determination by the control unit 34.

For the regions that are not being displayed as accentuated (i.e. the regions other than the first region 61), the image capture conditions that are currently set are kept unchanged.

Instead of displaying as accentuated the contour of the region which is to be the subject of setting (i.e. of changing) its image capture conditions, it would also be acceptable to arrange for the control unit 34 to display this entire subject region as brighter, or to display this entire subject region in high contrast, or to display this entire subject region as blinking. Moreover, the subject region could also be displayed as being surrounded by a frame. The format for such a frame displayed as surrounding the subject area may be a double frame or a single frame, and the display of the frame, such as line type, color, brightness or the like may be varied as appropriate. Furthermore, it may be arranged for the control unit 34 to point at the region that is the subject of setting of image capture conditions with an arrow sign or the like displayed in the neighborhood of that subject region. It would also be acceptable to arrange for the control unit 34 to display the regions other than the region that is the subject of setting (i.e. of changing) the image capture conditions as more dark, or to display such other regions than the subject region in low contrast.

As explained above, after the image capture conditions have been set for each of the regions, when a release button (not shown in the figures) that is included in the operation members 36 or a display (i.e. a release icon) for commanding the start of image capture is operated, the control unit 34 controls the image capture unit 32 to perform image capture (i.e. main image capture) under the image capture conditions set for each of the subdivided regions described above. And then the image processing unit 33 performs image processing upon the image data that has been acquired by the image capture unit 32. This image data is image data that will be recorded in the recording unit 37, and subsequently will be referred to as "main image data".

It should be understood that, when acquiring the main image data, the image capture unit 32 acquires image data for processing other than the main image data at a timing that is different from that of the main image data. Such image data for processing is image data that is employed, for example, when performing correction processing upon the main image data, when performing image processing upon the main image data, or when performing detection processing or setting processing of various types for capture of the main image data.

After the image processing upon the main image data by the image processing unit 33 described above, the recording unit 37 records the main image data after image processing upon a recording medium consisting of a memory card or the like, not shown in the figures, upon receipt of a command from the control unit 34. As a result, the image capture processing sequence is completed.

### The Image Data for Processing

The control unit 34 acquires the image data for processing described above in the following manner. That is, at least at the boundary portions of the regions subdivided by the setting unit 34b (in the example described above, the first region through the sixth region), image capture conditions are set as the image capture conditions for the image data for processing that are different from the image capture conditions that are set for capturing the main image data. For example, if first image capture conditions are set for capturing the main image data at the boundary portion between the first region 61 and the fourth region 64, then fourth image capture conditions are set for capturing the image data for processing at the boundary portion between the first region 61 and the fourth region 64.

It should be understood that it will also be acceptable for the setting unit 34b to set the entire region of the imaging surface of the imaging element 32a as the image capture region for processing; it is not limited to being the boundary portion between the first region 61 and the fourth region 64. In this case, sets of image data for processing for which the first image capture conditions through the sixth image capture conditions are set are respectively acquired.

Moreover, it should be understood that the timing of acquisition of the various items of image data for processing will be explained hereinafter.

### Processing Employing the Image Data for Processing

In the following, the processing will be explained separately for the case when the image data for processing is employed in correction processing, for the case when the image data for processing is employed in image processing, for the case when the image data for processing is employed in focus detection processing, for the case when the image data for processing is employed in photographic subject detection processing, and for the case when the image data for processing is employed in exposure conditions setting processing.

### First Correction Processing

According to requirements, the correction unit 33b of the image processing unit 33 performs first correction processing, which is one type of pre processing that is performed before the image processing, the focus detection processing, the photographic subject detection processing (for detecting the elements of the photographic subject), and the processing to set the image capture conditions.

As described above, in this embodiment, after the regions of the imaging screen have been divided up by the setting unit 34b, it is arranged to be possible for image capture conditions to be set (or changed) for a region that has been selected by the user, or for a region that has been determined by the control unit 34.

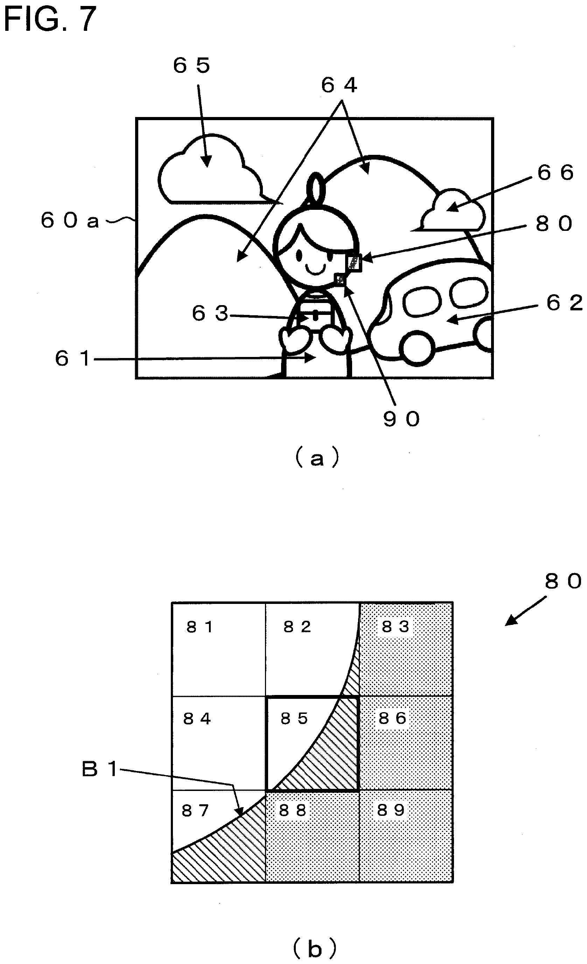

For example, it will be supposed that the regions after subdivision will be referred to as the first region 61 through the sixth region 66 (refer to Fig. 7(a)), and that first image capture conditions through sixth image capture conditions are set for the first region 61 through the sixth region 66 respectively. In this type of case, blocks are present that include boundaries between the first region 61 through the sixth region 66. As described above, these blocks are the minimum units upon the imaging element 32a for which image capture conditions can be set individually.

Fig. 7(a) is a figure showing an example of a predetermined range 80 in the live view image 60a that includes a boundary between the first region 61 and the fourth region 64. And Fig. 7(b) is an enlarged view of that predetermined range 80 of Fig. 7(a). In Fig. 7(b), a plurality of blocks 81 through 89 are included in the predetermined range 80. In this example, the blocks 81 and 84 in which only the person is imaged are included in the first region 61, and the blocks 82, 85, and 87 in which both the person and a mountain are imaged are also included in the first region 61. For this reason, the first image capture conditions are set for the blocks 81, 82, 84, 85, and 87. On the other hand, it is supposed that the blocks 83, 86, 88, and 89 in which the mountain only is imaged are included in the fourth region 64. For this reason, the fourth image capture conditions are set for the blocks 83, 86, 88, and 89.

The white portion in Fig. 7(b) represents the portion corresponding to the person. Furthermore, the hatched portion in Fig. 7(b) represents the portion corresponding to the mountain. The boundary B1 between the first region 61 and the fourth region 64 is included in the block 82, the block 85, and the block 87. The stippled portion in Fig. 7(b) represents the portion corresponding to the mountain.

In this embodiment the same image capture conditions are set within each single block, since a block is the minimum unit for setting of image capture conditions. Since, as described above, the first image capture conditions are set for the blocks 82, 85, and 87 which include the boundary B1 between the first region 61 and the fourth region 64, accordingly the first image capture conditions are also set for the hatched portions of these blocks 82, 85, and 87, in other words for their portions that correspond to the mountain. That is, for the hatched portions within the blocks 82, 85, and 87, the image capture conditions are set that are different from the fourth image conditions set for the blocks 83, 86, 88, and 89 in which the image of the mountain is captured.

In this case, a discrepancy may occur in the image brightness, contrast, hue or the like between the hatched portions of the block 82, the block 85, and the block 87, and the stippled portions of the blocks 83, 86, 88, and 89. In an extreme example, it may also be supposed that clipped whites or crushed blacks may occur in the main image data corresponding to the hatched portions specified above. For example, in the block 85, the first image capture conditions that are appropriate for a person may not be suitable for the hatched portion of the block 85 (in other words, for its mountain portion), and clipped whites or crushed blacks may occur in the main image data corresponding to the hatched portion. The term "clipped whites or blown out highlights" means that gradations of the data for a high luminance portion of the image are lost due to over-exposure. And the term "crushed blacks or crushed shadows" means that gradations of the data for a low luminance portion of the image are lost due to under-exposure.

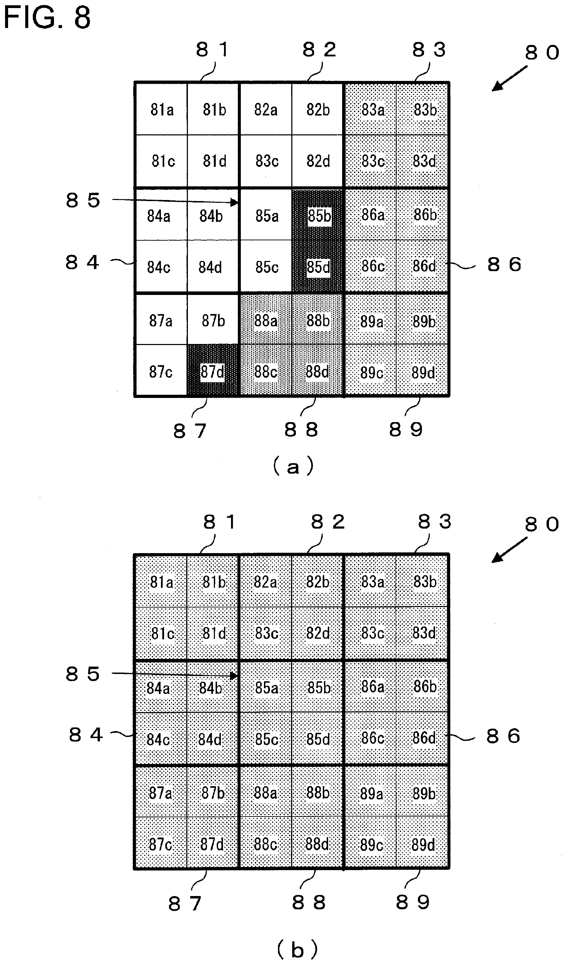

Fig. 8(a) is a figure showing an example of main image data corresponding to Fig. 7(b). Moreover, Fig. 8(b) is a figure showing image data for processing corresponding to Fig. 7(b). The image data for processing are acquired for all of the blocks 81 through 89 that include boundary portions between the first region 61 and the fourth region 64 under the fourth image capture conditions that are suitable for the mountain. It will be supposed that, in Fig. 8(a), each of the blocks 81 through 89 of the main image data consists of four pixels, i.e. of 2×2 pixels. And it will be supposed that, among these, crushed blacks have occurred in the pixel 85b and the pixel 85d that are positioned at the center of Fig. 8(a). In Fig. 8(b), the feature that each of the blocks 81 through 89 of the image data for processing consists of four pixels, i.e. of 2×2 pixels, is the same as in the case of the main image data. It will be supposed that no crushed blacks are present in the image data for processing of Fig. 8(b). The correction unit 33b according to this embodiment corrects the image by performing replacement processing by replacing an item of the main image data in which clipped whites or crushed blacks have occurred in a block of main image data with the corresponding image data for processing. This correction is referred to as the "first correction processing".

The correction unit 33b performs the first correction processing upon all of the blocks in which, as in the case of the block 85 described above, a boundary between a plurality of regions based upon elements of the photographic subject is included and in which clipped whites or crushed blacks are present in the main image data for that block 85.

It should be understood that the first correction processing is not required if no clipped whites or crushed blacks are present in the main image data.

### Example of the First Correction Processing

The correction unit 33b takes a block including a main image data item in which clipped whites or crushed blacks are present as being a block for attention, and performs the first correction processing upon the block for attention in the main image data. While, in this case, the block for attention is taken as being a region including an image data item in which clipped whites or crushed blacks has occurred, it is not always necessary for a white portion or black portion to be totally clipped. For example, it would be acceptable to arrange for a region in which a pixel value is greater than or equal to a first threshold value, or a region in which a pixel value is less than or equal to a second threshold value, to be taken as being a block for attention. In Fig. 7(b) and Fig. 8(a), the eight blocks around a predetermined block for attention 85 that are included in the predetermined range 80 (for example 3×3 blocks) centered around the block for attention 85 is taken as being reference blocks. In other words, the blocks 81 through 84 and the blocks 86 through 89 around the predetermined block for attention 85 are taken as being the reference blocks.

Furthermore, with respect to the image data for processing of Fig. 8(b), the correction unit 33b takes the block at the position corresponding to the block for attention in the main image data as being the block for attention, and takes the blocks at the positions corresponding to the reference blocks in the main image data as being the reference blocks.

It should be understood that the number of blocks making up the predetermined range 80 is not limited to being the 3×3 blocks described above; it could be changed as appropriate.

### 1. The Same Correction is Performed Over the Entire Region in which Clipped Whites or Crushed Blacks has Occurred

(1-1) As the first correction processing, the correction unit 33b corrects a partial region within the block for attention of the main image data by employing an item of the image data for processing that has been acquired for a single block (the block for attention or a reference block) within the image data for processing. In concrete terms, the correction unit 33b replaces all items of the main image data in which clipped whites or crushed blacks has occurred by employing an item of the image data for processing that has been acquired for a single block (the block for attention or a reference block) among the image data for processing. Here, the position of the single block (the block for attention or the reference block) among the image data for processing is the same as the position of the block for attention in the main image data. As the method for this processing (1-1), for example, any of the methods (i) through (iv) described below may be employed.
(i) The correction unit 33b replaces an item of the main image data of the block for attention in which clipped whites or crushed blacks has occurred in the main image data with an item of the image data for processing that has been acquired for a single block (the block for attention or a reference block) in the image data for processing corresponding to the position closest to the abovementioned region in which clipped whites or crushed blacks has occurred. Even if a plurality of pixels with clipped whites or crushed blacks are present within the block for attention of the main image data, the main image data items for this plurality of pixels in which clipped whites or crushed blacks have occurred are replaced with the same item of the image data for processing that has been acquired for the single block (the block for attention or a reference block) of the image data for processing corresponding to the abovementioned closest position.
(i-1) For example, as shown in Fig. 8(b), if no clipped whites or crushed blacks are present in the block for attention of the image data for processing, then the correction unit 33b performs replacement as follows. That is, the correction unit 33b replaces the main image data items of the block for attention in which clipped whites or crushed blacks are present in the main image data with an item of the image data for processing that has been acquired in the block for attention of the image data for processing at the position corresponding to the block for attention of the main image data. For example, on the basis of the items of the image data for processing corresponding to the pixels 85a through 85d included in the block for attention 85 of the image data for processing, the main image data item corresponding to the black crush pixel 85b and the main image data item corresponding to the black crush pixel 85d in the block for attention 85 of the main image data are replaced with the same item of the image data for processing (for example, with an item of the image data for processing corresponding to the pixel 85d in the image data for processing).
(i-2) If clipped whites or crushed blacks are also present in the block for attention of the image data for processing, then the correction unit 33b performs replacement as follows. That is, the correction unit 33b replaces the main image data item of the block for attention in which clipped whites or crushed blacks is present in the main image data with an item of the image data for processing that has been acquired in a reference block neighboring the block for attention in the image data for processing. For example, among the reference blocks 81 through 84 and 86 through 89 around the block for attention 85 in the image data for processing, on the basis of the items of the image data for processing corresponding to the pixels 86a through 86d included in the reference block 86 of the image data for processing which is positioned closest to the block for attention 85 of the image data for processing corresponding to the black crush pixels (i.e. the pixels 85b and 85d in the main image data), the main image data items corresponding to the black crush pixels (i.e. the pixels 85b and 85d in the main image data) are replaced with the same item of the image data for processing (for example the item of the image data for processing corresponding to the pixel 86c in the image data for processing).

If clipped whites or crushed blacks are also present in the block for attention of the image data for processing, then the correction unit 33b performs replacement as follows. That is, a plurality of main image data items of the block for attention in which clipped whites or crushed blacks are present in the main image data are replaced with the same item of the image data for processing acquired for a single reference block that is selected from reference blocks for which are applied the image capture conditions set most for the same element of the photographic subject (in this example, the mountain) as the element (the mountain) of the photographic subject with which clipped whites or crushed blacks have occurred (in this example, the fourth image capture conditions). For example, a single reference block, for instance, the reference block 88, is selected from the reference blocks for which the fourth image capture conditions are set within the range of the reference blocks 81 through 84 and 86 through 89 around the block for attention 85 in the image data for processing, and on the basis of the items of the image data for processing corresponding to the pixels 88a through 88d included in the reference block 88, the main image data item corresponding to the black crush pixel 85b in the main image data and the main image data item corresponding to the black crush pixel 85d in the main image data are replaced with the same item of the image data for processing (for example the item of the image data for processing corresponding to the pixel 88b of the image data for processing). As described above, the correction unit 33b may replace the crushed black pixel 85d with some of the pixels in the reference block of the image data for processing.
(iii) It would also be acceptable for the correction unit 33b to select a pixel in the image data for processing whose interval from the pixel within the block for attention in which clipped whites or crushed blacks have occurred is the shortest within the items of the image data for processing corresponding to the four pixels acquired for the single reference block of the image data for processing according to (i-2) or (ii) above. In concrete terms, the correction unit 33b replaces the black crush pixel 85b of the main image data by using the pixel 86a of the image data for processing whose interval from the black crush pixel 85b of the main image data is the shortest among the interval between the black crush pixel 85b of the main image data and the pixel 86a of the image data for processing, and the interval between the black crush pixel 85b of the main image data and the pixel 86b of the image data for processing. Here, if the case of the black crush pixel 85b in the main image data and the pixel 85 of the image data for processing is taken as an example, then the interval mentioned above is the interval between the center of the black crush pixel 85b in the main image data and the center of the pixel 86a of the image data for processing. Moreover, it would also be acceptable for the interval mentioned above to be the interval between the centroid of the black crush pixel 85b in the main image data and the centroid of the pixel 86a of the image data for processing. Yet further, in a case in which black crush pixels are consecutive (such as the case of the black crush pixel 85b of the main image data and the black crush pixel 86a of the image data for processing), it would be acceptable to take the center or the centroid of the clump of the two black crush pixels. The same is applied to the case for 86a and so on within the reference block. Moreover, it would also be acceptable for the correction unit 33b to replace the main image data item in which clipped whites or crushed blacks have occurred by employing the items of the image data for processing corresponding to adjacent pixels. When the reference block 86 is selected, for instance, the correction unit 33b may replace the main image data item corresponding to the black crush pixel 85b of the main image data and the main image data item corresponding to the black crush pixel 85d of the main image data with the same item of the image data for processing (i.e. with the item of the image data for processing corresponding to the pixel 86a or the pixel 86c in the image data for processing).
(iv) It would also be acceptable for the correction unit 33b to replace the main image data item in which clipped whites or crushed blacks have occurred by employing image data generated on the basis of the items of the image data for processing corresponding to the four pixels acquired for a single reference block of the image data for processing according to (i-2) or (ii) described above. For example, when the reference block 88 has been selected, then the correction unit 33b may replace the main image data item corresponding to the black crush pixel 85b of the main image data and the main image data item corresponding to the black crus pixel 85d of the main image data with the same image data (i.e. with the average value of the items of the image data for processing corresponding to the pixels 88a through 88d included in the reference block 88 of the image data for processing).

It should be understood that, when calculating the average value of the items of the image data for processing, instead of performing simple averaging, it would also be acceptable to perform replacement with a weighted average value that is obtained by assigning weightings according to the distance from the pixel where clipped whites or crushed blacks has occurred. For example, since the pixel 88b is closer to the black crush pixel 85d than is the pixel 88d, accordingly weightings are assigned so as to make the contribution ratio of the item of the image data for processing corresponding to the pixel 88b higher than the contribution ratio of the item of the image data for processing corresponding to the pixel 88d.

Instead of calculating the average value of the items of the image data for processing corresponding to the pixels 88a through 88d included in the reference block 88, it would also be acceptable to calculate the median value of the items of the image data for processing corresponding to the pixels 88a through 88d, and to replace the main image data items corresponding to the black crush pixel 85b and the black crush pixel 85d with this median value.

(1-2) As the first correction processing, the correction unit 33b replaces all items of the main image data in which clipped whites or crushed blacks have occurred within the block for attention in the main image data, by employing the items of the image data for processing acquired for a plurality of blocks among the image data for processing. Here, a plurality of candidate reference blocks of the image data for processing for replacing the black crush pixels (85b and 85d) of the main image data are extracted. Finally, a pixel within one of these blocks is used for replacement. As the method for this processing (1-2), for example, any of the methods (i) through (iv) described below may be employed.

(i) The correction unit 33b replaces the main image data item of the block for attention in the main image data in which clipped whites or crushed blacks have occurred with the item of the image data for processing acquired for a plurality of reference blocks of the image data for processing corresponding to positions around the above described region where clipped whites or crushed blacks have occurred. Even if a plurality of pixels where clipped whites or crushed blacks have occurred are present within the block for attention of the main image data, this main image data items for the plurality of pixels in which clipped whites or crushed blacks have occurred are replaced with the same item of the image data for processing acquired for the above described plurality of reference blocks of the image data for processing.

For example, replacement is performed in the following manner on the basis of the items of the image data for processing corresponding to the pixels 86a through 86d and 88a through 88d included in the two reference blocks 86 and 88 of the image data for processing, among the reference blocks 81 through 84 and 86 through 89 around the block for attention 85 of the image data for processing, that are adjacent to the block for attention 85 of the image data for processing corresponding to the black crush pixels (i.e. the pixels 85b and 85d of the main image data). That is, the main image data item corresponding to the black crush pixel 85b and the main image data item corresponding to the black crush pixel 85d are replaced with the same item of the image data for processing (for example, with the item of the image data for processing corresponding to the pixel 88b of the image data for processing). At this time, the area of the black crush pixel 85b and the black crush pixel 85d of the main image data which are replaced with the pixel 88b of the image data for processing is smaller than the area of the pixel 88b of the image data for processing.

It should be understood that if, for example, as shown in Fig. 8(b), no clipped whites or crushed blacks are present in the block for attention 85 of the image data for processing, then it will be acceptable for the correction unit 33b to replace the main image data item corresponding to the pixel in which clipped whites or crushed blacks have occurred in the block for attention 85 of the main image data by employing the items of the image data for processing acquired for a plurality of blocks, including the block for attention 85 of the image data for processing and the reference blocks 81 through 84 and 86 through 89 positioned around this block for attention 85.

(ii) If clipped whites or crushed blacks are also present in the block for attention of the image data for processing, then the correction unit 33b performs replacement in the following manner. That is, a plurality of main image data items of the block for attention in which clipped whites or crushed blacks are present in the main image data are replaced with the same item of the image data for processing acquired for a plurality of reference blocks that are selected from reference blocks for which are applied the image capture conditions set most for the same element of the photographic subject (in this example, the mountain) as the element (the mountain) of the photographic subject with which clipped whites or crushed blacks have occurred (in this example, the fourth image capture conditions). For example, two reference blocks, for instance, the reference blocks 86 and 88, are selected from the reference blocks for which the fourth image capture conditions are set within the range of the reference blocks 81 through 84 and 86 through 89 around the block for attention 85 in the image data for processing, and on the basis of the items of the image data for processing corresponding to the pixels 86a through 86d and 88a through 88d that are included in the reference blocks 86 and 88, the main image data item corresponding to the black crush pixel 85b in the main image data and the main image data item corresponding to the black crush pixel 85d in the main image data may be replaced with the same item of the image data for processing (for example the item of the image data for processing corresponding to the pixel 86c).

It should be understood that if, for example, as shown in Fig. 8(b), no clipped whites or crushed blacks are present in the block for attention 85 of the image data for processing, then it will be acceptable for the correction unit 33b to replace the main image data item corresponding to the pixel in which clipped whites or crushed blacks have occurred in the block for attention 85 of the main image data by employing the items of the image data for processing acquired for a plurality of blocks, including the block for attention 85 of the image data for processing and the reference blocks 81 through 84 and 86 through 89 positioned around this block for attention 85.
(iii) It would also be acceptable for the correction unit 33b to replace the main image data item in which clipped whites or crushed blacks have occurred by employing, from among the items of the image data for processing corresponding to a plurality of pixels acquired for a plurality of reference blocks of the image data for processing according to (i) or (ii) above, the item of the image data for processing corresponding to the pixel adjacent to the pixel within the block for attention of the image data for processing in which clipped whites or crushed blacks have occurred. If, for example, the reference blocks 86 and 88 have been selected, then the correction unit 33b replaces the main image data item corresponding to the black crush pixel 85b of the main image data and the main image data item corresponding to the black crush pixel 85d of the main image data with the same item of the image data for processing (i.e. with the item of the image data for processing corresponding to the pixel 86a or the pixel 86c of the reference block 86 of the image data for processing, or the pixel 86c or the pixel 88a of the reference block 88 of the image data for processing).
(iv) It would also be acceptable for the correction unit 33b to replace the main image data item within the block for attention in which clipped whites or crushed blacks have occurred by employing image data generated on the basis of the items of the image data for processing corresponding to a plurality of pixels acquired for a plurality of reference blocks of the image data for processing selected according to (i) or (ii) above. For example, if the reference blocks 86 and 88 have been selected, then the correction unit 33b replaces the main image data item corresponding to the black crush pixel 85b of the main image data and the main image data item corresponding to the black crush pixel 85d of the main image data with the same image data item (i.e. with the average value of the items of the image data for processing corresponding to the pixels 86a through 86d included in the reference block 86 of the image data for processing, and of the items of the image data for processing corresponding to the pixels 88a through 88d included in the reference block 88 of the image data for processing). At this time, the area of the pixels that are used for replacement is greater than the area of the black crush pixels 85b and 85d of the main image data.

It should be understood that, when calculating the average value of the image data items for processing, instead of performing simple averaging, it would also be acceptable to perform replacement with a weighted average value that is obtained by assigning weightings according to the distance from the pixel where clipped whites or crushed blacks has occurred. For example, since the pixel 86a is closer to the black crush pixel 85b than is the pixel 86b, accordingly weightings are assigned so as to make the contribution ratio of the item o the image data for processing corresponding to the pixel 86a higher than the contribution ratio of the item of the image data for processing corresponding to the pixel 86b.

Instead of calculating the average value of the items of the image data for processing corresponding to the pixels 86a through 86d and the pixels 88a through 88d included in the reference blocks 86 and 88, it would also be acceptable to calculate the median value of the items of the image data for processing corresponding to the pixels 88a through 88d and to the pixels 88a through 88d, and to replace the main image data items corresponding to the black crush pixel 85b and the black crush pixel 85d with the median value.

### 2. A Plurality of Corrections are Performed Over the Entire Region in which Clipped Whites or Crushed Blacks Have Occurred

(2-1) As the first correction processing, the correction unit 33b replaces all items of the main image data in which clipped whites or crushed blacks have occurred within the block for attention in the main image data, by employing the item of the image data for processing acquired for a single block among the image data for processing. As the method for this processing (2-1), for example, any of the methods (i) through (iii) described below may be employed.
(i) The correction unit 33b replaces the main image data item of the block for attention in the main image data in which clipped whites or crushed blacks have occurred with the item of the image data for processing acquired for a single block (the block for attention or a reference block) of the image data for processing corresponding to the position closest to the region described above where clipped whites or crushed blacks have occurred. If a plurality of pixels where clipped whites or crushed blacks have occurred are present within the block for attention of the main image data, then the main image data items for the plurality of pixels in which clipped whites or crushed blacks have occurred are respectively replaced with the different items of the image data for processing acquired for the single block of the image data for processing corresponding to the closest position described above.
   (i-1) For example, as shown in Fig. 8(b), if no clipped whites or crushed blacks are present in the block for attention of the image data for processing, then the correction unit 33b performs replacement as follows. That is, the correction unit 33b replaces the main image data items of the block for attention in which clipped whites or crushed blacks are present in the main image data with different image data items that have been acquired in the block for attention of the image data for processing at the position corresponding to that of the block for attention in main image data. For example, on the basis of the items of the image data for processing corresponding to the pixels 85a through 85d included in the block for attention 85 of the image data for processing, the main image data item corresponding to the black crush pixel 85b in the block for attention 85 of the main image data is replaced with the item of the image data for processing of the pixel 85b of the corresponding block for attention 85 of the image data for processing, and the main image data item corresponding to the black crush pixel 85d in the block for attention 85 of the main image data is replaced with the item of the image data for processing of the pixel 85d of the corresponding block for attention 85 of image data for processing.
   (i-2) If clipped whites or crushed blacks are also present in the block for attention of the image data for processing, then the correction unit 33b performs replacement as follows. That is, the correction unit 33b replaces the main image data items of the block for attention in which clipped whites or crushed blacks are present in the main image data with different items of the image data for processing that have been acquired for the reference block around the block for attention in the image data for processing. For example, among the reference blocks 81 through 84 and 86 through 89 around the block for attention 85 in the image data for processing, on the basis of the items of the image data for processing corresponding to the pixels 86a through 86d included in the reference block 86 of the image data for processing which is positioned adjacent to the block for attention 85 of the image data for processing corresponding to the black crush pixels (i.e. the pixels 85b and 85d in the main image data), replacement is performed as follows. That is, the main image data item corresponding to the black crush pixel 85b in the main image data is replaced with the item of the image data for processing corresponding to the pixel 86a of the reference block 86 of the data for processing, and the main image data item corresponding to the black crush pixel 85d in the main image data is replaced with the item of the image data for processing corresponding to the pixel 86c of the reference block 86 of the data for processing.
(ii) If clipped whites or crushed blacks are present in the block for attention of the image data for processing in a similar manner to the case of the block for attention in the main image data, then the correction unit 33b performs replacement as follows. That is, a plurality of main image data items of the block for attention in which clipped whites or crushed blacks are present in the main image data are replaced with different items of the image data for processing acquired for a single reference block that is selected from reference blocks for which are applied the image capture conditions set most for the same element of the photographic subject (in this example, the mountain) as the element (the mountain) of the photographic subject with which clipped whites or crushed blacks have occurred (in this example, the fourth image capture conditions). For example, a single reference block, for instance, the reference block 86, is selected from among the reference blocks for which the fourth image capture conditions are set within the range of the reference blocks 81 through 84 and 86 through 89 around the block for attention 85 of the image data for processing, and by employing the items of the image data for processing corresponding to the pixels 86a through 86d that are included in the reference block 86, replacement may be performed in the following manner. In other words, the main image data item corresponding to the black crush pixel 85b of the main image data is replaced with the item of the image data for processing corresponding to the pixel 86b of the reference block 86 of the image data for processing, and the main image data item corresponding to the black crush pixel 85d of the main image data is replaced with the item of the image data for processing corresponding to the pixel 86d of the reference block 86 of the image data for processing.
(iii) It would also be acceptable for the correction unit 33b to replace the main image data item in which clipped whites or crushed blacks have occurred by employing image data generated on the basis of items of the image data for processing corresponding to the four pixels acquired for a single reference block of the image data for processing according to (i-2) or (ii) above. If, for example, the reference block 86 has been selected, then the correction unit 33b replaces the main image data item corresponding to the black crush pixel 85b of the main image data with the average value of the items of the image data for processing corresponding to the pixels 86a and 86b included in the reference block 86 of the image data for processing. Moreover, the main image data item corresponding to the black crush pixel 85d of the main image data is replaced with the average value of the items of the image data for processing corresponding to the pixels 86c and 86d included in the reference block 86 of the image data for processing.

It should be understood that, when calculating the average value of the items of the image data for processing, instead of performing simple averaging, it would also be acceptable to perform replacement with a weighted average value that is obtained by assigning weightings according to the distance from the pixel where clipped whites or crushed blacks has occurred. For example, since the pixel 86a is closer to the black crush pixel 85b than is the pixel 86b, accordingly weightings are assigned so as to make the contribution ratio of the item of the image data for processing corresponding to the pixel 86a higher than the contribution ratio of the item of the image data for processing corresponding to the pixel 86b.

(2-2) As the first correction processing, the correction unit 33b replaces all items of the main image data in which clipped whites or crushed blacks have occurred within the block for attention of the main image data, by employing the items of the image data for processing acquired for a plurality of blocks among the image data for processing. As the method for this processing (2-2), for example, any of the methods (i) through (iii) described below may be employed.

(i) The correction unit 33b replaces the main image data item of the block for attention in the main image data in which clipped whites or crushed blacks have occurred with the item of the image data for processing acquired for a plurality of reference blocks of the image data for processing corresponding to the positions around the region described above where clipped whites or crushed blacks have occurred. If a plurality of pixels where clipped whites or crushed blacks have occurred are present within the block for attention of the main image data, then these main image data items for the plurality of pixels in which clipped whites or crushed blacks have occurred are respectively replaced with different items of image data for processing acquired for the plurality of blocks described above.

For example, replacement is performed in the following manner on the basis of the items of image data for processing corresponding to the pixels 86a through 86d and 88a through 88d included in the two reference blocks 86 and 88 of the image data for processing, among the reference blocks 81 through 84 and 86 through 89 around the block for attention 85 of the image data for processing, that are adjacent to the block for attention 85 of the image data for processing corresponding to the black crush pixels (i.e. the pixels 85b and 85d of the main image data). For example, the main image data item corresponding to the black crush pixel 85b is replaced with the item of image data for processing corresponding to the pixel 86a of the reference block 86 of the image data for processing, and the main image data item corresponding to the black crush pixel 85d is replaced with the item of image data for processing corresponding to the pixel 88b of the reference block 88 of the image data for processing.

It should be understood that if, for example, as shown in Fig. 8(b), no clipped whites or crushed blacks are present in the block for attention 85 of the image data for processing, then it will be acceptable for the correction unit 33b to replace the main image data item corresponding to the pixel in which clipped whites or crushed blacks have occurred in the block for attention 85 of the main image data by employing the items of image data for processing acquired for a plurality of blocks, including the block for attention 85 of the image data for processing and the reference blocks 81 through 84 and 86 through 89 positioned around this block for attention 85.

(ii) If clipped whites or crushed blacks are also present in the block for attention of the image data for processing, then the correction unit 33b performs replacement as follow. That is, a plurality of main image data items of the block for attention in which clipped whites or crushed blacks are present in the main image data are replaced with different items of image data for processing acquired for a plurality of reference blocks that are selected from reference blocks for which are applied the image capture conditions set most for the same element of the photographic subject (in this example, the mountain) as the element (the mountain) of the photographic subject in which clipped whites or crushed blacks have occurred (in this example, the fourth image capture conditions). The main image data item of the block for attention in the main image data in which clipped whites or crushed blacks have occurred is replaced with different image data items acquired for a plurality of reference blocks among the reference blocks for which are applied the image capture conditions set most for the reference blocks around the block for attention in the image data for processing. For example, two reference blocks, for instance, the reference blocks 86 and 88, are selected from the reference blocks for which the fourth image capture conditions are set within the range of the reference blocks 81 through 84 and 86 through 89 around the block for attention 85 in the image data for processing, and on the basis of the items of image data for processing corresponding to the pixels 86a through 86d and 88a through 88d that are included in the reference blocks 86 and 88, replacement may be performed in the following manner. That is, the main image data item corresponding to the black crush pixel 85b in the main image data is replaced with the item of image data for processing corresponding to the pixel 86a of the reference block 86 of the image data for processing, and the main image data item corresponding to the black crush pixel 85d in the main image data is replaced with the item of image data for processing corresponding to the pixel 88b of the reference block 88 of the image data for processing.

It should be understood that if, for example, as shown in Fig. 8(b), no clipped whites or crushed blacks are present in the block for attention 85 of the image data for processing, then it will be acceptable for the correction unit 33b to replace the main image data item corresponding to the pixel in which clipped whites or crushed blacks have occurred in the block for attention 85 of the main image data by employing the items of image data for processing acquired for a plurality of blocks, including the block for attention 85 of the image data for processing and the reference blocks 81 through 84 and 86 through 89 positioned around this block for attention 85.

(iii) It would also be acceptable for the correction unit 33b to replace the main image data item within the block for attention in which clipped whites or crushed blacks have occurred by employing an image data item generated on the basis of the items of image data for processing corresponding to a plurality of pixels acquired for a plurality of reference blocks of the image data for processing according to (i) or (ii) above. If, for example, the reference blocks 86 and 88 have been selected, then the correction unit 33b replaces the main image data items corresponding to the black crush pixel 85b and to the black crush pixel 85d of the main image data in the following manner. That is, the main image data item corresponding to the black crush pixel 85b in the main image data is replaced with the average value of the items of image data for processing corresponding to the pixels 86a through 86d included in the reference block 86 of the image data for processing. Moreover, the main image data item corresponding to the black crush pixel 85d in the main image data is replaced with the average value of the items of image data for processing corresponding to the pixels 88a through 88d included in the reference block 88 of the image data for processing.

It should be understood that, when calculating the average value of the items of image data for processing, instead of performing simple averaging, it would also be acceptable to perform replacement with a weighted average value that is obtained by assigning weightings according to the distance from the pixel where clipped whites or crushed blacks has occurred. For example, since the pixel 86a is closer to the black crush pixel 85b than is the pixel 86b, accordingly weightings are assigned so as to make the contribution ratio of the item of image data for processing corresponding to the pixel 86a higher than the contribution ratio of the item of image data for processing corresponding to the pixel 86b.

Instead of calculating the average value of the items of image data for processing corresponding to the pixels 86a through 86d and the pixels 88a through 88d included in the reference blocks 86 and 88, it would also be acceptable to calculate the median value of the items of image data for processing corresponding to the pixels 86a through 86d and the pixels 88a through 88d, and to replace the main image data items corresponding to the black crush pixel 85b and the black crush pixel 85d with the median value.

In the above explanation, various methods for performing the first correction processing have been described. The control unit 34 determines according to which method the first correction processing is to be performed, for example, on the basis of the state of setting of the operation members 36 (including settings on an operation menu).

It should be understood that it would also be acceptable for the control unit 34 to determine according to which method the first correction processing is to be performed, according to the scene imaging mode that is set for the camera 1, or according to the type of photographic subject element that is detected.

Although, in the explanation given above, the image data for processing was acquired by the image capture unit 32, it should be understood that it would also be acceptable for the image data for processing to be acquired by some image capture unit other than the image capture unit 32. For example, it would be possible to provide an image capture unit other than the image capture unit 32 to the camera 1, and to arrange for the image data for processing to be acquired by this image capture unit other than the image capture unit 32. Moreover, it would also be acceptable for the image data for processing to be acquired by an image capture unit of a camera other than the camera 1. And it would be acceptable for the image data for processing to be acquired by a sensor other than an imaging element, such as a photometric sensor. In such a case, it is preferable for the range of the photographic field that is captured when acquiring the image data for processing to be the same as the range of the photographic field that is captured when acquiring the main image data, but it will be possible to perform the first correction processing, provided that at least parts of the range of the photographic field that is captured when acquiring the image data for processing and the range of the photographic field that is captured when acquiring the main image data are mutually overlapped. It should be understood that, if the image data for processing is acquired by an image capture unit of a camera other than the camera 1, then it would also be possible to acquire the image data for processing almost simultaneously with acquisition of the main image data so that, when capturing an image of a photographic subject that is moving, it would be possible to eliminate positional deviation of the photographic subject between the image data for processing and the main image data.

It would also be acceptable for the image data for processing to be recorded in the recording unit 37, and for the first correction processing to be performed by acquiring the image data for processing by reading it out from the recording unit 37. The timing at which the image data for processing is recorded in the recording unit 37 may be arranged to be directly before, or directly after, acquisition of the main image data; or the image data for processing may be recorded in advance, before acquisition of the main image data.

### Second Correction Processing

Furthermore, according to requirements, before performing image processing upon the main image data, before performing focus detection processing for capture of the main image data, before performing photographic subject detection (i.e. detection of the elements of the photographic subject), and before processing for setting the image capture conditions for capture of the main image data, the correction unit 33b of the image processing unit 33 performs second correction processing in the following manner. It should be understood that the correction unit 33b performs this second correction processing after having replaced the pixels in which clipped whites or crushed blacks have occurred, as described above.

Moreover it should be understood that, for the image data item at the position of the black crush pixel 85b (or 85d) and which has been replaced with some other pixel, the second correction processing described below may be performed while taking this image data item as having been photographed under the image capture conditions under which the replacement pixel (for example, 86a) was captured. Furthermore, in a case in which the black crush pixel 85b has been replaced by employing pixels from a plurality of blocks for which the image capture conditions were different, image capture conditions may be assumed as being a value between the respective values of the image capture conditions of those blocks (i.e. which may be an average value or a median value thereof). For example, in a case in which the black crush pixel 85d has been corrected according to the pixel 86c that was photographed with ISO sensitivity 100 and the pixel 88b that was photographed with ISO sensitivity 1600, it may be treated as being an data item that was photographed with ISO sensitivity 800, which is between ISO sensitivity 100 and ISO sensitivity 1600.

### 1. When Performing Image Processing

In a case in which the image processing is predetermined image processing upon main image data that has been acquired by applying different image capture conditions for different subdivided regions, the correction unit 33b of the image processing unit 33 performs the second image processing as pre-processing upon the image data that is positioned at the boundary portions between those regions. The predetermined image processing is processing for calculating the main image data item of the position for attention in the image that is the subject of processing by referring to the main image data items in a plurality of reference positions around the position for attention, and may include, for example, pixel defect correction processing, color interpolation processing, contour enhancement processing, noise reduction processing, and so on.

The second correction processing is performed in order to alleviate discontinuity generated in the image after image processing, occurring due to discrepancy in the image capture conditions between the subdivided regions. In general, when the position for attention is located at a boundary portion between subdivided regions, main image data items at which were applied the same image capture conditions as those applied at the position for attention, and main image data items at which were applied image capture conditions different from those applied at the position for attention, may be mixed together at a plurality of reference positions around the position for attention. In this embodiment, on the basis of the consideration that it is preferable to calculate the main image data item at the position for attention by referring to main image data items at reference positions upon which the second correction processing has been performed in order to suppress the disparity between the main image data items due to discrepancy in the image capture conditions, rather than calculating the main image data item at the position for attention by referring to the main image data items at those reference positions at which different image capture conditions have been applied just as it is without modification, the second correction processing is performed as follows.

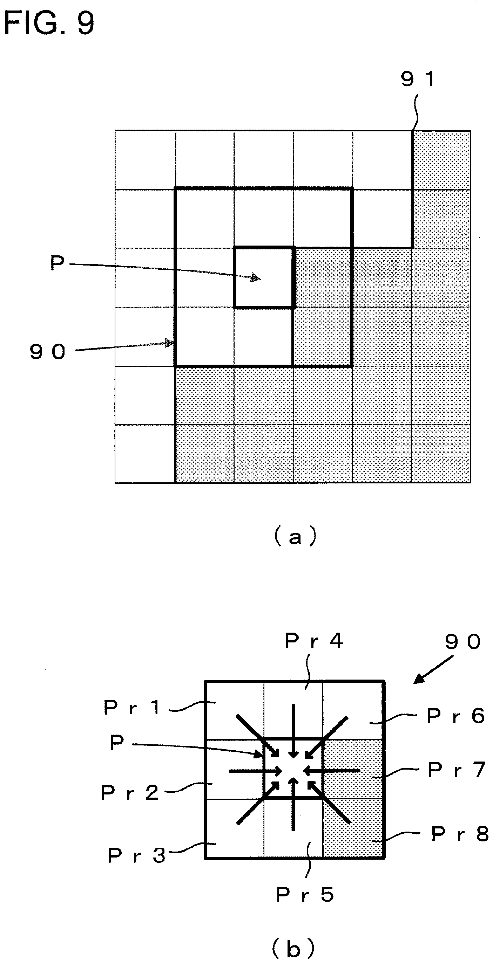

Fig. 9(a) is a figure in which a region for attention 90 at the boundary portion between the first region 61 and the fourth region 64 in the live view image 60a shown in Fig. 7(a) is shown as enlarged. Image data items from pixels on the imaging element 32a corresponding to the first region 61 for which the first image capture conditions have been set is shown as white, while image data items from pixels on the imaging element 32a corresponding to the fourth region 64 for which the fourth image capture conditions have been set is shown with stippling. In Fig. 9(a), the image data item from the pixel for attention P is positioned in the first region 61 at the portion in the neighborhood of a boundary 91 between the first region 61 and the fourth region 64, in other words, at their boundary portion. The pixels (in this example, eight pixels) around the pixel for attention P which are included in the region for attention 90 (in this example, 3×3 pixels) centered at the pixel for attention P will be taken as being reference pixels Pr. Fig. 9(b) is an enlarged view showing the pixel for attention P and reference pixels Pr1 through Pr8. The position of the pixel for attention P is the position for attention, and the positions of the reference pixels Pr1 through Pr8 that surround this pixel for attention P are the reference positions. The first image capture conditions are set for the reference pixels Pr1 through Pr6 and for the pixel for attention P which correspond to the first region 61, while the fourth image capture conditions are set for the reference pixels Pr7 and Pr8 which correspond to the fourth region 64.

It should be understood that, in the following explanation, the reference symbol Pr is applied to the reference pixels Pr1 through Pr8 when they are referred to generically.

The generation unit 33c of the image processing unit 33 normally performs image processing by referring to the main image data items for the reference pixels Pr just as they are, without performing the second correction processing. However, if the image capture conditions (supposed to be the first image capture conditions) that were applied at the pixel for attention P and the image capture conditions (supposed to be the fourth image capture conditions) that were applied at reference pixels Pr around the pixel for attention P are different, then, the correction unit 33b performs the second correction processing as shown in the following Example 1 through Example 3 below upon the main image data items to which the fourth image capture conditions were applied among the main image data items for the reference pixels Pr in the main image data. And then the generation unit 33c performs the image processing for calculating the main image data item at the pixel for attention P by referring to the main image data items for the reference pixels Pr after this second correction processing.

### Example 1

For example, if the first image capture conditions and the fourth image capture conditions only differ in ISO sensitivity with the ISO sensitivity of the first image capture conditions being 100 while the ISO sensitivity of the fourth image capture conditions is 800, then, as the second correction processing, the correction unit 33b of the image processing unit 33 multiplies the main image data items for the reference pixels Pr7 and Pr8 to which the fourth image capture conditions were applied among the main image data items for the reference pixels Pr by 100/800. By doing this, the disparity between the main image data items due to discrepancy in the image capture conditions is reduced.

It should be understood that, although the disparity in the main image data items can be reduced if the amount of light incident upon the pixel for attention P and the amount of light incident upon the reference pixel Pr are the same, the disparity in the main image data items may not be reduced if the amount of light incident upon the pixel for attention P and the amount of light incident upon the reference pixel Pr are substantially different. The same applies to the examples to be described hereinafter.

### Example 2

For example, if the first image capture conditions and the fourth image capture conditions only differ in shutter speed with the shutter speed of the first image capture conditions being 1/1000 second while the shutter speed of the fourth image capture conditions is 1/100 second, then, as the second correction processing the correction unit 33b of the image processing unit 33 multiplies the main image data items for the reference pixels Pr7 and Pr8 to which the fourth image capture conditions were applied among the main image data items for the reference pixels Pr by (1/1000)/(1/100)=1/10. By doing this, the disparity between the main image data items due to discrepancy in the image capture conditions is reduced.

### Example 3

For example, if the first image capture conditions and the fourth image capture conditions only differ in frame rate (the charge accumulation time being the same) with the frame rate of the first image capture conditions being 30 fps while the frame rate of the fourth image capture conditions is 60 fps, then, as the second correction processing, for the main image data item which was captured under the fourth image capture conditions (i.e. at 60 fps) among the main image data items of the reference pixels Pr, the correction unit 33b of the image processing unit 33 employs the main image data item for a frame image whose starting timing of acquisition is close to that of a frame image which was captured under the first image capture conditions (i.e. at 30 fps). By doing this, the disparity between the main image data items due to discrepancy in the image capture conditions is reduced.

It should be understood that it would also be acceptable for the second correction processing to be performed by executing interpolation calculation for the main image data item of the frame image whose starting time of acquisition is close to that of a frame image that was acquired under the first image capture conditions (i.e. at 30 fps), on the basis of a plurality of frame images acquired sequentially under the fourth image capture conditions (i.e. at 60 fps).

On the other hand, if the image capture conditions (supposed to be the first image capture conditions) that were applied at the pixel for attention P and the image capture conditions (supposed to be the fourth image capture conditions) that were applied at all of the reference pixels Pr around the pixel for attention P are the same, then the correction unit 33b of the image processing unit 33 does not perform the second correction processing upon the main image data items for the reference pixels Pr. In other words, the generation unit 33c performs the image processing for calculating the main image data item for the pixel for attention P by referring to the main image data items for the reference pixels Pr just as they are without modification.

It should be understood that, as described above, even if there is some slight difference in the image capture conditions, still they are considered as being the same image capture conditions.

### Examples of Image Processing

Examples will now be described of image processing accompanied by the second correction processing.

### (1) Pixel Defect Correction Processing

In this embodiment, pixel defect correction processing is one of the types of image processing that is performed when an image is captured. In general pixel defects occur in the imaging element 32a, which is a solid state imaging element, during the manufacturing process or after manufacture, so that image data of anomalous levels may be outputted. Accordingly, by correcting the main image data item outputted from the pixel with which pixel defects have occurred, the generation unit 33c of the image processing unit 33 ensures that the main image data item at the pixel position with which pixel defects have occurred does not stand out.

An example of the pixel defect correction processing will now be explained. The generation unit 33c of the image processing unit 33, for example, takes a pixel in an image of one frame at the position of a pixel defect that is recorded in advance in a non volatile memory not shown in the figures as being the pixel for attention P (i.e. as the pixel that is the subject of processing), and takes the pixels (in this example, eight pixels) around the pixel for attention P that are included in a region for attention 90 (for example 3×3 pixels) centered upon this pixel for attention P as being reference pixels Pr.

The generation unit 33c of the image processing unit 33 calculates the maximum value and the minimum value of the main image data items for the reference pixels Pr and performs max-min filter processing in which, when the main image data item outputted from the pixel for attention P is outside this maximum value or this minimum value, the main image data item outputted from the pixel for attention P is replaced with the above described maximum value or minimum value. This type of processing is performed for all of the pixel defects whose position information is recorded in a non-volatile memory not shown in the figures.

In this embodiment, if a pixel to which have been applied the fourth image capture conditions which are different from the first image capture conditions applied to the pixel for attention P is included in the reference pixels Pr described above, then the correction unit 33b of the image processing unit 33 performs the second correction processing upon the main image data item to which the fourth image capture conditions have been applied. And subsequently the generation unit 33c of the image processing unit 33 performs the max-min filter processing described above.

### (2) Color Interpolation Processing

In this embodiment, color interpolation processing is one of the types of image processing performed when an image is captured. As illustrated in the example of Fig. 3, in the image capture chip 111 of the imaging element 100, green color pixels Gb and Gr, blue color pixels B, and red color pixels R are arranged in a Bayer array. Since, at the position of each pixel, there is a lack of main image data items for the color components that are different from the color component of the color filter F that is installed for that pixel, accordingly the generation unit 33c of the image processing unit 33 performs color interpolation processing in order to generate main image data items for those lacking color components.

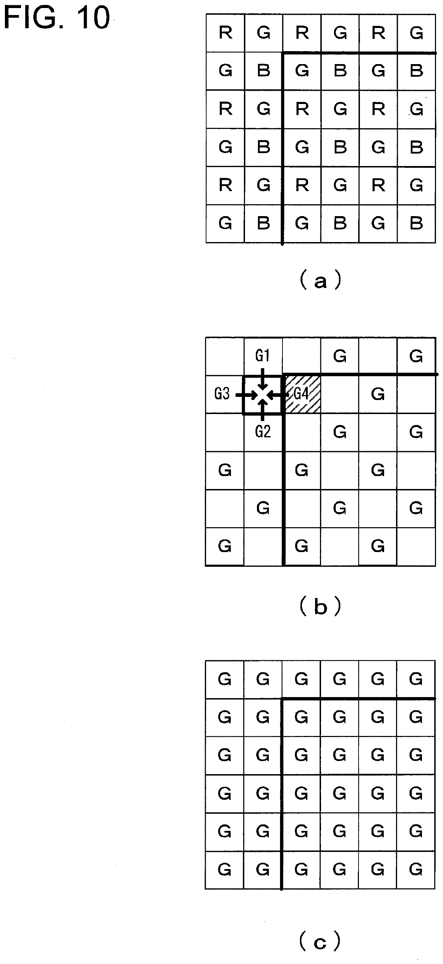

An example of color interpolation processing will now be explained. Fig. 10(a) is a figure showing an example of an arrangement of main image data outputted from the imaging element 32a. This arrangement has R, G, and B color components corresponding to the positions of the various pixels, arranged according to the Bayer array rule.

### G Color Interpolation

First, the general process of interpolation of the G color will be explained. In performing the G color interpolation, the generation unit 33c of the image processing unit 33 takes the positions of the R color component and of the B color component in order as the position for attention, and generates a main image data item for the G color component at the position for attention by referring to the four items of main image data for the G color component at the four reference positions around the position for attention. When, for example, generating a main image data item for the G color component at the position for attention indicated by the thick frame in Fig. 10(b) (which, counting from the upper left position, is at the second row and the second column; subsequently it will be supposed that the position for attention is designated by counting from the upper left position in the same manner), reference is made to the four main image data items G1 through G4 for the G color component positioned in the neighborhood of the position for attention (which is at the second row and the second column). The generation unit 33c of the image processing unit 33 sets, for example, (aG1+bG2+cG3+dG4)/4 as being the main image data item of the G color component at the position for attention (which is at the second row and the second column). Here, it should be understood that a through d are weighting coefficients that are provided according to the distances between the reference positions and the position for attention, and according to the image configuration.

Next, the G color interpolation in this embodiment will be explained. It will be supposed that, in Figs. 10(a) through 10(c), the first image capture conditions are applied to the region to the left of and above the thick line, while the fourth image capture conditions are applied to the region to the right of and below the thick line. And it should be understood that, in Figs. 10(a) through 10(c), the first image capture conditions and the fourth image capture conditions are different. Moreover, in Fig. 10(b) the main image data items G1 through G4 of the G color component are at the reference positions for performing image processing upon the pixel at the position for attention (at the second row and the second column). In Fig. 10(b), the first image capture conditions are applied to the position for attention (at the second row and the second column). And, among the reference positions, the first image capture conditions are applied to the main image data items G1 through G3. Moreover, among the reference positions, the fourth image capture conditions are applied to the main image data item G4. Due to this, the correction unit 33b of the image processing unit 33 performs the second correction processing upon the main image data item G4. Subsequently, the generation unit 33c of the image processing unit 33 calculates the main image data item for the G color component at the position for attention (at the second row and the second column).

As shown in Fig. 10(c), the generation unit 33c of the image processing unit 33 is able to obtain the main image data item for the G color component at each pixel position by generating a main image data item for the G color component at each of the positions of the B color component and the R color component in Fig. 10(a).

### R Color Interpolation

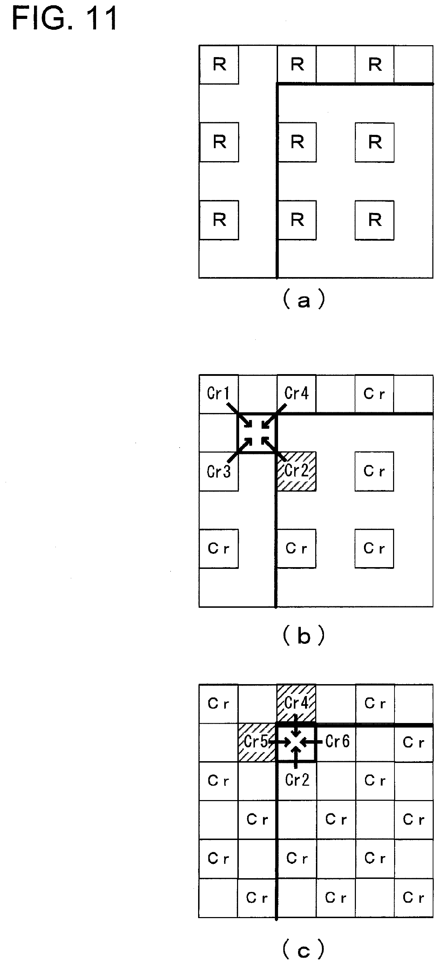

Fig. 11(a) is a figure in which the main image data for the R color component have been extracted from Fig. 10(a). The generation unit 33c of the image processing unit 33 calculates the main image data for the Cr color difference component shown in Fig. 11(b) on the basis of the main image data for the G color component shown in Fig. 10(c) and the main image data for the R color component shown in Fig. 11(a).

First, the general process of interpolation of the Cr color difference component will be explained. When, for example, generating a main image data item for the Cr color difference component at the position for attention (at the second row and the second column) indicated by the thick frame in Fig. 11(b), the generation unit 33c of the image processing unit 33 refers to the four items of main image data Cr1 through Cr4 for the color difference component at the four positions in the neighborhood of the position for attention (at the second row and the second column). The generation unit 33c of the image processing unit 33 sets, for example, (eCr1+fCr2+gCr3+hCr4)/4 as being the main image data item of the Cr color difference component at the position for attention (at the second row and the second column). Here, it should be understood that e through h are weighting coefficients that are provided according to the distances between the reference positions and the position for attention, and according to the image configuration.

In a similar manner, when generating the main image data item for the Cr color difference component at, for example, the position for attention indicated by the thick frame in Fig. 11(c) (at the second row and the third column), the generation unit 33c of the image processing unit 33 refers to the four main image data items Cr2 and Cr4 through Cr6 for the color difference component positioned in the neighborhood of that position for attention (i.e. in the neighborhood of the second row and the third column). The generation unit 33c of the image processing unit 33 sets, for example, (qCr2+rCr4+sCr5+tCr6)/4 as being the main image data item of the Cr color difference component at the position for attention (at the second row and the third column). It should be understood that q through t are weighting coefficients that are provided according to the distances between the reference positions and the position for attention, and according to the image configuration. The main image data item for the Cr color difference component at each of the pixel positions is generated in this manner.

Next, the Cr color difference component interpolation in this embodiment will be explained. It will be supposed that, in Figs. 11(a) through 11(c), for example, the first image capture conditions are applied to the region to the left of and above the thick line, while the fourth image capture conditions are applied to the region to the right of and below the thick line. And it should be understood that, in Figs. 11(a) through 11(c), the first image capture conditions and the fourth image capture conditions are different. In Fig. 11(b), the position indicated by the thick frame (at the second row and the second column) is the position for attention for the Cr color difference component. Moreover, the main image data items Cr1 through Cr4 for the Cr color difference component in Fig. 11(b) are the reference positions for performing image processing upon the pixel at the position for attention (at the second row and the second column). In Fig. 11(b), the first image capture conditions are applied to the position for attention (at the second row and the second column). And, among the reference positions, the first image capture conditions are applied to the main image data items Cr1, Cr3, and Cr4. Moreover, among the reference positions, the fourth image capture conditions are applied to the main image data item Cr2. Due to this, the correction unit 33b of the image processing unit 33 performs the second correction processing upon the main image data item Cr2. Subsequently, the generation unit 33c of the image processing unit 33 calculates the main image data item for the Cr color difference component at the position for attention (at the second row and the second column).

Furthermore, in Fig. 11(c), the position indicated by the thick frame (at the second row and the third column) is the position for attention for the Cr color difference component. Moreover, the main image data items Cr2, Cr4, Cr5, and Cr6 of the Cr color difference component in Fig. 11(c) are the reference positions for performing image processing upon the pixel at the position for attention (at the second row and the third column). In Fig. 11(c), the fourth image capture conditions are applied to the position for attention (at the second row and the third column). And, among the reference positions, the first image capture conditions are applied to the main image data items Cr4 and Cr5. Moreover, among the reference positions, the fourth image capture conditions are applied to the main image data items Cr2 and Cr6. Due to this, the correction unit 33b of the image processing unit 33 performs the second correction processing upon each of the main image data items Cr4 and Cr5. And subsequently the generation unit 33c of the image processing unit 33 calculates the main image data item for the Cr color difference component at the position for attention (at the second row and the third column).

Having obtained the main image data item for the Cr color difference component at each of the pixel positions, the generation unit 33c of the image processing unit 33 is able to obtain the main image data items for the R color component at each of the pixel positions by adding the main image data items for the G color component shown in Fig. 10(c) corresponding to respective pixel positions.

### B Color Interpolation

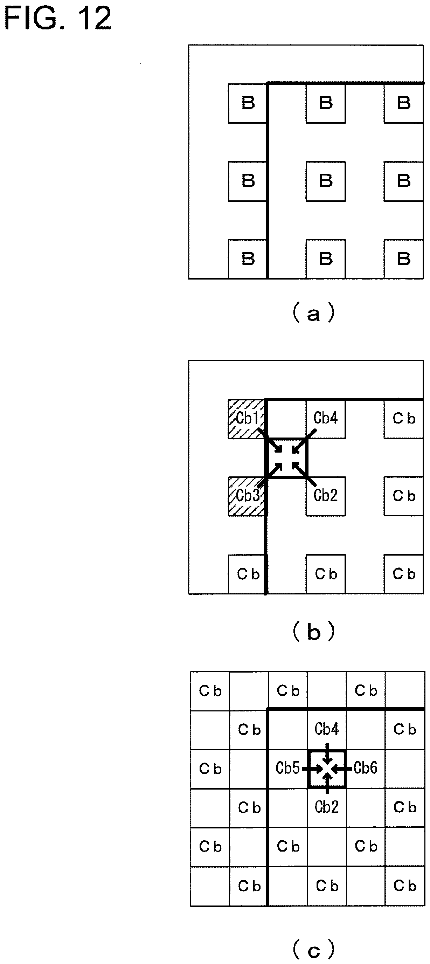

Fig. 12(a) is a figure in which main image data for the B color component has been extracted from Fig. 10(a). The generation unit 33c of the image processing unit 33 calculates the main image data for the Cb color difference component shown in Fig. 12(b) on the basis of the main image data for the G color component shown in Fig. 10(c) and the main image data for the B color component shown in Fig. 12(a).

First, the general process of interpolation of the Cb color difference component will be explained. When generating the main image data item for the Cb color difference component at, for example, the position for attention indicated by the thick frame in Fig. 12(b) (at the third row and the third column), the generation unit 33c of the image processing unit 33 refers to the four main image data items Cb1 through Cb4 for the color difference component positioned in the neighborhood of the position for attention (i.e. in the neighborhood of the third row and the third column). The generation unit 33c of the image processing unit 33 sets, for example, (uCb1+vCb2+wCb3+xCb4)/4 as being the main image data item of the Cb color difference component at the position for attention (which is at the third row and the third column). It should be understood that u through x are weighting coefficients that are provided according to the distances between the reference positions and the position for attention, and according to the structure of the image.

In a similar manner, when for example generating the main image data item for the Cb color difference component at, for example, the position for attention indicated by the thick frame in Fig. 12(c) (at the third row and the fourth column), the generation unit 33c of the image processing unit 33 refers to the four main image data items Cb2 and Cb4 through Cb6 for the color difference component positioned in the neighborhood of the position for attention (i.e. at the third row and the fourth column). The generation unit 33c of the image processing unit 33 sets, for example, (yCb2+zCb4+αCb5+βCb6)/4 as being the main image data item for the Cb color difference component at the position for attention (at the third row and the fourth column). It should be understood that y, z, α, and β are weighting coefficients that are provided according to the distances between the reference positions and the position for attention, and according to the structure of the image. The main image data items for the Cb color difference component at each of the pixel positions is generated in this manner.

Next, the Cb color difference component interpolation of this embodiment will be explained. It will be supposed that, in Figs. 12(a) through 12(c), for example, the first image capture conditions are applied to the region to the left of and above the thick line, while the fourth image capture conditions are applied to the region to the right of and below the thick line. And it should be understood that, in Figs. 12(a) through 12(c), the first image capture conditions and the fourth image capture conditions are different. In Fig. 12(b), the position indicated by the thick frame (at the third row and the third column) is the position for attention for the Cb color difference component. Moreover, the main image data items Cb1 through Cb4 of the Cb color difference component in Fig. 12(b) are the reference positions for performing image processing upon the pixel at the position for attention (at the third row and the third column). In Fig. 12(b), the fourth image capture conditions are applied to the position for attention (at the third row and the third column). And, among the reference positions, the first image capture conditions are applied to the main image data items Cb1 and Cb3. Moreover, among the reference positions, the fourth image capture conditions are applied to the main image data items Cb2 and Cb4. Due to this, the correction unit 33b of the image processing unit 33 performs the second correction processing upon the data items Cb1 and Cb3. Subsequently, the generation unit 33c of the image processing unit 33 calculates the main image data item for the Cb color difference component at the position for attention (at the third row and the third column).

Furthermore, in Fig. 12(c), the position indicated by the thick frame (at the third row and the fourth column) is the position for attention for the Cb color difference component. Moreover, the main image data items Cb2 and Cb4 through Cb6 of the Cb color difference component in Fig. 12(c) are at the reference positions for performing image processing upon the pixel at the position for attention (at the third row and the fourth column). In Fig. 12(c), the fourth image capture conditions are applied to the position for attention (at the third row and the fourth column). And the fourth image capture conditions are applied to the main image data items Cb2 and Cb4 through Cb6 at all of the reference positions. Due to this, the main image data item for the Cb color difference component at the position for attention (at the third row and the fourth column) is calculated by referring to the main image data items Cb2 and Cb4 through Cb6 at the reference positions, upon which the second correction processing is not performed by the correction unit 33b of the image processing unit 33.

Having obtained the main image data item for the Cb color difference component at each of the pixel positions, the generation unit 33c of the image processing unit 33 is able to obtain the main image data item for the B color component at each of the pixel positions by adding the main image data items for the G color component shown in Fig. 10(c) corresponding to respective pixel positions.

It should be understood that although, in the "G color interpolation" described above, for example, the four main image data items G1 through G4 that are positioned in the neighborhood of the position for attention are referred to when generating the main image data item for the G color component at the position for attention indicated by the thick frame in Fig. 10(b) (at the second row and the second column), it would also be acceptable, depending upon the structure of the image, to vary the number of main image data items of the G color component that are referred to. For example, if the image in the vicinity of the position for attention is similar in the vertical direction (for example, if it has a pattern of vertical stripes), then the interpolation processing may be performed by employing only the main image data items above and below the position for attention (in Fig. 10(b), G1 and G2). Furthermore if, for example, the image in the vicinity of the position for attention is similar in the horizontal direction (for example, if it has a pattern of horizontal stripes), then the interpolation processing may be performed by employing only the main image data items to the left and the right of the position for attention (in Fig. 10(b), G3 and G4). In these cases, the main image data item G4 upon which correction is performed by the correction unit 33b may or may not be employed. As described above, by the correction unit 33b performing the first correction processing, the second correction processing, and the interpolation processing, even if pixels where black crush has occurred such as 85b and 85d are present, it is still possible to generate an image in which this black crush is corrected.

### (3) Contour Enhancement Processing

An example of contour enhancement processing will now be explained. For example, in an image for one frame, the generation unit 33c of the image processing unit 33 may perform per se known linear filter calculation by employing a kernel of a predetermined size that is centered upon the pixel for attention P (i.e. upon the pixel that is the subject for processing). If the size of the kernel of a sharpening filter, which is one example of a linear filter, is N×N pixels, then the position of the pixel for attention P is the position for attention, and the positions of the (N²-1) reference pixels Pr surrounding the pixel for attention are the reference positions.

It should be understood that it would also be acceptable for the size of the kernel to be N×M pixels.

The generation unit 33c of the image processing unit 33 performs filter processing for replacing the main image data item at the pixel for attention P with the result of linear filter calculation, while shifting the pixel for attention along a horizontal line from left to right, for example, from the horizontal line at the top portion of the frame image to the horizontal line at its bottom portion.

In this embodiment, when a pixel to which have been applied the fourth image capture conditions which are different from the first image capture conditions that have been applied to the pixel for attention P is included in the reference pixels Pr, then the correction unit 33b of the image processing unit 33 performs the second correction processing upon the main image data item to which the fourth image capture conditions have been applied. Subsequently, the generation unit 33c of the image processing unit 33 performs the linear filter processing described above.

### (4) Noise Reduction Processing

An example of noise reduction processing will now be explained. For example, in an image for one frame, the generation unit 33c of the image processing unit 33 may perform per se known linear filter calculation by employing a kernel of a predetermined size that is centered upon the pixel for attention P (i.e. upon the pixel that is the subject for processing). If the size of the kernel of a smoothing filter, which is one example of a linear filter, is N×N pixels, then the position of the pixel for attention P is the position for attention, and the positions of the (N²-1) reference pixels Pr surrounding the pixel for attention are the reference positions.

It should be understood that it would also be acceptable for the size of the kernel to be N×M pixels.

The generation unit 33c of the image processing unit 33 performs filter processing for replacing the main image data item at the pixel for attention P with the result of linear filter calculation while shifting the pixel for attention along a horizontal line from left to right, for example from the horizontal line at the top portion of the frame image to the horizontal line at its bottom portion.

In this embodiment, when a pixel to which the fourth image capture conditions have been applied which are different from the first image capture conditions that have been applied to the pixel for attention P is included in the reference pixels Pr described above, then the correction unit 33b of the image processing unit 33 performs the second correction processing upon the main image data item to which the fourth image capture conditions have been applied. And, subsequently, the generation unit 33c of the image processing unit 33 performs the linear filter processing described above.

It should be understood that it would be acceptable for the setting unit 34b to set the entire area of the imaging surface of the imaging element 32a as the image capture region for processing or, alternatively, it would also be acceptable to set a part of the area of the imaging surface of the imaging element 32a as the image capture region for processing. In the case in which a part of the area of the imaging surface is set as the image capture region for processing, the setting unit 34b sets image capture conditions that are different from the image capture conditions set for capturing the main image data for a region including a predetermined number of blocks containing the boundaries between at least the first region 61 through the sixth region 66.

Furthermore, it would also be acceptable for the setting unit 34b to extract the image data relating to the region including a predetermined number of blocks containing the boundaries at least between the first region 61 through the sixth region 66 from the image data for processing captured by setting the entire area of the imaging surface of the imaging element 32a as the image capture region for processing, and to employ the extracted image data as the image data for processing. For example, the setting unit 34b may extract the image data relating to the region including a predetermined number of blocks sandwiching the boundary between the first region 61 and the fourth region 61 of the main image data from the image data for processing captured by employing the entire area of the imaging surface of the imaging element 32a for which the fourth image capture conditions are set, and may generate the extracted image data as the image data for processing.

Yet further, the image capture region for processing described above is not to be limited to a region that is set corresponding to the regions set for the main image data (in the example described above, the first region through the sixth region). For example, it would also be acceptable for the image capture region for processing to be set in advance to a part of the imaging surface of the imaging element 32a. If, for example, the image capture region for processing is set near to the central portion of the imaging surface of the imaging element 32a, then, when capturing an image of a person positioned at the center of the screen, as in a portrait, it is possible to generate the image data for processing in a region for which the possibility is high that the main photographic subject will be positioned therein. In this case, it would be acceptable to change the size of the image capture region for processing on the basis of user operation; or, alternatively it would also be acceptable to fix the size of the image capture region for processing set in advance.

### 2. When Performing Focus Detection Processing

In the example described above, as the first correction processing, the pixels in which clipped whites or crushed blacks or the like had occurred were replaced with the image data for processing; but, if only focus adjustment is the objective, then it will be acceptable to replace a signal from a pixel for focus detection with which white clipping or black crushing has occurred with a signal from some other pixel for focus detection. The method for replacement with another signal for focus detection is the same as the method for replacement of the image data of a pixel where white clipping or black crushing has occurred, and accordingly description of the details will here be omitted. In the case of focus adjustment on the basis of image contrast, the image data that has been replaced by the first correction processing described above may be used. The lens movement control unit 34d of the control unit 34 performs focus detection processing by employing the signal data (i.e. the image data) corresponding to a predetermined position upon the imaging screen (i.e. the point of focusing). If different image capture conditions are set for different subdivided regions, and if the point of focusing for A/F operation is positioned at a boundary portion between subdivided regions, then, as pre-processing before the focus detection processing, the lens movement control unit 34d of the control unit 34 performs the second correction processing upon the signal data for focus detection of at least one of those regions.

The second correction processing is performed in order to suppress deterioration of the accuracy of the focus detection processing originating in differences in image capture conditions between the different regions into which the imaging screen is subdivided by the setting unit 34b. For example, if the signal data for focus detection at the point of focusing where the amount of image deviation (i.e. of the phase difference) in the image is detected is positioned at a boundary portion between subdivided regions, then signal data for which the image capture conditions are mutually different may be mixed together in the signal data for focus detection. This embodiment is configured based on the consideration that it is more preferable to perform detection of the amount of image deviation (i.e. of the phase difference) by employing signal data upon which the second correction processing has been performed in order to suppress disparity in the signal data due to discrepancy in the image capture conditions, rather than performing detection of the amount of image deviation (i.e. of the phase difference) by employing signal data to which different image capture conditions have been applied just as it is without modification. The second correction processing is performed as described below.

### Example of Focus Detection Processing

Focus detection processing accompanied by the second correction processing will now be illustrated by an example. In the A/F operation of this embodiment, for example, the focus is set to a photographic subject corresponding to a point of focusing selected by the user from among a plurality of points of focusing upon the imaging screen. The lens movement control unit 34d (i.e. a generation unit) of the control unit 34 calculates the amount of defocusing of the image capture optical system 31 by detecting the amount of image deviation (i.e. the phase difference) of a plurality of images of the photographic subject formed by light fluxes that have passed through different pupil regions of the image capture optical system 31. And the lens movement control unit 34d of the control unit 34 adjusts the focal point of the image capture optical system 31 by shifting a focusing lens of the image capture optical system 31 to a position at which the defocusing amount becomes zero (i.e. is within a tolerance value), in other words to a focusing position.

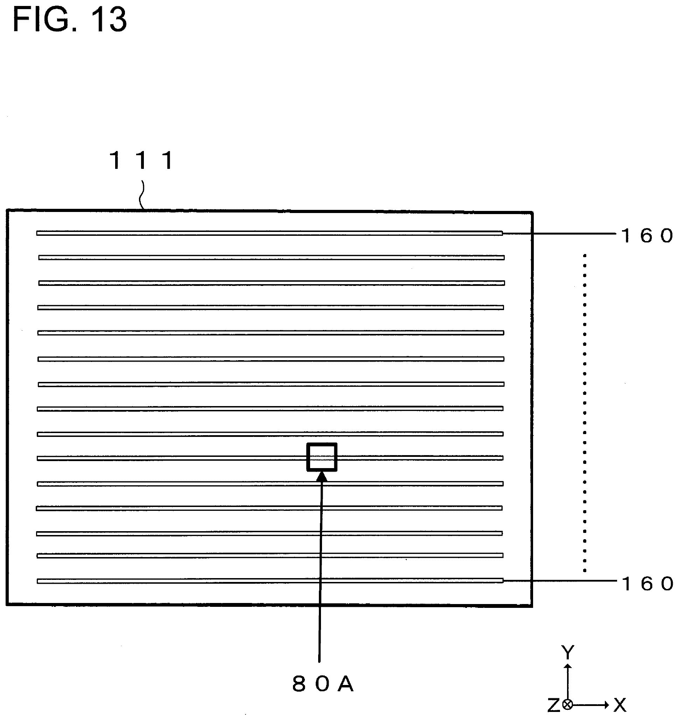

Fig. 13 is a figure showing an example of positions of pixels for focus detection upon the imaging surface of the imaging element 32a. In this embodiment, pixels for focus detection are provided as arranged discretely in lines along the X axis direction of the image capture chip 111 (i.e. along its horizontal direction). In the example of Fig. 13, fifteen focus detection pixel lines 160 are provided at predetermined intervals. Each of the pixels for focus detection making up each of these focus detection pixel lines outputs a photoelectrically converted signal for focus detection. Normal pixels for image capture are provided at pixel positions upon the image capture chip 111 other than the focus detection pixel lines 160. These pixels for image capture output photoelectrically converted signals for live view images and for recording.

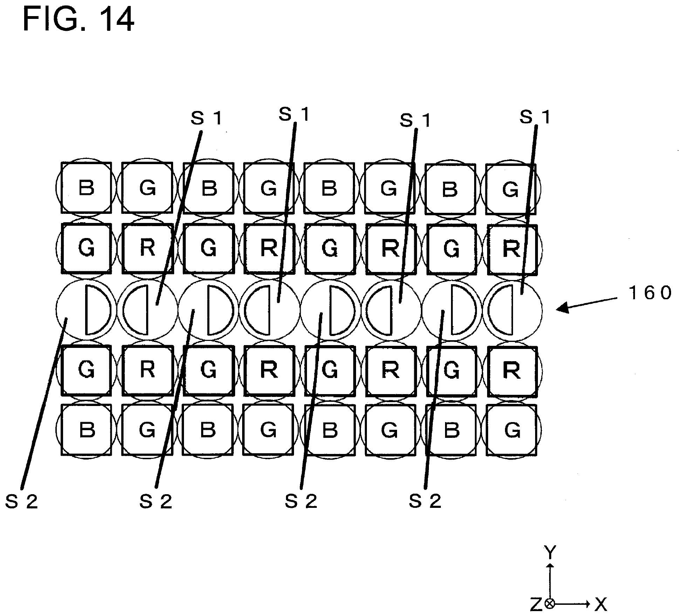

Fig. 14 is a figure in which a partial region of one of the focus detection pixel lines 160 corresponding to a point of focusing 80A shown in Fig. 13 is illustrated as enlarged. In Fig. 14, examples are shown of red color pixels R, green color pixels G (Gb and Gr), blue color pixels B, pixels for focus detection S1, and pixels for focus detection S2. The red color pixels R, the green color pixels G (Gb and Gr), and the blue color pixels B are arranged according to the Bayer array rule described above.

The square shaped regions shown by way of example for the red color pixels R, for the green color pixels G (Gb and Gr), and for the blue color pixels B represent the light reception regions of these pixels for image capture. Each of these pixels for image capture receives a light flux that has passed through the exit pupil of the image capture optical system 31 (refer to Fig. 1). In detail, each of the red color pixels R, the green color pixels G (Gb and Gr), and the blue color pixels B has a square shaped mask opening portion, and light that has passed through these mask opening portions reaches the light reception portions of these pixels for image capture.

It should be understood that the shapes of the light reception regions (i.e. of the mask opening portions) of the red color pixels R, the green color pixels G (Gb and Gr), and the blue color pixels B are not limited to being rectangular; it would also be acceptable, for example, for them to be circular.

The semicircular shaped regions of the pixels for focus detection S1 and of the focus detection pixels S2 shown by way of example represent the light reception regions of these pixels for focus detection. In more detail, each of the pixels S1 for focus detection has a semicircular shaped mask opening portion on the left side of the pixel position in Fig. 14, and light passing through this mask opening portion reaches the light reception portion of the pixel for focus detection S1. On the other hand, each of the pixels S2 for focus detection has a semicircular shaped mask opening portion on the right side of the pixel position in Fig. 14, and light passing through this mask opening portion reaches the light reception portion of the pixel for focus detection S2. In this manner, each of the pixels for focus detection S1 and the pixels for focus detection S2 receives one of a pair of light fluxes that have passed through different regions of the exit pupil of the image capture optical system 31 (refer to Fig. 1).

It should be understood that the positions of the focus detection pixel lines 160 upon the image capture chip 111 are not to be considered as being limited to the positions shown by way of example in Fig. 13. Moreover, the number of the focus detection pixel lines 160 also is not to be considered as being limited to the number shown by way of example in Fig. 13. Yet further, the shapes of the mask opening portions of the pixels for focus detection S1 and of the pixels for focus detection S2 are not to be considered as being limited to being semicircular; it would also be acceptable, for example, to arrange for these mask opening portions to be formed in rectangular shapes by dividing the rectangular shaped light reception regions (i.e. the mask opening portions), such as of the R pixels for image capture, of the G pixels for image capture, and of the B pixels for image capture, in the horizontal direction.

It would also be acceptable for the focus detection pixel lines 160 upon the image capture chip 111 to be provided by the pixels for focus detection being arranged linearly along the Y axis direction of the image capture chip 111 (i.e. along its vertical direction). An imaging element in which pixels for image capture and pixels for focus detection are arranged in a two dimensional array as shown in Fig. 14 is per se known, and accordingly detailed illustration and explanation of these pixels will be omitted.

It should be understood that, in the example of Fig. 14, a so called 1PD structure has been explained that has a structure in which each of the pixels for focus detection S1 and S2 receives one of a pair of light fluxes for focus detection. Instead of this, it would also be acceptable to adopt a so called 2PD structure in which each of the pixels for focus detection S1 and S2 receives both of a pair of light fluxes for focus detection. By adopting a 2PD structure, it becomes possible also to employ the photoelectrically converted signals obtained by the pixels for focus detection as photoelectrically converted signals for recording.

On the basis of the photoelectrically converted signals for focus detection outputted from the pixels for focus detection S1 and from the pixels for focus detection S2, the lens movement control unit 34d of the control unit 34 detects the amount of image deviation (i.e. of the phase difference) between the pair of images by the pair of light fluxes that have passed through different regions of the image capture optical system 31 (refer to Fig. 1). And the defocusing amount is calculated on the basis of this amount of image deviation (i.e. on the basis of the phase difference). Since this type of defocusing amount calculation according to the split pupil phase difference method is per se known in the camera field, accordingly detailed explanation thereof will be omitted.

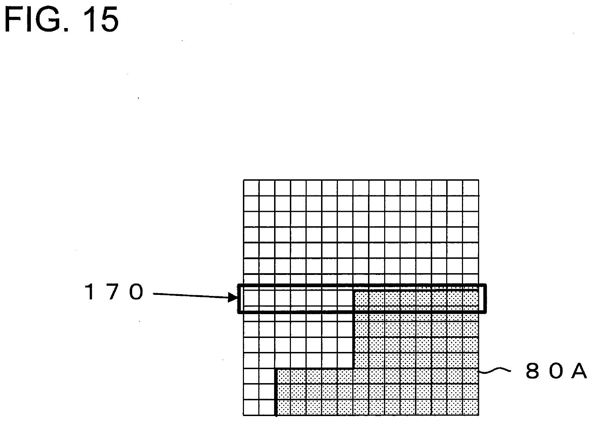

It will be supposed that, for example, the point of focusing 80A (refer to Fig. 13) is selected by the user at a position in the live view image 60a shown by way of example in Fig. 7(a) that corresponds to the region for attention 90 at the boundary portion between the first region 61 and the fourth region 64. Fig. 15 is a figure in which the point of focusing 80A is shown as enlarged. The pixels shown as white are ones for which the first image capture conditions are set, while the pixels shown with stippling are ones for which the fourth image capture conditions are set. The positions in Fig. 15 surrounded by the frame 170 correspond to a focus detection pixel line 160 (refer to Fig. 13).

Normally, the lens movement control unit 34d of the control unit 34 performs focus detection processing by employing the signal data from the pixels for focus detection shown by the frame 170 just as it is, without performing the second correction processing. However, if signal data to which the first image capture conditions have been applied and signal data to which the fourth image capture conditions have been applied are mixed together in the signal data enclosed by the frame 170, then, as described in the following Example 1 through Example 3, the lens movement control unit 34d of the control unit 34 performs the second correction processing upon the signal data that, among the signal data enclosed by the frame 170, has been captured under the fourth image capture conditions. And the lens movement control unit 34d of the control unit 34 performs focus detection processing by employing the signal data after the second correction processing.

### Example 1

For example, if the first image capture conditions and the fourth image capture conditions only differ by ISO sensitivity, with the ISO sensitivity of the first image capture conditions being 100 while the ISO sensitivity of the fourth image capture conditions is 800, then the lens movement control unit 34d of the control unit 34 may perform the second correction processing by multiplying the signal data that was obtained under the fourth image capture conditions by 100/800. In this manner, disparity between the signal data due to discrepancy in the image capture conditions is reduced.

It should be understood that, when the amount of light incident upon the pixels to which the first image capture conditions have been applied and the amount of light incident upon the pixels to which the fourth image capture conditions have been applied are the same, then the disparity in the signal data becomes small. If, for instance, the amount of light incident upon the pixels to which the first image capture conditions have been applied and the amount of light incident upon the pixels to which the fourth image capture conditions have been applied are radically different, the disparity in the signal data may not be reduced. The same applies to the examples that will be described hereinafter.

### Example 2

For example, if the first image capture conditions and the fourth image capture conditions only differ by shutter speed, with the shutter speed of the first image capture conditions being 1/1000 second while the shutter speed of the fourth image capture conditions is 1/100 second, then the lens movement control unit 34d of the control unit 34 may perform the second correction processing by multiplying the signal data that was obtained under the fourth image capture conditions by 1/1000/1/100=1/10. By doing this, disparity between the signal data due to discrepancy in the image capture conditions is reduced.

### Example 3

For example, if the first image capture conditions and the fourth image capture conditions only differ by frame rate (the charge accumulation time being the same), with the frame rate of the first image capture conditions being 30 fps while the frame rate of the fourth image capture conditions is 60 fps, then, for the signal data that was obtained under the fourth image conditions (i.e. at 60 fps), the lens movement control unit 34d of the control unit 34 may perform the second correction processing by employing signal data of a frame image whose acquisition start timing is close to that of a frame image that was acquired under the first image capture conditions (at 30 fps). In this manner, disparity between the signal data due to discrepancy in the image capture conditions is reduced.

It should be noted that it would also be acceptable to perform interpolation calculation as the second correction processing to calculate the signal data of a frame image whose acquisition start timing is close to that of a frame image acquired under the first image capture conditions (i.e. at 30 fps), on the basis of a plurality of previous and subsequent frame images acquired under the fourth image capture conditions (i.e. at 60 fps).

On the other hand, if the image capture conditions applied to all of the signal data enclosed by the frame 170 are the same, then the lens movement control unit 34d of the control unit 34 does not perform the second correction processing described above. In other words, the lens movement control unit 34d of the control unit 34 performs the focus detection processing by employing the signal data from the pixels for focus detection shown by the frame 170 just as it is without alteration.

It should be understood that, as described above, even if there are some moderate differences in the image capture conditions, still they are regarded as being the same image capture conditions.

Furthermore while, in the example described above, an example was explained in which the second correction processing was performed by referring to the first image capture conditions upon the signal data that, among the signal data, was acquired under the fourth image capture conditions, it would also be acceptable to perform the second correction processing based on the fourth image capture conditions upon the signal data that, among the signal data, was acquired under the first image capture conditions.

Whether the lens movement control unit 34d of the control unit 34 performs the second correction processing upon the signal data that was obtained under the first image capture conditions, or performs the second correction processing upon the signal data that was obtained under the fourth image capture conditions, may, for example, be determined on the basis of the ISO sensitivity. If the ISO sensitivity is different between the first image capture conditions and the fourth image capture conditions, then it is desirable to perform the second correction processing upon the signal data that was obtained under the image capture conditions whose ISO sensitivity was the lower, provided that the signal data that was obtained under the image capture conditions whose ISO sensitivity was the higher is not saturated. In other words, if the ISO sensitivity is different between the first image capture conditions and the fourth image capture conditions, then it is preferable to perform the second correction processing upon the signal data that is the darker, in order to reduce its difference from the signal data that is the brighter.

Yet further, it would also be acceptable to arrange to reduce the difference between the two sets of signal data after the second correction processing, by performing the second correction processing upon, among the signal data, both the signal data that was obtained under the first image capture conditions and also the signal data that was obtained under the fourth image conditions.

In the explanation given above an example of focus detection processing employing the split pupil phase difference method was described, but it would also be possible to perform focus detection processing in a similar manner in the case of a contrast detection method in which the focusing lens of the image capture optical system 31 is shifted to its focusing position on the basis of the amount of contrast in the image of the photographic subject.

If such a contrast detection method is employed, then, while shifting the focusing lens of the image capture optical system 31, the control unit 34 performs per se known calculation of a focus evaluation value for each position of the focusing lens on the basis of signal data outputted from the pixels for image capture of the imaging element 32a corresponding to the point of focusing. And the position of the focusing lens that maximizes this focus evaluation value is obtained as being the focusing position.

Normally, the control unit 34 performs calculation of the focus evaluation value by employing the signal data outputted from the pixels for image capture corresponding to the point of focusing just as it is, without performing second correction processing. However, if signal data to which the first image capture conditions have been applied and signal data to which the fourth image capture conditions have been applied are mixed together in the signal data corresponding to the point of focusing, then, among the signal data corresponding to the point of focusing, the control unit 34 performs the second control processing described above upon the signal data that was obtained under the fourth image capture conditions. And the control unit 34 then performs calculation of the focus evaluation value by employing the signal data after the second correction processing. In this manner, by performing the first correction processing, the second correction processing, and the interpolation processing, the correction unit 33b is able to perform correction of black crush and focus adjustment even if black crush pixels such as 85b and 85d are present. As a result, it is possible to adjust the focal point by shifting the lens, even if black crush pixels such as 85b and 85d occur.

In the example described above, the focus adjustment processing is performed after the second correction processing has been performed, but it would also be acceptable to perform the focus adjustment based on the image data obtained by the first correction processing, without performing the second correction processing.

It should be understood that, as described above, it would be acceptable for the setting unit 34b to set the entire area of the imaging surface of the imaging element 32a as the image capture region for processing; or, alternatively, it would also be acceptable for a part of the area of the imaging surface of the imaging element 32a to be set as the image capture region for processing. If a part of the area of the imaging surface is set as the image capture region for processing, then, as the image capture region for processing, the setting unit 34b should set a range that includes at least the frame 170, a region corresponding to a range that includes the point of focusing, or the central portion and its neighborhood of the imaging surface of the imaging element 32a.

Furthermore, it would also be acceptable for the setting unit 34b to extract, from image data for processing that has been captured by setting the entire area of the imaging surface as the image capture region for processing, a region corresponding to a range that includes the frame 170, or a region corresponding to a range that includes the point of focusing, in order to generate the image data for processing.

### 3. When Performing Photographic Subject Detection Processing

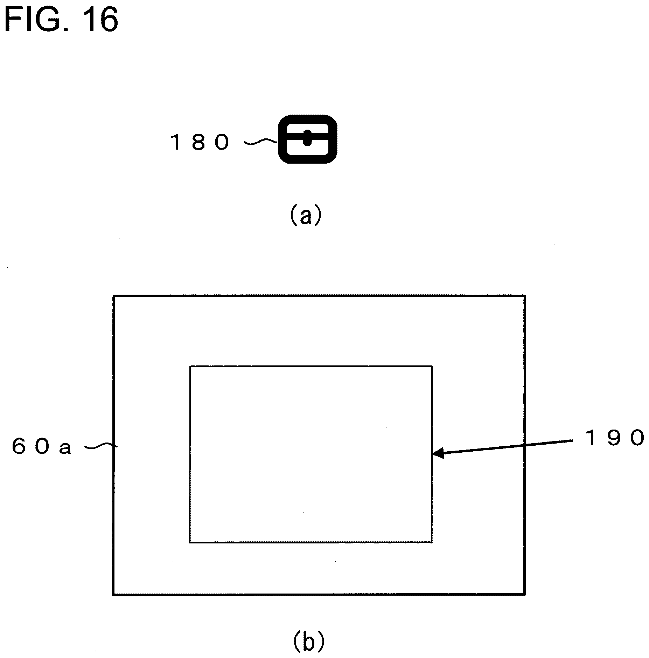

Fig. 16(a) is a figure showing an example of a template image in which an object to be detected is represented, and Fig. 16(b) is a figure showing an example of a live view image 60a and a search range 190. The object detection unit 34a of the control unit 34 detects an object (for example the bag 63a, which is one of the elements of the photographic subject of Fig. 5) from the live view image. It would be acceptable to arrange for the object detection unit 34a of the control unit 34 to set the range for detection of the object as being the entire range of the live view image 60a; but it would also be acceptable, in order to reduce the burden of the detection processing, to arrange for only a part of the live view image 60a to be set as the search range 190.

When different image capture conditions are set for different subdivided regions, and the search range 190 includes a boundary between subdivided regions, then, as pre-processing before performing the photographic subject detection processing, the object detection unit 34a of the control unit 34 performs the second correction processing upon the main image data for at least one region within the search range 190.

The second correction processing is performed in order to prevent degradation of the accuracy of the processing for detection of the elements of the photographic subject, originating in the fact that the image capture conditions are different for different regions of the image screen subdivided by the setting unit 34b. In general, if a boundary between subdivided regions is included in the search range 190 that is used for detecting elements of the photographic subject, main image data items to which different image conditions have been applied may be mixed together in the image data for the search range 190. In this embodiment, on the basis of the consideration that it is preferable to perform detection of the elements of the photographic subject by employing a main image data item upon which the second correction processing has been performed in order to suppress the disparity in the main image data items due to discrepancy in the image capture conditions, rather than performing detection of the elements of the photographic subject by employing a main image data item to which different image capture conditions have been applied just as it is without alteration, the second correction processing is performed in the following manner.

The case will now be explained of detection of the bag 63a, which is an object that is being held by the person 61a, in the live view image 60a shown by way of example in Fig. 6. The object detection unit 34a of the control unit 34 sets the search range 190 to the region that includes the person 61a and the vicinity thereof. It should be understood that it would also be acceptable to set the region 61 that includes the person 61a as the search range.

If the search range 190 is not divided into sections by two regions for which the image capture conditions are different, then the object detection unit 34a of the control unit 34 performs the photographic subject detection processing by employing the main image data for the search range 190 just as it is, without performing the second correction processing. However, if a main image data item to which the first image capture conditions have been applied and a main image data item to which the fourth image capture conditions have been applied are mixed together in the image data for the search range 190, then the object detection unit 34a of the control unit 34 performs the second correction processing as described above in Example 1 through Example 3 for the case of performing focus detection processing upon the main image data item that, among the main image data in the search range 190, was captured under the fourth image capture conditions. And then the object detection unit 34a of the control unit 34 performs the photographic subject detection processing by employing the main image data item after this second correction processing.

It should be understood that, as described above, even if there is some slight difference in the image capture conditions, still they are considered as being the same image capture conditions.

Furthermore, in the example described above, an example was explained in which the second correction processing was performed according to the first image capture conditions upon the main image data item that, among the main image data, was captured under the fourth image capture conditions; but it would also be acceptable to perform the second correction processing according to the fourth image capture conditions upon the main image data item that, among the main image data, was captured under the first image capture conditions.

It would also be acceptable to apply the second correction processing performed upon the main image data in the search range 190 described above to a search range that is employed for detection of a specific photographic subject such as the face of a person, or to a region that is employed for determination of the image capture scene.

Moreover, the second correction processing performed upon the main image data in the search range 190 described above is not to limited to a search range that is employed in a pattern matching method that uses a template image, but could also be applied in a similar manner to a search range that is employed when detecting the amount of a characteristic based upon the color of the image or upon its contour or the like.

Furthermore it would also be acceptable, by performing per se known template matching processing in which sets of the main image data for a plurality of frames whose time points of acquisition are different are employed, to apply the method described above to processing for tracking a moving object for finding, in a frame image acquired subsequently, a region that resembles a tracked object in a frame that has been previously acquired. In this case, if a main image data item to which the first image capture conditions have been applied and a main image data item to which the fourth image capture conditions have been applied are mixed together in the search range set for the frame image that is acquired later, then the control unit 34 performs the second correction processing as described above in Example 1 through Example 3 upon the main image data item that, among the main image data in the search range, was captured under the fourth image capture conditions. And the control unit 34 performs tracking processing by employing the main image data after this second correction processing.

Even further, the same holds for a case in which per se known movement vector detection is performed by employing sets of main image data for a plurality frames whose time points of acquisition are different. If main image data to which the first image capture conditions have been applied and main image data to which the fourth image capture conditions have been applied are mixed together in the detection region that is employed for detection of the movement vector, then the control unit 34 performs the second correction processing as described above in Example 1 through Example 3 upon the main image data item that, among the main image data in the detection region that is employed for detection of the movement vector, was captured under the fourth image capture conditions. And the control unit 34 detects the movement vector by employing the main image data after the second correction processing. In this manner, by performing the first correction processing, the second correction processing, and the interpolation processing, even if the pixels 85b and 85d where black crushing has occurred are present, the correction unit 33b is able to perform correction of such black crushing and to perform the detection of the photographic subject described above. As a result, it is possible to perform detection of the photographic subject, even if the black crush pixel 85b or 85d is present.

In the example described above, the photographic subject detection processing was performed after having performed the second correction processing, but it would also be acceptable to perform photographic subject detection according to the image data that was obtained by the first correction processing, without performing the second correction processing.

It should be understood that, as described above, it would be acceptable for the setting unit 34b to set the entire area of the imaging surface of the imaging element 32a as the image capture region for processing; or, alternatively, it would also be acceptable to set a partial region of the imaging surface of the imaging element 32a as the image capture region for processing. If a partial region of the imaging surface is set as the image capture region for processing, then the setting unit 34b may set, as the image capture region for processing, a range that includes at least the search range 190, a region corresponding to a range including a range that is employed for detection of a movement vector, or the central portion and its neighborhood of the imaging surface of the imaging element 32a.

Furthermore, it would also be acceptable for the setting unit 34b to extract, from the image data for processing captured by setting the entire area of the imaging surface of the imaging element 32a as the image capture region for processing, a range that includes the search range 190, or a range including a detection range employed for detection of a movement vector, and to generate image data for processing therefrom.

### 4. When Setting the Image Capture Conditions

In a situation in which the imaging screen is subdivided into regions and different image capture conditions are set for different subdivided regions, when photometry is again performed to determine the exposure conditions, the setting unit 34b performs the second correction processing upon a main image data item of at least one of the regions as pre-processing for setting exposure conditions.

The second correction processing is performed in order to suppress degradation of the accuracy of processing for determination of the exposure conditions, originating in discrepancy in the image capture conditions between the regions of the imaging screen subdivided by the setting unit 34b. For example, if a boundary between the subdivided regions is included in a photometric range that is set for the central portion of the imaging screen, a main image data item to which different image capture conditions have been applied may be mixed together in the main image data for the photometric range. In this embodiment, on the basis of the consideration that it is more preferable to perform exposure calculation processing by employing a main image data item that has been subjected to the second correction processing, in order to reduce the disparity between the main image data items due to discrepancy in the image capture conditions rather than performing exposure calculation processing by employing a main image data item to which different image capture conditions have been applied just as it is without alteration, the second correction processing is performed in the following manner.

If the photometric range is not divided into a plurality of regions whose image capture conditions are different, then the setting unit 34b of the control unit 34 performs the exposure calculation processing by employing the main image data for the photometric range just as it is without alteration, without performing the second correction processing. However, if a main image data item to which the first image capture conditions have been applied and a main image data item to which the fourth image capture conditions have been applied are mixed together in the main image data for the photometric range, then the setting unit 34b of the control unit 34 performs the second correction processing as described in Example 1 through Example 3 above when performing focus detection processing or photographic subject detection processing upon the image data for which, among the main image data for the photometric range, the fourth image capture conditions were applied. And the setting unit 34b of the control unit 34 performs exposure calculation processing by employing the main image data after the second correction processing.

It should be understood that, as described above, even if there is some slight difference in the image capture conditions, still they are considered as being the same image capture conditions.

Moreover, in the example described above, an example was explained in which the second correction processing was performed according to the first image capture conditions upon the main image data item that, among the main image data, was captured under the fourth image capture conditions, but it would also be acceptable to perform the second correction processing according to the fourth image capture conditions upon the main image data item that, among the main image data, was captured under the first image capture conditions.

The application of this processing is not limited to the photometric range employed for performing the exposure calculation processing described above; the same would apply for the photometric (colorimetry) range employed when determining the white balance adjustment value, and/or for the photometric range employed when determining whether or not to cause a light source to emit auxiliary photographic light, and/or for the photometric range employed when determining the amount of auxiliary photographic light to be emitted by the light source mentioned above.

Furthermore, in a case in which the readout resolution of the photoelectrically converted signals is different between the various regions into which the imaging screen is subdivided, the above method may be applied in a similar manner to the regions that are employed for the determination of the image capture scene when determining the readout resolution for each region. By the correction unit 33b performing the first correction processing, the second correction processing, and the interpolation processing in this manner, even if black crush pixels such as the pixels 85b and 85d occur, still it is possible to perform setting of the photographic conditions while correcting for this black crush. As a result, it is possible to set the photographic conditions even if the black crush pixel 85b or 85d occurs.

In the example described above, the setting of the photographic conditions is performed after the second correction processing, but it would also be acceptable to perform setting of the photographic conditions based on the image data obtained by the first correction processing, without performing the second correction processing.

It should be understood that, as described above, it would be acceptable for the setting unit 34b to set the entire area of the imaging surface of the imaging element 32a as the image capture region for processing; or, alternatively, it would also be acceptable to set a partial area of the imaging surface of the imaging element 32a as the image capture region for processing. If a partial area of the imaging surface is set as the image capture region for processing, then the setting unit 34b may set, as the image capture region for processing, a region corresponding to a range that includes at least the photometric range, or the central portion and the vicinity thereof of the imaging surface of the imaging element 32a.

Furthermore, it would also be acceptable for the setting unit 34b to extract a range that includes the photometric range from the image data for processing captured by setting the entire area of the imaging surface of the imaging element 32a as the image capture region for processing, and to generate the image data for processing therefrom.

The timings for generation of the image data for processing that is employed in the first correction processing described above will now be explained. In the following, these timings will be separated into the timing for generating the image data for processing that is employed in the image processing, and the timing for generating the image data for processing that is employed in the focus detection processing, in the photographic subject detection processing and in the image capture conditions setting processing (hereinafter referred to as the "detection and setting processing"); and these timings will be explained separately.

### Generation of the Image Data for Processing Employed in the Image Processing

The image capture control unit 34c causes the image capture unit 32 to capture the image data for processing at a different timing from the timing at which the main image data is captured. In this embodiment, the image capture control unit 34c causes the image capture unit 32 to capture the image data for processing at the time of display of the live view image, or at the time of operation of the operation member 36. Furthermore, when commanding the image capture control unit 32 to perform capture of the image data for processing, the image capture control unit 34c outputs information specifying the image capture conditions that are set by the setting unit 34b for the image data for processing. In the following, capture of the image data for processing when the live view image is displayed, and capture of the image data for processing when the operation member 36 is actuated, will be explained separately.

### (1) When the Live View Image is Displayed

The image capture control unit 34c causes the image capture unit 32 to capture the image data for processing, after actuation has been performed by the user for commanding display of a live view image to be started. In this case, during display of the live view image, the image capture control unit 34c causes the image capture unit 32 to capture the image data for processing on predetermined cycles. For example, the image capture unit 34c outputs a signal to the image capture unit 32 commanding it to perform capture of the image data for processing, instead of outputting a command for capturing the live view image, at a timing related to the frame rate of the live view image, for example at the timing for capturing each even numbered frame of the live view image, or at the timing following the capture of each tenth frame of the live view image. At this time, the image capture control unit 34c causes the image capture unit 32 to capture the image data for processing under the image capture conditions that have been set by the setting unit 34b.

Referring to Fig. 17, an example is shown of the relationship between the timing of capturing the image data for the live view image and the timing of capturing the image data for processing. Fig. 17(a) shows a case in which capture of the live view image and capture of the image data for processing are performed alternatingly.

It should be understand that it will be supposed that, according to actuation by the user, the first image capture conditions through the third image capture conditions have been set for the first region 61 through the third region 63 respectively (refer to Fig. 7(a)). Here, first image data for processing D1 for which the first image capture conditions are set, second image data for processing D2 for which the second image capture conditions are set, and third image data for processing D3 for which the third image capture conditions are set are captured for use in the processing of the main image data for the first region 61 through the third region 63 respectively.

The image capture control unit 34c issues a command to the image capture unit 32 for capturing the N-th frame of the live view image LV1, and the control unit 34 causes this live view image LV1 that has thus been captured to be displayed upon the display unit 35. And, at the timing for capturing the (N+1)-th frame, the image capture control unit 34c issues a command to the image capture unit 32 for capturing the first image data for processing D1 to which the first image capture conditions are applied. And the image capture control unit 34c causes, for example, the recording unit 37 to record the first image data for processing D1 that has been thus captured upon a predetermined recording medium (not shown in the figures). In this case, as the (N+1)-th frame of the live view image, the control unit 34 causes the live view image LV1 that has been captured at the timing of capturing the N-th frame to be displayed upon the display unit 35. In other words, the display of the previous frame of the live view image LV1 is continued.

And, at the timing for capturing the (N+2)-th frame of the live view image LV2, the image capture control unit 34c issues a command to the image capture unit 32 for capturing the (N+2)-th frame of the live view image LV2. And the control unit 34 changes over from the display of the live view image LV1 on the display unit 35 to display of the live view image LV2 that has been obtained by capturing the (N+2)-th frame. And then, at the timing for capturing the (N+3)-th frame, the image capture control unit 34c causes the image capture unit 32 to capture the second image data for processing D2 to which the second image capture conditions are applied, and this second image data for processing D2 that has thus been captured is recorded. Also in this case, as the (N+3)-th frame of the live view image, the control unit 34 continues the display upon the display unit 35 of the live view image LV2 that has been captured at the timing of capturing the (N+2)-th frame.

For the (N+4)-th frame, in a similar manner to the cases of the N-th frame and the (N+2)-th frame, the image capture control unit 34c causes the image capture unit 32 to capture the live view image LV3, and the control unit 34 causes the display unit 35 to display this live view image LV3 that has thus been captured. And then, for the (N+5)-th frame, the image capture control unit 34c causes the image capture unit 32 to capture the third image data for processing D3 to which the third image capture conditions are applied. At this time, in a similar manner to that described above, the control unit 34 continues the display of the (N+4)-th live view image LV3 upon the display unit 35. And, for the subsequent frames, the control unit 34 repeatedly performs the processing shown above for the N-th frame through the (N+5)-th frame.

When the setting unit 34b changes the image capture conditions on the basis of the result of detection by the object detection unit 34a and/or the result of calculation by the lens movement control unit 34d, the image capture unit 32 may cause image capture to be performed by applying the newly set image capture conditions at the timing for capture of the image data for processing (in Fig. 17(a), the (N+1)-th frame, the (N+3)-th frame, the (N+5)-th frame).

It should be understood that it would also be acceptable for the image capture control unit 34c to cause the image capture unit 32 to capture the image data for processing before starting the display of the live view image. For example, a signal that commands capture of the image data for processing may be outputted to the image capture unit 32 at the timing when the user actuates to turn on the camera 1, or when actuation is performed for commanding the start of display of a live view image. When capturing of the first image data for processing through the third image data for processing has been completed, the image capture unit 34c commands the image capture unit 32 to capture a live view image.

For example, as shown in Fig. 17(b), the image capture control unit 34c may capture the first image data for processing D1 under the first image capture conditions, the second image data for processing D2 under the second image capture conditions, and the third image data for processing D3 under the third image capture conditions, at the respective timings of capture of the first frame through the third frame. For the fourth frame and subsequent frames, the image capture control unit 34c causes the live view images LV1, LV2, LV3... to be captured, and the control unit 34 causes the display unit 35 to display these live view images LV1, LV2, LV3... in sequence.

Moreover, it would also be acceptable for the image capture control unit 34c to cause the image capture unit 32 to capture the image data for processing at the timing when the user performs actuation for termination of display of the live view image during the display of the live view image. In other words, when an operation signal is inputted from the operation member 36 corresponding to an actuation for commanding the termination of the display of the live view image, then the image capture control unit 34c outputs a signal to the image capture unit 32 commanding it to terminate capture of the live view image. And, when the image capture unit 32 terminates capture of the live view image, then the image capture control unit 32c outputs a signal to the image capture unit 32 commanding to capture the image data for processing.

For example, as shown in Fig. 17(c), when actuation is performed to terminate the display of the live view image at the N-th frame, the image capture control unit 34c causes the first image data for processing D1 to be captured under the first image capture conditions, the second image data for processing D2 to be captured under the second image capture conditions, and the third image data for processing D3 to be captured under the third image capture conditions in the (N+1)-th frame through the (N+3)-th frame respectively. In this case, it would be acceptable for the control unit 34 to cause the live view image LV1 that has been captured at the N-th frame to be displayed upon the display unit 35 during the time periods of the (N+1)-th frame through the (N+3)-th frame; or, alternatively, this display of the live view image may not be performed.

Furthermore, the image capture control unit 34c may cause the image data for processing to be captured for all of the frames of the live view image. In this case, the setting unit 34b sets image capture conditions for the entire area of the imaging surface of the imaging element 32a which are different for each frame. The control unit 34 displays the image data for processing that has been generated upon the display unit 35 as a live view image.

Yet further it will also be acceptable for the image capture control unit 34, during display of the live view image, to cause the image data for processing to be captured when a change has taken place in the composition of the image that is being captured. For example, the image capture control unit 34c may issue a command for capture of the image data for processing when the position of an element of the photographic subject that is detected by the setting unit 34b of the control unit 34 on the basis of the live view image deviates by a predetermined distance or greater as compared with the position of that element of the photographic subject detected for the previous frame.

### (2) Actuation of the Operation Member 36

Actuation of the operation member 36 for capturing the image data for processing may, for example, include half press actuation of a release button by the user, in other words actuation for commanding preparation for image capture, or full press actuation of the release button, in other words actuation for commanding actual image capture, or the like.

### (2-1) Half Press Actuation of the Release Button

When half press actuation of the release button is performed by the user, in other words when actuation is performed for commanding preparation for image capture, a half press actuation signal is outputted from the operation member 36. This half press actuation signal is outputted from the operation member 36 during the period in which the release button is half pressed by the user. When the above described half press actuation signal corresponding to the start of operation for commanding preparation for image capture is inputted from the operation member 36, the image capture control unit 34c of the control unit 34 outputs a signal to the image capture unit 32 commanding to capture the image data for processing. In other words, the image capture unit 32 captures the image data for processing according to the start of actuation by the user for commanding preparations to be made for image capture.

It should be understood that it would be acceptable for the image capture control unit 34c to cause the image capture unit 32 to capture the image data for processing at the timing that half press actuation of the release button by the user ends, for example at the timing at which half press actuation ends due to transition from half press actuation to full press actuation. In other words, it would be acceptable for the image capture control unit 34c to output to the image capture unit 32 a signal commanding image capture, at the timing that the operation signal from the operation member 36 corresponding to actuation for commanding preparations to be made for image capture ceases to be inputted.

Furthermore, it would also be acceptable for the image capture control unit 34c to cause the image capture unit 32 to capture the image data for processing while half press actuation of the release button by the user is being performed. In this case, the image capture control unit 34c may output a signal commanding image capture to the image capture unit 32 on predetermined cycles. In this manner, it is possible to capture the image data for processing while the user is performing half press actuation of the release button. Or, alternatively, it would also be acceptable for the image capture control unit 34c to output a signal commanding capture to the image capture unit 32 at a timing that is matched to capture of the live view image. In this case, the image capture control unit 34c may output a signal commanding capture of the image data for processing to the image capture unit 32 at, for example, the timing that each even numbered frame is captured in the frame rate of the live view image, or at the timing after every tenth frame of the live view image is captured.

It should be understood that, if image data for processing is being captured during display of the live view image, the image data for processing need not be captured on the basis of half press actuation of the release button.

### (2-2) Full Press Actuation of the Release Button

When full press actuation of the release button, in other words actuation to command main image capture, is performed by the user, a full press operation signal is outputted from the operation member 36. When the image capture control unit 34c of the control unit 34 receives a full press operation signal from the operation member 36 corresponding to actuation for commanding main image capture, then it outputs a signal commanding main image capture to the image capture unit 32. After the main image data has been captured by the main image capture, the image capture control unit 34c outputs a signal to command capture of the image data for processing. In other words, after full press actuation has been performed by the user for commanding image capture, the image capture unit 32 captures the main image data by the main image capture and then, captures the image data for processing.

It should be understood that it would be acceptable for the image capture control unit 34c to capture the image data for processing before causing the image capture unit 32 to capture the main image data. The image capture control unit 34c records the image data for processing that has thus been acquired before capturing the main image data, for example with the recording unit 37 upon a recording medium (not shown in the figures). By doing this, after capture of the main image data, it is possible to employ the image data for processing that has been recorded for generation of the main image data.

Additionally, if the image data for processing is captured during display of the live view image, it will be acceptable not to perform image capture of the image data for processing in response to half press actuation of the release button.

It should be understood that actuation of the operation member 36 for capturing the image data for processing is not to be considered as being limited to half press actuation or full press actuation of the release button. For example, it would be acceptable for the image capture control unit 34c to issue a command for capture of the image data for processing, when an actuation related to image capture other than actuation of the release button is performed by the user. Such an actuation related to image capture may be, for example, actuation to change the image magnification, actuation to adjust the aperture, actuation related to focus adjustment (for example, selection of a point for focusing), or the like. When the actuation for adjustment is completed and a new setting is accepted on the basis of this actuation for adjustment, then the image capture control unit 34c causes the image capture unit 32 to capture the image data for processing. In this manner, it is possible to generate image data for processing that has been captured under the same conditions as the main image capture, even when main image capture is performed under the new settings.

It should be understood that it would be acceptable for the image capture control unit 34c to capture the image data for processing when an operation of a menu item upon a menu screen is performed. This is arranged in view of the possibility being high that a new setting is being established for the main image capture when an operation corresponding to image capture is performed on the menu screen. In this case, the image capture unit 32 performs capture of the image data for processing during the period in which the menu screen is open. It will be acceptable for this capture of the image data for processing to be performed on predetermined cycles; or, alternatively, at the same frame rate for capturing the live view image.

When an actuation that is not related to image capture is being performed, for example an actuation for reproduction and display of an image, or an actuation during such reproduction and display, or an actuation for setting a clock, then the image capture control unit 34c does not output any signal for commanding capture of the image data for processing. In other words, the image capture control unit 34c does not cause the image capture unit 32 to perform capture of the image data for processing. In this manner, it is possible not to perform capture of the image data for processing, if the possibility is low that a new setting will be established for capture of the main image, or if the possibility is low that capture of the main image will be performed.

Moreover, if the operation members 36 include a dedicated button for commanding capture of the image data for processing, then the image capture control unit 34c issues a command for capture of the image data for processing to the image capture unit 32 when this dedicated button is actuated by the user. And, if the operation members 36 are so structured that the actuation signal continues to be outputted while this dedicated button is being actuated by the user, then it will be acceptable for the image capture control unit 34c to cause the image capture unit 32 to capture the image data for processing upon a predetermined cycle during the period while this dedicated button is being actuated; or, alternatively, it will also be acceptable for the image data for processing to be captured at the time point that actuation of this dedicated button terminates. In this manner, it is possible to ensure that the image data for processing is captured at the timing desired by the user.

Furthermore, it would also be acceptable for the image capture control unit 34c to issue a command to the image capture unit 32 for capturing the image data for processing, when an operation is performed to turn on the power supply of the camera 1.

With the camera 1 of the present embodiment, it would be acceptable to capture the image data for processing by applying all of the methods shown above by way of example; or it could be arranged for the image data for processing to be captured by application of at least one such method; or it could be arranged for the image data for processing to be captured by application of one or more methods selected by the user from among several methods. The selection by the user may be performed, for example, by an operation of a menu item on a menu screen displayed upon the display unit 35.

### Generation of the Image Data for Processing Employed in the Detection and Setting Processing

The image capture control unit 34c captures the image data for processing to be employed in the detection and setting processing at similar timing to the timings of generation of the image data for processing to be employed in the image processing described above. In other words, the same image data for processing can be employed as the image data for processing to be employed in the detection and setting processing, and also as the image data for processing to be employed in the image processing. In the following, a case will be explained in which the generation of the image data for processing to be employed in the detection and setting processing is performed at a different timing from the generation of the image data for processing to be employed in the image processing.

When full press actuation of the release button is performed by the user, the image capture control unit 34c causes the image capture unit 32 to perform capture of the image data for processing before performing capture of the main image data. In this case it is possible to reflect, in the main image capture, the result of detection by employing the latest image data for processing that has been captured directly before the main image capture, and/or the result of setting by employing the latest image data for processing that has been captured directly before the main image capture.

The image capture control unit 34c may cause the image data for processing to be captured, even when an operation not related to image capture, for example an operation for reproducing and displaying an image, or an operation during such reproduction and display, or an operation for setting the clock, is being performed. In this case, it will be acceptable for the imaging capture control unit 34c to generate the image data for processing of a single frame, or to generate sets of the image data for processing of a plurality of frames.

It should be understood that although, in the above explanation, cases have been explained by way of example in which the image data for processing was employed in the image processing, in the focus detection processing, in the photographic subject detection processing, and in the processing for setting image capture conditions such as exposure or the like, the present invention is not limited to cases in which the image data for processing is employed in all of these various types of processing. In other words, a case in which the image data for processing is employed in at least one of these processes, such as in the image processing, in the focus detection processing, in the photographic subject detection processing, or in the image capture conditions setting processing, is also to be considered as being included in the scope of this embodiment. It may be arranged to enable the user to select and decide in which of the various types of processes the image data for processing is to be employed, from a menu screen displayed upon the display unit 35.

Furthermore, it would also be acceptable to generate the image data for processing described above on the basis of the output signal from a photometric sensor 38 that is provided separately from the imaging element 32a.

### Explanation of the Flow Chart

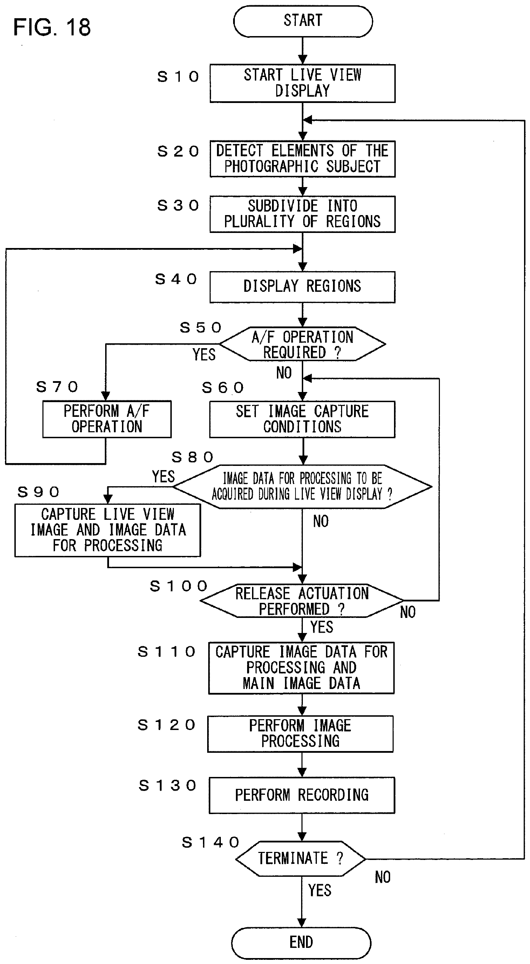

Fig. 18 is a flow chart for explanation of a flow of processing for setting image capture conditions for each of the regions and capturing an image. When a main switch of the camera 1 is turned on, the control unit 34 starts a program that executes the processing shown in Fig. 18. In step S10, the control unit 34 starts live view display upon the display unit 35, and then the flow of control proceeds to step S20.

In concrete terms, the control unit 34 issues a command to the image capture unit 32 for the start of acquisition of a live view image, and live view images that are acquired are repeatedly displayed upon the display unit 35. As described above, at this time point, the same image capture conditions are set for the entire area of the image capture chip 111, in other words for the entire screen.

It should be understood that, if a setting is made for A/F operation to be performed during the live view display, then, by performing focus detection processing, the lens movement control unit 34d of the control unit 34 controls A/F operation so as to adjust the focus to a photographic subject element that corresponds to a predetermined focusing point. According to requirements, the lens movement control unit 34d may perform this focus detection processing after both the first correction processing described above and also the second correction processing described above have been performed, or after either the first correction processing described above or the second correction processing described above has been performed.

Moreover, if a setting is not made for A/F operation to be performed during the live view display, then the lens movement control unit 34d of the control unit 34 performs A/F operation subsequently, at the time point that a command for A/F operation is issued.

In step S20, the object detection unit 34a of the control unit 34 detects the elements of the photographic subject from the live view image, and then the flow of control proceeds to step S30. According to requirements, the object detection control unit 34a may perform this photographic subject detection processing after both the first correction processing described above and also the second correction processing described above have been performed, or after either the first correction processing described above or the second correction processing described above has been performed. Then in step S30 the setting unit 34b of the control unit 34 subdivides the screen of the live view image into regions that include the elements of the photographic subject, and then the flow of control proceeds to step S40.

In step S40, the control unit 34 performs display of these regions upon the display unit 35. As shown by way of example in Fig. 6, the control unit 34 displays as accentuated the region that, among the subdivided regions, is the subject for setting (i.e. for changing) its image capture conditions. Moreover, the control unit 34 displays the setting screen 70 for setting the image capture conditions upon the display unit 35, and then the flow of control proceeds to step S50.

It should be understood that, if the position at which another main photographic subject is displayed upon the display screen is selected by the user tapping upon it with his/her finger, then the control unit 34 changes over to this region including this new main photographic subject so that it becomes the new region which is to be the subject of setting (or of changing) the image capture conditions, and displays this new region as accentuated.

In step S50, the control unit 34 makes a determination as to whether or not A/F operation is required. For example, the control unit 34 reaches an affirmative determination in step S50 and the flow of control proceeds to step S70 if the focus adjustment state has changed due to the photographic subject having moved, or if the position of the point of focusing has been changed by user actuation, or if a command has been issued for A/F operation to be performed. But the control unit 34 reaches a negative determination in step S50 and the flow of control proceeds to step S60 if the focus adjustment state has not changed, and the position of the point of focusing has not been changed by user actuation, and moreover no command has been issued by user actuation for A/F operation to be performed.

In step S70 the control unit 34 performs A/F operation, and then the flow of control returns to step S40. According to requirements, the lens movement control unit 34d may perform the focus detection processing for A/F operation after both the first correction processing described above and also the second correction processing described above have been performed, or after either the first correction processing described above or the second correction processing described above has been performed. And, after the flow of control has returned to step S40, the control unit 34 repeats the processing similar to the processing described above on the basis of the live view image that is acquired after the A/F operation.

In step S60, in response to user actuation, the setting unit 34b of the control unit 34 sets image capture conditions for the region that is being displayed as accentuated, and then the flow of control proceeds to step S80. It should be understood that change of the display upon the display unit 35 corresponding to user actuation in step S60 and setting of the image capture conditions are as described above. According to requirements, the setting unit 34b of the control unit 34 may perform exposure calculation processing after both the first correction processing described above and also the second correction processing described above have been performed, or after either the first correction processing described above or the second correction processing described above has been performed.

In step S80, the control unit 34 makes a decision as to whether or not to acquire the image data for processing during display of the live view image. If a setting is made for performing capture of the image data for processing during display of the live view image, then the control unit 34 reaches an affirmative determination in step S80 and the flow of control proceeds to step S90. But if no such setting is made for performing capture of the image data for processing during display of the live view image, then the control unit 34 reaches a negative determination in step S80 and the flow of control is transferred to step S100, which will be described subsequently.

In step S90, the image capture control unit 34c of the control unit 34 issues a command to the image capture unit 32 for capturing the image data for processing under the respective image capture conditions that have been set at predetermined cycles during capture of the live view image, and then the flow of control proceeds to step S100. It should be understood that the image data for processing captured at this time is stored, for example, by the recording unit 37 upon a storage medium (not shown in the figures). In this manner, it is possible to utilize subsequently this image data for processing that has been recorded. In step S100, the control unit 34 determines whether or not release actuation has been performed. If the release button included in the operation members 36 has been actuated, or if a display icon that commands image capture has been actuated, then the control unit 34 reaches an affirmative determination in step S100 and the flow of control proceeds to step S110. But if no such release actuation has been performed, then a negative determination is reached in step S100 and the flow of control returns to step S60.

In step S110, the control unit 34 performs processing for capturing the image data for processing and the main image data. In other words, as well as capturing the image data for processing under each of the different sets of image capture conditions that were set in step S60, the image capture control unit 34c controls the imaging element 32a to perform main image capture under the image capture conditions that were set in step S60 for each of the regions described above and thereby acquires main image data, and then the flow of control proceeds to step S120. It should be understood that, when capturing the image data for processing to be employed in the detection and setting processing, the capture of the image data for processing is performed before capture of the main image data. Moreover, if capture of the image data for processing is performed in step S90, the image data for processing may not to be captured in step S110.

In step S120, the image control unit 34c of the control unit 34 sends a command to the image processing unit 33 for causing predetermined image processing to be performed upon the main image data that was obtained by the image capture described above by employing the image data for processing that was acquired in step S90 or step S110, and then the flow of control proceeds to step S130. This image processing includes the pixel defect correction processing, the color interpolation processing, the contour enhancement processing, and/or the noise reduction processing described above.

It should be understood that, according to requirements, the correction unit 33b of the image processing unit 33 may perform image processing upon a main image data item that is positioned at the boundary portion between the regions, either after performing both the first correction processing described above and also the second correction processing described above, or after performing only one of the first correction processing described above and the second correction processing described above.

In step S130, the control unit 34 sends a command to the recording unit 37 in order to record the image data after image processing upon a recording medium not shown in the figures, and then the flow of control proceeds to step S140.

In step S140, the control unit 34 decides whether or not actuation has been performed for termination. If termination actuation has been performed, then the control unit 34 reaches an affirmative determination in step S140 and the processing of Fig. 18 is terminated. But if termination actuation has not been performed, then the control unit 34 reaches a negative determination in step S140 and the flow of control returns to step S20. After having returned to step S20, the processing described above is repeated.

It should be understood that, in the example described above, the main image capture is performed under the image capture conditions set in step S60, and processing is performed upon the main image data by employing the image data for processing acquired in step S90 or step S110. However, if different image capture conditions are set for each of the regions when capturing the live view image, it will also be acceptable to perform the focus detection processing, the photographic subject detection processing, and the image capture conditions setting processing on the basis of the image data for processing obtained during display of the live view image in step S90.

In the explanation given above the laminated type or stacked imaging element 100 was described as an example, but the imaging element (i.e. the image capture chip 111) is not necessarily to be configured of the laminated type, provided that it is of a type for which different image capture conditions can be set for each of a plurality of blocks.

According to the first embodiment as explained above, the following advantageous operational effects are obtained.
(1) If an inappropriate main image data item originating in the first image capture conditions set for the first region 61 has been generated in the main image data captured in the first region 61, then it is possible to generate main image data in an appropriate manner by employing the image data for processing captured under the fourth image capture conditions, which are different from the image capture conditions for the first region 61. In concrete terms, it is possible to generate main image data in which discontinuity of the image or a sense of strangeness originating in discrepancy of the brightness, the contrast, the hue or the like of the image between the hatched portions of the block 82, the block 85, and the block 87 of Fig. 7(b) and the stippled portions of the blocks 83, 86, 88, and 89 are suppressed.
(2) If an inappropriate main image data item originating in the first image capture conditions set for the first region 61 has been generated in the main image data captured in the first region 61, then it is possible to generate main image data in an appropriate manner by employing the image data for processing captured under the fourth image capture conditions, which are different from the image capture conditions for the first region 61. In concrete terms, it is possible to generate main image data in which discontinuity of the image or a sense of strangeness originating in discrepancy of the brightness, the contrast, the hue or the like of the image between the hatched portions of the block 82, the block 85, and the block 87 of Fig. 7(b) and the stippled portions of the blocks 83, 86, 88, and 89 are suppressed.
(3) If an inappropriate main image data item originating in the first image capture conditions set for the first region 61 has been generated in the main image data captured in the first region 61, then it is possible to generate main image data in an appropriate manner by employing the image data for processing, which is different from the main image data.
(4) It is possible to generate main image data in an appropriate manner by employing the image data for processing of the block for attention in the image for processing at the position corresponding to the block for attention of the main image.
(5) By acquiring the image data for processing after main image capture, it is possible to acquire the main image data without any risk of missing a shutter opportunity. And it is possible to generate main image data in an appropriate manner according to this image data for processing that has been acquired after main image capture.
(6) By employing the photometric sensor 83 that is different from the image capture unit 32, it is possible to acquire the image data for processing with the photometric sensor 38 while acquiring the main image data with the image capture unit 32.
(7) By storing the image data for processing, it is possible to utilize this image data for processing that has been acquired before capture of the main image data for generation of the main image data that is acquired subsequently.
(8) Since image data for the photographic subject captured in the first region 61 is generated on the basis of the image data for the photographic subject captured in the fourth region 64 whose area is greater than the area of the first region 61, accordingly it is possible to generate the image data in an appropriate manner.
(9) In replacing the image data that has been acquired for the block for attention of the main image by employing image data that has been acquired for a block that is a part of the image for processing (the block for attention or a reference block), it is possible to keep down the burden of calculation of the replacement processing by replacing a plurality of image data items corresponding to a plurality of pixels included in the block for attention of the main image, for example, by employing the same number of image data items or fewer.
(10) In replacement of the image data acquired for the block for attention of the main image by employing image data of the image for processing, the replacement is performed by employing an image data item from a pixel that is closer to the pixel that is the subject of replacement included in the block for attention. In this manner, it is possible to generate the image data in an appropriate manner.
(11) It is possible to perform processing in an appropriate manner for each of the regions for which the image capture conditions are different. In other words, it is possible to generate images in an appropriate manner according to the image data that is generated in each of the regions.
(12) The signal processing chip 112 is disposed between the image capture chip 111 and the memory chip 113. Accordingly, since the chips are laminated together in a sequence that corresponds to the flow of data in the imaging element 100, it is possible to connect the chips together electrically in an efficient manner.
(13) If an inappropriate signal data item originating in the first image capture conditions set for the first region 61 has been generated in the signal data for the image captured in the first region 61 of the main image, then it is possible to adjust the focus in an appropriate manner by employing the signal data for the image for processing that has been captured under the fourth image capture conditions, which are different from the image capture conditions for the first region 61. In concrete terms, it is possible to generate signal data for the main image in which discontinuity of the image due to discrepancy or the like of the brightness, the contrast, or the like of the image between the hatched portions of the block 82, the block 85, and the block 87 of Fig. 7(b) and the stippled portions of the blocks 83, 86, 88, and 89 is suppressed. As a result it becomes possible to perform appropriate focus adjustment, since degradation of the accuracy of focus detection due to difference between the image capture conditions for the various blocks can be suppressed.
(14) If an inappropriate signal data item originating in the first image capture conditions set for the first region 61 has been generated in the signal data for the image captured in the first region 61 of the main image, it is possible to generate the signal data of the main image in an appropriate manner by employing the signal data for the image for processing, which has been captured under the fourth image capture conditions which are different from the image capture conditions for the first region 61. In concrete terms, it is possible to generate signal data for the main image in which discontinuity of the image due to discrepancy or the like of the brightness, the contrast, or the like of the image between the hatched portions of the block 82, the block 85, and the block 87 of Fig. 7(b) and the stippled portions of the blocks 83, 86, 88, and 89 is suppressed. As a result it becomes possible to perform appropriate focus adjustment, since it is possible to suppress degradation of the accuracy of focus detection due to difference between the image capture conditions for the various blocks.
(15) If an inappropriate signal data item originating in the first image capture conditions set for the first region 61 has been generated in the signal data for the image captured in the first region 61 of the main image, then it is possible to perform focus adjustment in an appropriate manner by employing the signal data of the image for processing captured at a different timing from that of the main image.
(16) If an inappropriate signal data item originating in the first image capture conditions set for the first region 61 has been generated in the signal data for the image captured in the first region 61 of the main image, then it is possible to generate signal data for the main image in an appropriate manner by employing the signal data of the image for processing, which has been captured at a timing that is different from that of the main image. As a result it becomes possible to perform focus adjustment in an appropriate manner, since it is possible to suppress degradation of the accuracy of focus detection due to the difference in image capture conditions between the various blocks.
(17) By acquiring the signal data for the image for processing before main image capture, it becomes possible to perform focus adjustment in an appropriate manner by referring to the signal data for the image for processing when performing capture of the main image data.
(18) By employing the photometric sensor 38 which is different from the image capture unit 32, it is possible to perform focus adjustment in an appropriate manner, since it is possible to acquire the image for processing with the photometric sensor 38 while acquiring the main image data with the image capture unit 32.
(19) By storing signal data of the image for processing, it is possible to employ the signal data of the image for processing which has been acquired before capture of the main image data for focus adjustment during when capturing the main image data.
(20) It is possible to generate signal data in an appropriate manner on the basis of the signal data for an image captured in the fourth region 64 whose area is larger than the area of the first region 61. Accordingly, it becomes possible to perform focus adjustment in an appropriate manner.
(21) In generation of appropriate signal data, by replacing a plurality of signal data items of an image corresponding to a plurality of pixels included in, for example, the block for attention by employing the same number of signal data items of an image or fewer, it is possible to keep down the burden of calculation imposed by the replacement processing.
(22) If an inappropriate main image data item originating in the first image capture conditions set for the first region 61 has been generated in the main image data captured in the first region 61, then it is possible to generate main image data in an appropriate manner by employing the image data for processing, which has been captured under image capture conditions that are different from the image capture conditions of the first region 61. In concrete terms, it is possible to generate main image data in which discontinuity of the image due to discrepancy of the brightness, the contrast, the hue, or the like of the image between the hatched portions of the block 82, the block 85, and the block 87 of Fig. 7(b) and the stippled portions of the blocks 83, 86, 88, and 89 is suppressed. As a result, it is possible to suppress degradation of the accuracy of detection of the elements of the photographic subject due to difference between the image capture conditions for the various blocks.
(23) By acquiring the image data for processing before main image capture, it is possible, during capture of the main image data, to suppress degradation of the accuracy of detection of elements of the photographic subject by referring to the image data for processing.
(24) By acquiring the image data for processing after main image capture, it is possible to acquire the main image data without missing a shutter opportunity. Moreover, it is possible to detect the elements of the photographic subject in an appropriate manner according to the image data for processing that is acquired after main image capture.
(25) By employing the photometric sensor 38 which is different from the image capture unit 32, it is possible to detect the elements of the photographic subject in an appropriate manner, since it is possible to acquire the image for processing with the photometric sensor 38 while acquiring the main image data with the image capture unit 32.
(26) By referring to the signal data of the image for processing that has been obtained from the photometric sensor 38 that is different from the image capture unit 32, it is possible to suppress degradation of the accuracy of detection of the elements of the photographic subject.
(27) By storing the image data for processing, it is possible to employ this image data for processing that has been acquired before capture of the main image data for detection of elements of the photographic subject during capture of the main image data.
(28) If an inappropriate main image data item has been generated in a part (i.e. in a block) of the main image data captured in the first region 61, then it is possible to generate main image data in an appropriate manner by employing the image data for processing captured in the first region 61 or in the fourth region 64. As a result, it is possible to suppress degradation of the accuracy of detection of the elements of the photographic subject due to difference between the image capture conditions for the various blocks.
(29) It is possible to generate main image data in an appropriate manner on the basis of the image data for processing that has been captured in the fourth region 64, whose area is larger than the area of the first region 61. As a result, it is possible to suppress degradation of the accuracy of detection of the elements of the photographic subject due to difference between the image capture conditions for the various blocks.
(30) In replacement of the image data acquired for the block for attention of the main image by employing image data acquired for a block (i.e. the block for attention or a reference block) that is a part of the image for processing, it is possible to keep down the burden imposed by calculation of the replacement processing by replacing a plurality of items of image data corresponding to a plurality of pixels included in, for example, the block for attention of the main image by employing the same number of image data items or fewer.
(31) If an inappropriate main image data item has been generated in a part (i.e. in a block) of the main image data captured in the first region 61, then it is possible to generate main image data in an appropriate manner by employing a part (i.e. a block) of the image data for processing captured in the first region 61 or in the fourth region 64. As a result, it is possible to suppress degradation of the accuracy of detection of the elements of the photographic subject due to difference between the image capture conditions for the various blocks.
(32) If an inappropriate signal data item originating in the first image capture conditions set for the first region 61 has been generated in the main image data captured in the first region 61, then it is possible to generate main image data in an appropriate manner by employing the image data for processing, which has been captured under image capture conditions that are different from the image capture conditions of the first region 61. In concrete terms, it is possible to generate main image data in which discontinuity of the image due to discrepancy of the brightness, the contrast, the hue, or the like of the image between the hatched portions of the block 82, the block 85, and the block 87 of Fig. 7(b) and the stippled portions of the blocks 83, 86, 88, and 89 is suppressed. As a result, it is possible to suppress degradation of the accuracy of setting of the exposure conditions due to difference between the image capture conditions for the various blocks.
(33) By acquiring the image data for processing before main image capture, it is possible to suppress degradation of the accuracy of setting of the exposure conditions by referring to the image data for processing during capture of the main image data.
(34) By employing the photometric sensor 38 that is different from the image capture unit 32, it is possible to set the exposure conditions in an appropriate manner, since it is possible to acquire the image for processing with the photometric sensor 38 while acquiring the main image data with the image capture unit 32.
(35) By storing the image data for processing, it is possible to employ the image data for processing that has been acquired before capture of the main image data for setting the exposure conditions when capturing the main image data.

It would also be acceptable to change over between a mode 1 in which the second processing described above is performed as pre processing, and a mode 2 in which no second correction processing as pre processing is performed. When the mode 1 is selected, the control unit 34 performs the processing for image processing and so on after having performed the pre processing described above. On the other hand, when the mode 2 is selected, the control unit 34 performs the processing for image processing and so on without performing the pre processing described above. For example, a case is assumed in which there is a shadow upon a part of a face that is detected as a photographic subject element and an image is generated by image capture under settings in which the image capture conditions for a region including the part of the face that is in shadow and the image capture conditions for a region including a portion of the face that is not in shadow are different from one another so that the brightness of the shadowed portion of the face is of the same order as the brightness of the other portions which are not shadowed. If color interpolation processing is performed upon such an image after having performed the second correction processing thereupon, then, depending upon the difference in the image capture conditions that have been set, unintended color interpolation may be performed upon the portion that is in shadow. It is possible to avoid unintended color interpolation by making it possible to change over between the mode 1 and the mode 2 and to perform color interpolation processing by employing the image data just as it is, without performing the second correction processing.

### Variants of First Embodiment

The following modifications also come within the range of the present invention, and one or a plurality of the following variants could also be combined with the embodiment described above.

### Variant 1

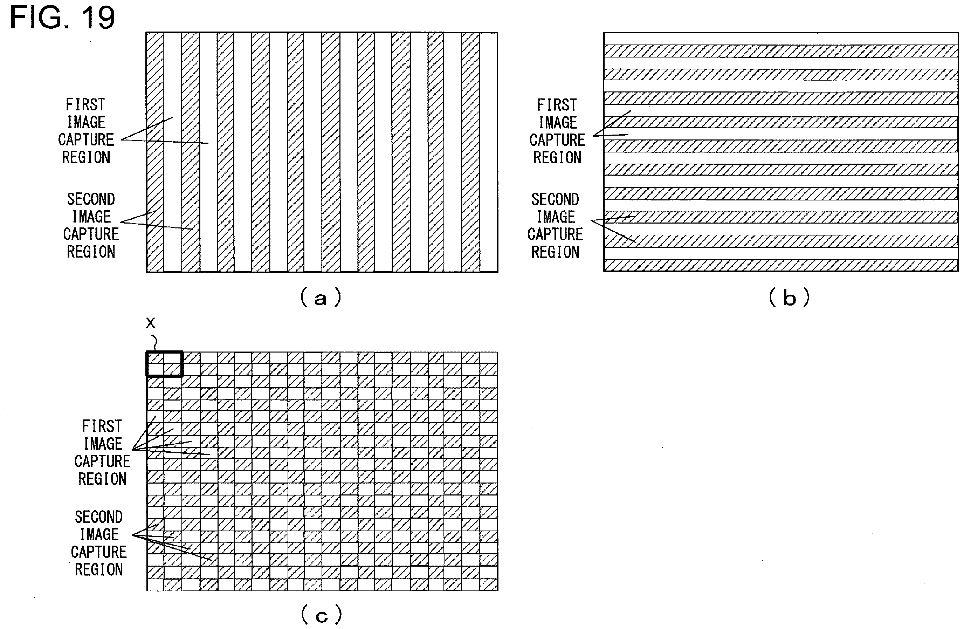

Fig. 19(a) through Fig. 19(c) are figures showing various examples of arrangement of a first image capture region and a second image capture region upon the imaging surface of the imaging element 32a. According to the example of Fig. 19(a), the first image capture region consists of the even numbered columns, and the second image capture region consists of the odd numbered columns. In other words, the imaging surface is subdivided into the even numbered columns and the odd numbered columns.

According to the example of Fig. 19(b), the first image capture region consists of the even numbered rows, and the second image capture region consists of the odd numbered rows. In other words, the imaging surface is subdivided into the even numbered rows and the odd numbered rows.

According to the example of Fig. 19(c), the first image capture region includes the blocks in the even numbered rows in the odd numbered columns and the blocks in the odd numbered rows in the even numbered columns. Moreover, the second image capture region includes the blocks in the odd numbered rows in the odd numbered columns and the blocks in the even numbered rows in the even numbered columns. In other words, the imaging surface is subdivided into a checkerboard pattern.

In any of the cases of Fig. 19(a) through Fig. 19(c), both a first image based upon photoelectrically converted signals read out from the first image capture region and a second image based upon photoelectrically converted signals read out from the second image capture region are generated according to the photoelectrically converted signals read out from the imaging element 32a that has performed image capture of one frame. According to Variant 1, the first image and the second image are captured at the same angle of view, and thus include images of the common photographic subject.

In Variant 1, the control unit 34 employs the first image for display and employs the second image as image data for processing. In concrete terms, the control unit 34 causes the display unit 35 to display the first image as a live view image. Moreover, the control unit 34 employs the second image as the image data for processing. In other words, the image processing is performed by the processing unit 33b by employing the second image, the photographic subject detection processing is performed by the object detection unit 34a by employing the second image, the focus detection processing is performed by the lens movement control unit 34d by employing the second image, and the exposure calculation processing is performed by the setting unit 34b by employing the second image.

It should be understood that it would also be acceptable to change the region for acquisition of the first image and the region for acquisition of the second image, frame to frame. For example, in the N-th frame, the first image from the first image capture region may be captured as the live view image, and the second image from the second image capture region may be captured as the image data for processing; whereas, in the (N+1)-th frame, the first image may be captured as the image data for processing, while the second image is captured as the live view image; and this operation may be further repeated in subsequent frames.
1. As one example, the control unit 34 may capture the live view image under first image capture conditions, and these first image capture conditions are set to conditions that are suitable for display by the display unit 35. The first image capture conditions are the same over the entire imaging screen. On the other hand, the control unit 34 captures the image data for processing under the second image capture conditions, and these second image capture conditions are set to conditions that are suitable for the focus detection processing, for the photographic subject detection processing, and for the exposure calculation processing. The second image capture conditions are also set to be the same over the entire imaging screen.
   It should be understood that, if the conditions that are suitable for the focus detection processing, for the photographic subject detection processing, and for the exposure calculation processing are different from each other, then it will be acceptable for the control unit 34 to differentiate the second image capture conditions that are set for the second image capture region for each frame. For example, the second image capture conditions for the first frame may be set to conditions that are suitable for the focus detection processing, the second image capture conditions for the second frame may be set to conditions that are suitable for the photographic subject detection processing, and the second image capture conditions for the third frame may be set to conditions that are suitable for the exposure calculation processing. In these cases, in each frame, the same second image capture conditions are set over the entire imaging screen.
2. As another example, it would also be acceptable for the control unit 34 to vary the first image capture conditions over the imaging screen. The setting unit 34b of the control unit 34 sets different first image capture conditions for each of the regions including an element of the photographic subject that have been subdivided by the setting unit 34b. On the other hand, the control unit 34 sets the second image capture conditions to be the same over the entire imaging screen. While the control unit 34 sets the second image capture conditions to be suitable for the focus detection processing, for the photographic subject detection processing, and for the exposure calculation processing, if the conditions that are suitable for the focus detection processing, for the photographic subject detection processing, and for the exposure calculation processing are different from one another, then different image capture conditions may be set for the second image capture region in each frame.
3. Moreover, as another example, it would also be acceptable for the control unit 34 to make the first image capture conditions be the same over the entire imaging screen, while varying the second image capture conditions over the imaging screen. For example, the setting unit 34b may set the second image capture conditions to be different for each of the regions including an element of the photographic subject that have been subdivided by the setting unit 34b. In this case as well, if the conditions that are suitable for the focus detection processing, for the photographic subject detection processing, and for the exposure calculation processing are different from one another, then it would also be acceptable for the image capture conditions that are set for the second image capture region to be different for each frame.
4. Even further, as yet another example, the control unit 34 may make the first image capture conditions to be different over the imaging screen, and may also make the second image capture conditions to be different over the imaging screen. For example, the setting unit 34b sets different first image capture conditions for each of the regions including an element of the photographic subject that have been subdivided by the setting unit 34b and also sets different second image capture conditions for each of the regions including an element of the photographic subject that have been subdivided by the setting unit 34b.

In Figs. 19(a) through 19(c), it would also be acceptable to make a ratio between the area of the first image capture region and the area of the second image capture region be different. For example, on the basis of user actuation or on the basis of determination by the control unit 34, the control unit 34 may set the ratio of the first image capture region to the second image capture region to be high, or may set the ratio of the first image capture region and the second image capture region to be equal as shown in the examples of Fig. 19(a) through Fig. 19(c), or may set the ratio of the first image capture region to the second image capture region to be low. By changing the ratio between the area of the first image capture region and the area of the second image capture region, it is possible to make the first image be higher in definition as compared with the second image, or to make the resolutions of the first image and the second image to be equal, or to make the second image be higher in definition as compared with the first image.

For example, in the region X surrounded by the thick line in Fig. 19(c), the image signals from the blocks in the second image capture region are added together and averaged so as to increase the resolution of the first image to be higher than that of the second image. In this manner, it is possible to obtain image data equivalent to a case in which the image capture region for processing is enlarged or reduced according to change of the image capture conditions.

### Variant 2

In the embodiment described above, if the image capture conditions that are applied at the position for attention (i.e. the first image capture conditions) and the image capture conditions that are applied at the reference positions around the position for attention (i.e. the fourth image capture conditions) are different, then, in the second correction processing, when performing image processing, the correction unit 33b of the image processing unit 33 corrects the main image data under the fourth image conditions (i.e. an image data item under the fourth image capture conditions among the image data for the reference positions,) on the basis of the first image capture conditions. In other words, it is arranged to alleviate discontinuity in the image due to the disparity between the first image capture conditions and the fourth image capture conditions by performing the second correction processing upon the main image data for which the fourth image capture conditions are applied in the reference positions.

Instead of the above, in Variant 2, it will also be acceptable for the correction unit 33b of the image processing unit 33 to correct the main image data under the first image conditions (i.e. a main image data item under the first image capture conditions among the main image data at the position for attention and the main image data at the reference positions) on the basis of the fourth image capture conditions. In this case as well, it is possible to alleviate discontinuity in the image caused by the disparity between the first image capture conditions and the fourth image capture conditions.

Alternatively, it would also be acceptable for the correction unit 33b of the image processing unit 33 to correct both the main image data item under the first image capture conditions and also the main image data item under the fourth image capture conditions. In other words, it would be acceptable to perform the second correction processing upon the main image data item at the position for attention under the first image capture conditions, the main image data item under the first image capture conditions among the main image data at the reference positions, and the main image data item under the fourth image capture conditions among the main image data at the reference positions so as to alleviate discontinuity in the image due to the disparity between the first image capture conditions and the fourth image capture conditions.

In Example 1 described above, for instance, as the second correction processing, the main image data item of a reference pixel Pr for which the first image capture conditions (i.e., ISO sensitivity being 100) is applied is multiplied by 400/100, and, as the second correction processing, the main image data item of a reference pixel Pr for which the image capture conditions (i.e., ISO sensitivity being 800) is applied is multiplied by 400/800. By doing this, the disparity between the main image data items due to discrepancy in the image capture conditions is reduced. It should be understood that the main pixel data item of the pixel for attention is subjected to the second correction processing for multiplying it by 100/400 after the color interpolation processing. Because of this second correction processing, it is possible to change the main pixel data item of the pixel for attention after the color interpolation processing to a similar value as when performing image capture under the first image capture conditions. Furthermore, in Example 1 described above, it would also be acceptable to vary the degree of the second correction processing according to the distance from the boundary between the first region and the fourth region. And it is also possible to reduce the proportion by which the main image data items increases or decreases due to the second correction processing, as compared with Example 1 above, and it is possible to reduce the noise created by the second correction processing. Although the above explanation has been applied to Example 1 described above, it can also be applied in a similar manner to Example 2 described above.

According to this Variant 2, in a similar manner to the case with the embodiments described above, it is possible to perform image processing in an appropriate manner upon the main image data items that have been generated for respective regions whose image capture conditions are different.

### Variant 3

In the embodiment described above, when performing the second correction processing upon the main image data, it is arranged to obtain the corrected main image data by performing calculation on the basis of the difference between the first image capture conditions and the fourth image capture conditions. Instead of employing calculation, it would also be acceptable to obtain the corrected main image data by referring to a table for correction. For example, the corrected main image data may be read out by inputting the first image capture conditions and the fourth image capture conditions as arguments. Alternatively, it would also be acceptable to read out a correction coefficient by inputting the first image capture conditions and the fourth image capture conditions as arguments.

### Variant 4

It would also be acceptable, in the second correction processing of the embodiment described above, to determine an upper limit value and/or a lower limit value for the corrected main image data. By setting an upper limit value and/or a lower limit value, it is possible to impose limitation so that correction beyond the required level is not performed. The upper limit value and/or the lower limit value may be determined in advance; or, if a photometric sensor is provided separately from the imaging element 32a, it will be acceptable to determine these limit values on the basis of the output signal from that photometric sensor.

### Variant 5

In the embodiment described above, an example was explained in which the setting unit 34b of the control unit 34 detected the elements of the photographic subject on the basis of the live view image, and subdivided the live view image screen into regions each including an element of the photographic subject. However, if a photometric sensor is provided separately from the imaging element 32a, then, in Variant 5, it would also be acceptable for the control unit 34 to subdivide into the regions on the basis of the output signal from that photometric sensor.

The control unit 34 performs subdivision into a foreground and a background on the basis of the output signal from the photometric sensor. In concrete terms, the live view image acquired by the imaging element 32b is subdivided into a foreground region corresponding to a region that has been determined from the output signal of the photometric sensor to be the foreground, and a background region corresponding to a region that has been determined from the output signal of the photometric sensor to be the background.

Furthermore, as illustrated in Fig. 19(a) through Fig. 19(c), the control unit 34 arranges a first image capture region and a second image capture region in positions corresponding to the foreground region of the imaging surface of the imaging element 32a. On the other hand, the control unit 34 only arranges a first image capture region upon the imaging surface of the imaging element 32a in a position corresponding to the background region of the imaging surface of the imaging element 32a. The control unit 34 employs the first image for display, and employs the second image as the image data for processing.

According to Variant 5, the live view image acquired by the imaging element 32b can be subdivided into regions by employing the output signal from the photometric sensor. Moreover, it is possible to obtain the first image for display and the second image as image data for processing for the foreground region, while obtaining only the first image for display for the background region. Even if the image capture environment of the photographic subject has changed during display of the live view image, still it is possible to re-set the foreground region and the background region by performing subdivision into regions by employing the output from the photometric sensor.

### Variant 6

In Variant 6, as one example of the second correction processing, the generation unit 33c of the image processing unit 33 performs contrast adjustment processing. In other words, the generation unit 33c alleviates discontinuity in the image due to the disparity between the first image capture conditions and the fourth image capture conditions by varying the gradation curve (i.e. the gamma curve).

For example, suppose that the first image capture conditions and the fourth image capture conditions only differ by ISO sensitivity, with the ISO sensitivity of the first image capture conditions being 100 while the ISO sensitivity of the fourth image capture conditions is 800. Among the main image data for the reference positions, the generation unit 33c compresses to one eighth the value of the main image data item captured under the fourth image conditions by flattening the gradation curve.

Alternatively, it would also be acceptable for the generation unit 33c to magnify by eight times the value of the main image data item of the position for attention and the main image data item under the first image conditions among the main image data for the reference positions by raising the gradation curve.

According to this Variant 6, in a similar manner to the case with the embodiments described above, it is possible to perform image processing in an appropriate manner upon the main image data items generated in respective regions for which the image capture conditions are different. For example, it is possible to suppress discontinuity or sense of strangeness appearing in the image after image processing due to difference in the image capture conditions at a boundary between regions.

### Variant 7

In Variant 7, it is arranged for the image processing unit 33 not to lose the contours of the elements of the photographic subject in the image processing described above (for example, in the noise reduction processing). Generally, smoothing filter processing is employed when performing noise reduction. When a smoothing filter is employed, although there is a beneficial effect for reduction of noise, a boundary of an element of the photographic subject may become blurred.

Therefore, for example, the generation unit 33c of the image processing unit 33 compensates for blurring of the boundary between elements of the photographic subject described above by performing contrast adjustment processing in addition to the noise reduction processing, or along with the noise reduction processing. In Variant 7, the generation unit 33c of the image processing unit 33 sets a curve like a letter-S shape as the density conversion curve (the gradation conversion curve) (this is so-called letter-S conversion). By performing contrast adjustment by employing the letter-S conversion, the generation unit 33c of the image processing unit 33 extends the gradation portions of each of the bright main image data and the dark main image data to increase the gradation levels of the bright main image data (and of the dark data), and compresses the main image data having intermediate gradations to reduce its gradation levels. In this manner, the number of main image data items whose image brightness is medium decreases and the number of main image data items that are classified as either bright or dark increases, and as a result, it is possible to compensate for blurring at the boundary between elements of the photographic subject.

According to this Variant 7, it is possible to compensate for blurring of a boundary of elements of the photographic subject by sharpening the contrast of the image.

### Variant 8

In Variant 8, the generation unit 33c of the image processing unit 33 changes the white balance adjustment gain in order to reduce discontinuity of the image due to disparity between the first image capture conditions and the fourth image capture conditions.

For example, in a case in which the image capture conditions that are applied during image capture at the position for attention (taken as being the first image capture conditions) and the image capture conditions that are applied during image capture at reference positions around the position for attention (taken as being the fourth image capture conditions) are different, the generation unit 33c of the image processing unit 33 changes the white balance adjustment gain so as to bring the white balance of a main image data item under the fourth image capture conditions among the main image data at the reference positions closer to the white balance of a main image data item that was acquired under the first image capture conditions.

It should be understood that it would also be acceptable for the generation unit 33c of the image processing unit 33 to change the white balance adjustment gain so as to bring the white balance of a main image data item under the first image capture conditions among the main image data at the reference positions and the white balance of a main image data item at the position for attention closer to the white balance of a main image data item that was acquired under the fourth image capture conditions.

According to Variant 8, for the main image data items generated for the regions with different image capture conditions the white balance adjustment gain is adjusted to the adjustment gain of any one of the regions for which the image capture conditions are different, thereby alleviating discontinuity in the image caused by the disparity between the first image capture conditions and the fourth image capture conditions.

### Variant 9

It would also be acceptable to provide a plurality of image processing units 33 so as to perform image processing in parallel. For example, while performing image processing upon the main image data captured in a region A of the image capture unit 32, image processing may be performed upon the main image data captured in a region B of the image capture unit 32. It would be possible for the plurality of image processing units 33 to perform the same type of image processing, or alternatively for them to perform different types of image processing. In other words, it would be possible to perform similar image processing upon the main image data for the region A and for the region B by applying the same parameters and so on; or, alternatively, it would also be possible to perform different image processing upon the main image data for the region A and for the region B by applying different parameters and so on.

If a plurality of the image processing units 33 are provided, one of the image processing units may perform the image processing upon the main image data for which the first image capture conditions have been applied, while another image processing unit may perform the image processing upon the main image data for which the fourth image capture conditions have been applied. The number of image processing units is not to be considered as being limited to two as in the example discussed above; for example, it would be acceptable to provide the same number of image processing units as the number of image capture conditions that can be set. In other words, a single dedicated image processing unit will be assigned to perform image processing for one of the regions to which different image capture conditions have been applied. According to this Variant 9, it is possible to perform in parallel, both image capture according to different image capture conditions for each of the regions, and also image processing of the main image data of images obtained for each of the above described regions.

### Variant 10

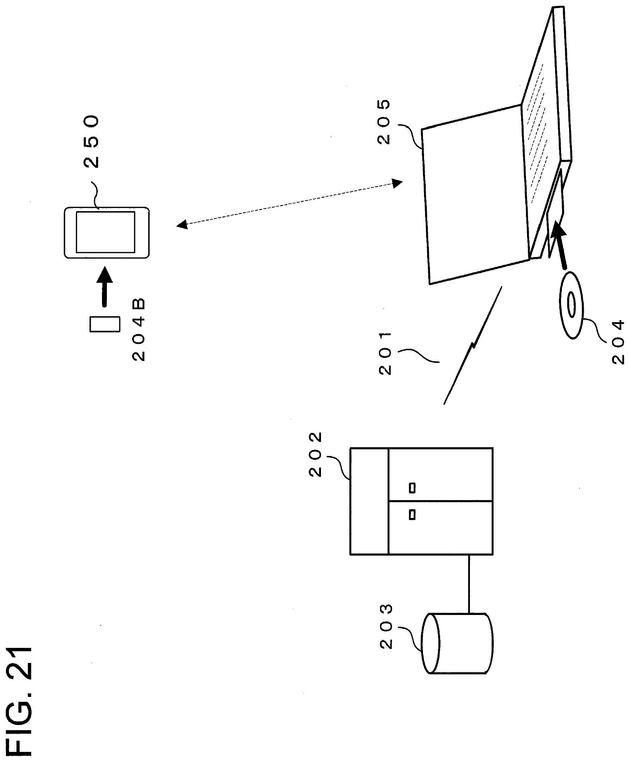

While in the above the camera 1 has been explained by way of example, it would also be acceptable to apply the present invention to a high function portable telephone device 250 (refer to Fig. 21) such as a smartphone, or to a mobile device such as a tablet terminal or the like.

### Variant 11

In the embodiments described above, various examples were explained with reference to the camera 1 in which the image capture unit 32 and the control unit 34 were built as a single electronic apparatus. Instead of that, it would also be acceptable to arrange, for example, to provide the image capture unit 32 and the control unit 34 separately, and to build an image capturing system 1B so that the image capture unit 32 is controlled via communication from the control unit 34.

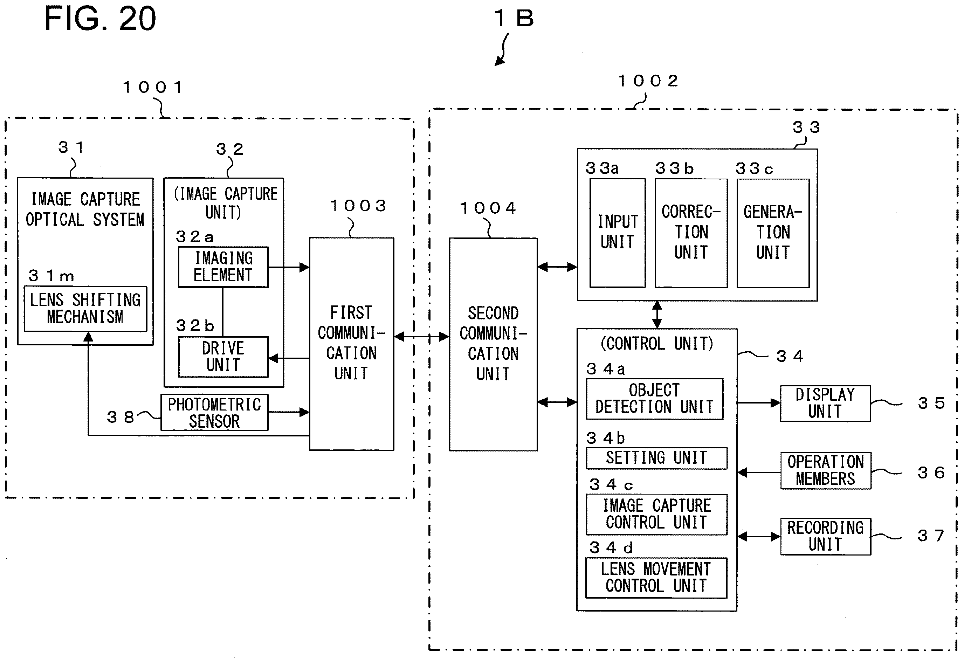

In the following, an example will be explained with reference to Fig. 20 in which an imaging device 1001 to which the image capture unit 32 is provided is controlled from a display device 1002 to which the control unit 34 is provided.

Fig. 20 is a block diagram showing an example of the structure of an image capturing system 1B according to Variant 11. In Fig. 20, the image capturing system 1B includes an imaging device 1001 and a display device 1002. In addition to comprising the image capture optical system 31 and the image capture unit 32 as explained in connection with the embodiments described above, the imaging device 1001 also comprises a first communication unit 1003. Moreover, in addition to comprising the image processing unit 33, the control unit 34, the display unit 35, the operation members 36, and the recording unit 37 as explained in connection with the embodiments described above, the display device 1002 also comprises a second communication unit 1004.

The first communication unit 1003 and the second communication unit 1004 may, for example, perform bidirectional image data communication according to a per se known wireless communication technique or according to a per se known optical communication technique.

It should be understood that it would also be acceptable for the imaging device 1001 and the display device 1002 to be connected together via a cable, and for the first communication unit 1003 and the second communication unit 1004 to be adapted to perform bidirectional image data communication with this cable.

The image capturing system 1B performs control of the image capture unit 32 by the control unit 34 performing data communication therewith via the second communication unit 1004 and the first communication unit 1003. For example, by predetermined control data being transmitted and received between the imaging device 1001 and the display device 1002, the display device 1002 may be enabled to subdivide the screen into a plurality of regions on the basis of an image, to set different image capture conditions for each of the subdivided regions, and to read out photoelectrically converted signals that have been photoelectrically converted in each of the regions as described above.

Since, according to this Variant 11, a live view image that is acquired by the imaging device 1001 and that is transmitted to the display device 1002 is displayed upon the display unit 35 of the display device 1002, accordingly the user is able to perform remote actuation at the display device 1002 while it is located at a position remote from the imaging device 1001.

The display device 1002 may, for example, be implemented by a high function portable telephone device 250 such as a smartphone. Moreover, the imaging device 1001 may be implemented by an electronic apparatus that incorporates the laminated type imaging element 100 such as described above.

It should be understood that, although an example has been explained in which the object detection unit 34a, the setting unit 34b, the image capture control unit 34c, and the lens movement control unit 34d are provided to the control unit 34 of the display device 1002, it would also be acceptable to arrange for portions of the object detection unit 34a, the setting unit 34b, the image capture control unit 34c, and the lens movement control unit 34d to be provided to the imaging device 1001.

### Variant 12

Supply of the program to a mobile device such as the camera 1, the high function mobile telephone device 250, or the tablet terminal described above may, as shown by way of example in Fig. 21, be performed by transmission to the mobile device from a personal computer 205 upon which the program is stored by infra-red radiation transmission, or by short distance wireless communication.

Supply of the program to the personal computer 205 may be performed by loading a recording medium 204 such as a CD ROM or the like upon which the program is stored into the personal computer 205, or the program may be loaded onto the personal computer 205 by the method of transmission via a communication line 201 such as a network or the like. In the case of transmission via the communication line 201, the program may be stored in, for instance, a storage device 203 of a server 202 that is connected to that communication line.

Moreover, it would also be possible for the program to be directly transmitted to the mobile device via an access point of a wireless LAN (not shown in the figures) that is connected to the communication line 201. Furthermore, it would also be acceptable to arrange for a recording medium 204B such as a memory card or the like upon which the program is stored to be loaded into the mobile device. In this manner, the program may be supplied as a computer program product in various formats, such as via a recording medium or via a communication line or the like.

### Second Embodiment

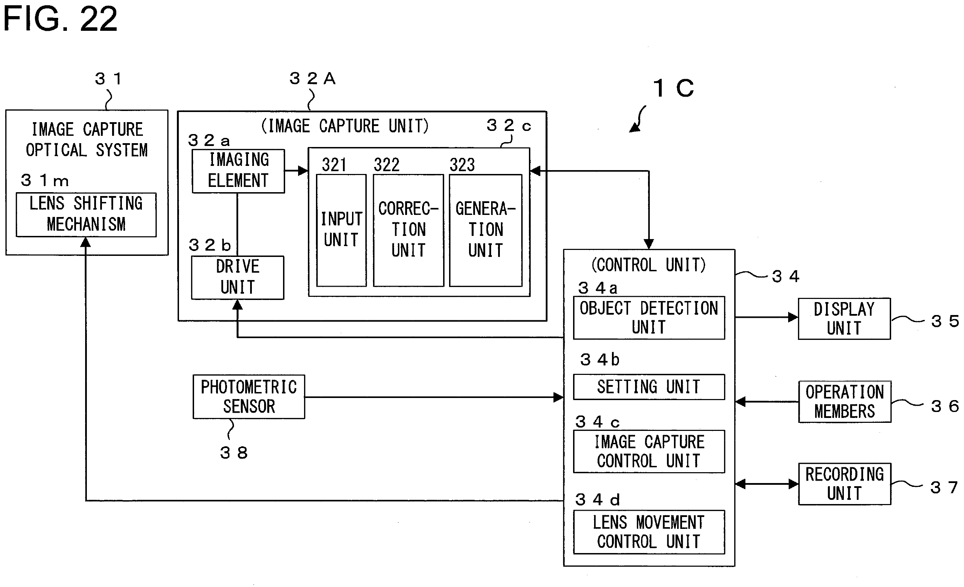

Referring to Figs. 22 through 28, a digital camera will now be explained as one example of an electronic device that is equipped with an image processing device according to a second embodiment of the present invention. The same reference symbols will be appended to structural elements that are the same as ones in the first embodiment, and the explanation will principally focus upon the features of difference. Points that are not particularly explained are the same as in the first embodiment. In this embodiment, the principal difference from the first embodiment is the feature that, instead of the provision of the image processing unit 33 of the first embodiment, an image capture unit 32A further includes an image processing unit 32c that has a similar function to that of the image processing unit 33 of the first embodiment.

Fig. 22 is a block diagram showing an example of the structure of a camera 1C according to the second embodiment. In Fig. 22, the camera 1C comprises an image capture optical system 31, an image capture unit 32A, a control unit 34, a display unit 35, operation members 36, and a recording unit 37. And the image capture unit 32A further comprises an image processing unit 32c that has a function similar to that of the image processing unit 33 of the first embodiment.

The image processing unit 32c includes an input unit 321, correction units 322, and a generation unit 323. Image data from the imaging element 32a is inputted to the input unit 321. The correction units 322 perform pre processing for performing correction upon the input data inputted as described above. This pre processing performed by the correction units 322 is the same as the pre processing performed by the correction unit 33b in the first embodiment. The generation unit 323 performs image processing upon the inputted image data after having performed pre processing thereupon as described above, and thereby generates an image. The image processing performed by the generation unit 323 is the same as the image processing performed by the generation unit 33c of the first embodiment.

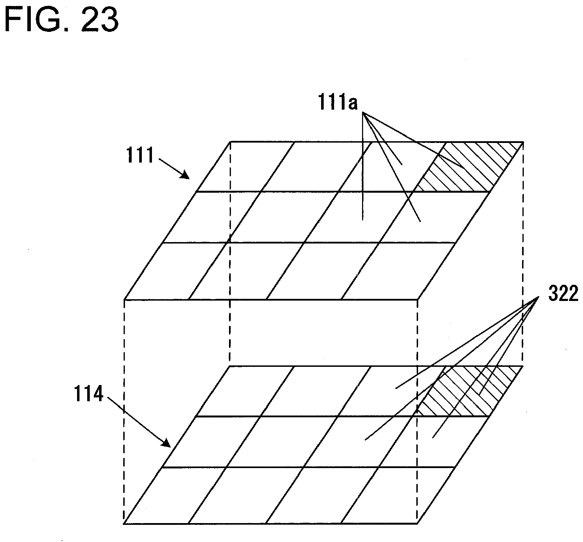

Fig. 23 is a figure schematically showing a correspondence relationship in this embodiment between various blocks and a plurality of correction units 322. In Fig. 23, a single square on the image capture chip 111, which is represented by a rectangle, represents a single block 111a. Similarly, one square shown as rectangular upon an image processing chip 114 that will be described hereinafter represents a single one of the correction units 322.

In this embodiment, one of the correction units 322 is provided to correspond to each of the blocks 111a. To put it in another manner, one correction unit 322 is provided for each of the blocks, which are the minimum unit regions upon the imaging surface for which the image capture conditions can be changed. For example, the block 111a that is shown in Fig. 23 as hatched corresponds to the correction unit 322 that is shown as hatched. The correction unit 322 that is shown in Fig. 23 as hatched performs pre-processing upon the image data from the pixels included in the block 111a that is shown as hatched. And each of the correction units 322 likewise performs pre processing upon the image data from the pixels included in the respectively corresponding block 111a.

Since, in this manner, it is possible for the pre processing of the image data to be performed by the plurality of correction units 322 in parallel, accordingly it is possible to reduce the processing burden upon the correction units 322, and moreover it is possible to generate an appropriate image in a short time period from the image data generated in each of the regions for which the image capture conditions are different.

It should be understood that, in the following explanation, when explaining the relationship between some block 111a and a pixel included in that block 111a, in some cases the block 111a may be referred to as the block 111a to which that pixel belongs. Moreover, the block 111a will sometimes be referred to as a unit subdivision, and a collection of a plurality of the blocks 111a, that is a collection of a plurality of unit subdivisions will sometimes be referred to as a compound subdivision.

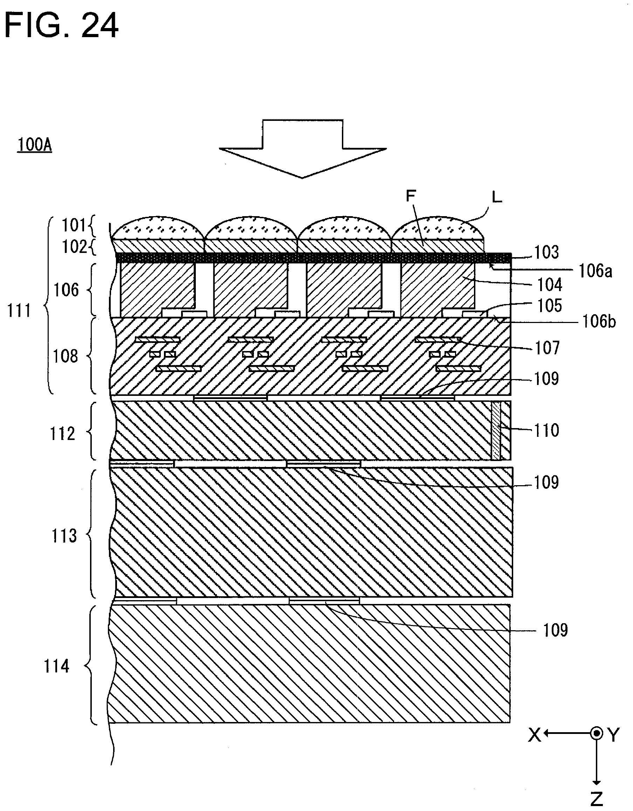

Fig. 24 is a sectional view of a laminated type imaging element 100a. In addition to a backside illuminated type capture chip 111, a signal processing chip 112, and a memory chip 113, this laminated type imaging element 100A further comprises an image processing chip 114 that performs the pre-processing and image processing described above. In other words, the image processing unit 32c described above is provided upon the image processing chip 114.

The image capture chip 111, the signal processing chip 112, the memory chip 113, and the image processing chip 114 are laminated together, and are mutually electrically connected by electrically conductive bumps 109 that are made from Cu or the like.

A plurality of these bumps 109 are arranged on mutually opposing surfaces of the memory chip 113 and the image processing chip 114. These bumps 109 are aligned with each other, and, by for example pressing the memory chip 113 and the image processing chip 114 against each other, these bumps 109 that are mutually aligned are bonded together so as to be electrically connected together.

### First Correction Processing

In a similar manner to the case with the first embodiment, in this second embodiment, after the imaging screen has been subdivided into regions by the setting unit 34b, image capture conditions can be set (or changed) for a region selected by the user, or for a region determined by the control unit 34. When setting different image capture conditions for the various subdivided regions, according to requirements, the control unit 34 causes the correction unit 322 of the image processing unit 32c to perform first correction processing.

That is, when a boundary between regions based upon a plurality of elements of the photographic subject is included in a block, which is the minimum unit for which image capture conditions can be set, and moreover clipped whites or crushed black is present in the image data for this block, then the control unit 34 causes the correction unit 322 to perform first correction processing as described below, as one type of pre processing performed before the image processing, the focus detection processing, photographic subject detection processing, and processing for setting the image capture conditions.

### 1. The Same Correction is Performed Over the Entire Region Where Clipped Whites or Crushed Blacks Have Occurred

(1-1) As the first correction processing, in a similar manner to the case with the first embodiment, the correction unit 322 replaces all items of the main image data in which clipped whites or crushed blacks have occurred within the block for attention in the main image data, by employing an item of image data for processing acquired for a single block (the block for attention, or a reference block) among the image data for processing according to any of the methods (i) through (iv) described below.
(i) The correction unit 322 replaces a main image data item of the block for attention in the main image data in which clipped whites or crushed blacks have occurred with an item of image data for processing acquired for a single block (the block for attention or a reference block) of the image data for processing corresponding to the position closest to the region described above where clipped whites or crushed blacks have occurred. Even if a plurality of pixels where clipped whites or crushed blacks have occurred are present within the block for attention of the main image data, main image data items for the plurality of pixels in which clipped whites or crushed blacks have occurred are replaced with the same item of image data for processing acquired for the single block of the image data for processing (the block for attention or the reference block) corresponding to the closest position described above.
(ii) If clipped whites or crushed blacks have occurred in the block for attention of the image data for processing as well, then the correction unit 322 performs replacement as follows. That is, a plurality of main image data items of the block for attention in which clipped whites or crushed blacks have occurred in the main image data are replaced with the same item of image data for processing acquired for a single reference block that is selected from the reference blocks for which are applied the image capture conditions set most for the same element of the photographic subject (in this example, the mountain) as the element of the photographic subject (the mountain) with which clipped whites or crushed blacks have occurred (in this example, the fourth image capture conditions). Even if a plurality of pixels in which clipped whites or crushed blacks have occurred are present within the block for attention of the main image data, the main image data items for this plurality of pixels in which clipped whites or crushed blacks have occurred are replaced with the same item of image data for processing acquired from a single reference block.
(iii) It would also be acceptable for the correction unit 322 to replace the main image data item with which clipped whites or crushed blacks have occurred by employing an item of image data for processing corresponding to a pixel adjacent to the pixels in the block for attention with which clipped whites or crushed blacks have occurred among the items of image data for processing corresponding to a plurality of pixels (in the example of Fig. 8(b), four pixels) acquired in a single block of the image data for processing according to (i) or (ii) described above.
(iv) It would also be acceptable for the correction unit 322 to replace the main image data item in which clipped whites or crushed blacks have occurred by employing image data generated on the basis of the items of image data for processing corresponding to a plurality of pixels (in the example of Fig. 8, four pixels) acquired for a single reference block of the image data for processing according to (i) or (ii) described above.

It should be understood that, in the same manner as in the first embodiment, when calculating the average value of the image data for processing, instead of performing simple averaging, it would also be acceptable to perform replacement with a weighted average value that is obtained by assigning weightings according to the distance from the pixel where clipped whites or crushed blacks has occurred.

Moreover, instead of calculating the average value of the items of image data for processing corresponding to a plurality of pixels included in the reference block of the image data for processing, it would also be acceptable to calculate the median value of the items of image data for processing corresponding to a plurality of pixels, and to replace the main image data item corresponding to a pixel in which clipped whites or crushed blacks have occurred with this median value, as in the case of the first embodiment.

(1-2) As the first correction processing, in a similar manner to the case with the first embodiment, the correction unit 322 replaces all items of the main image data in which clipped whites or crushed blacks have occurred within the block for attention in the main image data, by employing the items of image data for processing acquired for a plurality of blocks among the image data for processing, according to any of the methods (i) through (iv) described below.
(i) The correction unit 322 replaces the main image data item of the block for attention in which clipped whites or crushed blacks have occurred in the main image data with the item of image data for processing acquired for a plurality of reference blocks of the image data for processing corresponding to the positions around the region described above where clipped whites or crushed blacks have occurred. Even if a plurality of pixels where clipped whites or crushed blacks have occurred are present within the block for attention of the main image data, main image data items for the plurality of pixels in which clipped whites or crushed blacks have occurred are replaced with the same item of image data for processing acquired for the plurality of reference blocks of the image data for processing described above.
(ii) If clipped whites or crushed blacks have also occurred in the block for attention of the image data for processing, then the correction unit 322 performs replacement as follows. That is, a plurality of main image data items of the block for attention in which clipped whites or crushed blacks have occurred in the main image data with the same item of image data for processing acquired for a plurality of reference blocks chosen from among the reference blocks for which are applied the image capture conditions (in this example, the fourth image capture conditions) set most for the same element of the photographic subject (in this example, the mountain) as the element of the photographic subject (the mountain) with which clipped whites or crushed blacks have occurred. Even if a plurality of pixels in which clipped whites or crushed blacks have occurred are present within the block for attention of the main image data, the main image data items for this plurality of pixels in which clipped whites or crushed blacks have occurred are replaced with the same item of image data for processing acquired from the plurality of reference blocks of the image data for processing described above.
(iii) It would also be acceptable for the correction unit 322 to replace the main image data with which clipped whites or crushed blacks have occurred by employing the item of image data for processing corresponding to a pixel adjacent to a pixel in the block for attention with which clipped whites or crushed blacks have occurred in the image data for processing among the items of image data for processing corresponding to a plurality of pixels acquired in a plurality of reference blocks as described in (i) or (ii) above.
(iv) It would also be acceptable for the correction unit 322 to replace the main image data in the block for attention with which clipped whites or crushed blacks have occurred by employing image data generated on the basis of the items of image data for processing corresponding to a plurality of pixels acquired for a plurality of reference blocks according to (i) or (ii) described above.

It should be understood that, when calculating the average value of the image data for processing, instead of performing simple averaging, it would also be acceptable to perform replacement with a weighted average value that is obtained by assigning weightings according to the distance from the pixel where clipped whites or crushed blacks has occurred, as in the case of the first embodiment.

Moreover, instead of calculating the average value of the items of image data for processing corresponding to a plurality of pixels included in a plurality of the reference blocks of the image data for processing, it would also be acceptable to calculate the median value of the items of image data for processing corresponding to the plurality of pixels, and to replace the main image data item corresponding to the pixel in which clipped whites or crushed blacks have occurred with the median value, as in the case of the first embodiment.

### 2. A Plurality of Corrections are Performed Over the Entire Region Where Clipped Whites or Crushed Blacks Have Occurred

(2-1) As the first correction processing, in a similar manner to the case with the first embodiment, the correction unit 322 replaces all items of the main image data in which clipped whites or crushed blacks have occurred within the block for attention in the main image data, by employing the item of image data for processing acquired for a single block among the image data for processing according to any of the methods (i) through (iii) described below.
(i) The correction unit 322 replaces the main image data of the block for attention in which clipped whites or crushed blacks have occurred in the main image data with the item of image data for processing acquired for a single reference block among the plurality of reference blocks of the image data for processing corresponding to the positions around the region described above where clipped whites or crushed blacks have occurred. If a plurality of pixels where clipped whites or crushed blacks have occurred are present within the block for attention of the main image data, then the main image data items for the plurality of pixels in which clipped whites or crushed blacks have occurred are respectively replaced with the different items of image data for processing acquired for the single block of the image data for processing described above.
(ii) If clipped whites or crushed blacks have occurred in the block for attention of the image data for processing as well, then the correction unit 322 performs replacement as follows. That is, a plurality of main image data items of the block for attention in which clipped whites or crushed blacks have occurred in the main image data with different items of image data for processing acquired from a single reference block chosen from among the reference blocks for which are applied the image capture conditions (in this example, the fourth image capture conditions) which are set the greatest number of times for the same element of the photographic subject (in this example, the mountain) as the element of the photographic subject (the mountain) in which clipped whites or crushed blacks have occurred. If a plurality of pixels in which clipped whites or crushed blacks have occurred are present within the block for attention of the main image data, the main image data items for this plurality of pixels in which clipped whites or crushed blacks have occurred are replaced with different items of image data for processing acquired from the single reference block of the image data for processing described above.
(iii) It would also be acceptable for the correction unit 322 to replace the main image data in the block for attention with which clipped whites or crushed blacks have occurred by employing image data generated on the basis of the image data for processing corresponding to a plurality of pixels that have been acquired in a single reference block according to (i) or (ii) above.

It should be understood that, when calculating the average value of the image data for processing, instead of performing simple averaging, it would also be acceptable to perform replacement with a weighted average value that is obtained by assigning weightings according to the distance from the pixel where clipped whites or crushed blacks has occurred, as in the case of the first embodiment.

Moreover, instead of calculating the average value of the items of image data for processing corresponding to a plurality of pixels included in a plurality of reference blocks of the image data for processing, it would also be acceptable to calculate the median value of the items of image data for processing corresponding to a plurality of pixels, and to replace the main image data item corresponding to the black crush pixel with the median value, as in the case of the first embodiment.

(2-2) As the first correction processing, in a similar manner to the case with the first embodiment, the correction unit 322 replaces all items of the main image data in which clipped whites or crushed blacks have occurred within the block for attention in the main image data, by employing the image data for processing acquired for a plurality of blocks among the image data for processing according to any of the methods (i) through (iv) described below.
(i) The correction unit 322 replaces the main image data item of the block for attention in which clipped whites or crushed blacks have occurred in the main image data with the item of image data for processing acquired for a plurality of reference blocks of the image data for processing corresponding to the positions around the region described above where clipped whites or crushed blacks have occurred. If a plurality of pixels where clipped whites or crushed blacks have occurred are present within the block for attention of the main image data, then the main image data items for the plurality of pixels in which clipped whites or crushed blacks have occurred are respectively replaced with the different items of image data for processing acquired for the plurality of reference blocks of the image data for processing described above.
(ii) If clipped whites or crushed blacks have occurred in the block for attention of the image data for processing as well, then the correction unit 322 performs replacement as follows. That is, a plurality of main image data items of the block for attention in which clipped whites or crushed blacks have occurred in the main image data are replaced with different items of image data for processing acquired from a plurality of reference blocks chosen from among the reference blocks for which are applied the image capture conditions (in this example, the fourth image capture conditions) set most for the same element of the photographic subject (in this example, the mountain) as the element of the photographic subject (the mountain) in which clipped whites or crushed blacks have occurred. If a plurality of pixels in which clipped whites or crushed blacks have occurred are present within the block for attention of the main image data, then the main image data items for this plurality of pixels in which clipped whites or crushed blacks have occurred are replaced with the different items of image data for processing acquired from the plurality of reference blocks of the image data for processing described above.
(iii) It would also be acceptable for the correction unit 322 to replace the main image data in the block for attention with which clipped whites or crushed blacks have occurred by employing image data generated on the basis of the items of image data for processing corresponding to a plurality of pixels that have been acquired in a plurality of reference blocks according to (i) or (ii) above.

It should be understood that, when calculating the average value of the items of image data for processing, instead of performing simple averaging, it would also be acceptable to perform replacement with a weighted average value that is obtained by assigning weightings according to the distance from the pixel where clipped whites or crushed blacks have occurred, as in the case of the first embodiment.

Moreover, instead of calculating the average value of the items of image data for processing corresponding to a plurality of pixels included in a plurality of the reference block of the image data for processing, it would also be acceptable to calculate the median value of the items of image data for processing corresponding to a plurality of pixels, and to replace the main image data item corresponding to the black crush pixel with the median value, as in the case of the first embodiment.

With respect to which correction methods should be performed among the methods of the first correction processing explained above, the control unit 34 may, for example, make a decision on the basis of the state of setting by the operation members 36 (including operation menu settings).

It should be understood that it would also be acceptable to arrange for the control unit 34 to determine which of the various methods of the first correction processing explained above should be performed, according to the scene imaging mode that is set for the camera 1, or according to the type of photographic subject element that has been detected.

### Second Correction Processing

Before performing the image processing, the focus detection processing, the photographic subject detection processing (for detecting the elements of the photographic subject), and the processing for setting the image capture conditions, the control unit 34 instructs the correction unit 322 to perform the following second correction processing, according to requirements.

### 1. When Performing Image Processing

### 1-1. If the Image Capture Conditions for the Pixel for Attention P and the Image Capture Conditions for the Plurality of Reference Pixels Pr Around the Pixel for Attention P are the Same

In this case, in the image processing unit 32c, the correction unit 322 does not perform the second correction processing, and the generation unit 323 performs image processing by employing the main image data items of the plurality of reference pixels Pr which have not been subjected to the second correction processing.

### 1-2. If the Image Capture Conditions for the Pixel for Attention P and the Image Capture Conditions for at least One Reference Pixel Pr among the Plurality of Reference Pixels Pr Around the Pixel for Attention P are Different

The image capture conditions applied at the pixel for attention P will be supposed to be the first image capture conditions, and the image capture conditions applied at a part of the plurality of reference pixels Pr will be supposed to be the first image capture conditions, while the image capture conditions applied the remainder of the reference pixels Pr will be supposed to be the second image capture conditions.

In this case, the correction unit 322 corresponding to the block 111a to which belong the reference pixel Pr to which the second image capture conditions have been applied performs the second correction processing upon the main image data item for the reference pixel Pr to which the second image capture conditions have been applied, as will be described in Example 1 through Example 3 below. And the generation unit 323 then performs image processing for calculating the main image data for the pixel for attention P by referring to the main image data for the reference pixel Pr to which the first image capture conditions have been applied and to the main image data for the reference pixel Pr after the second correction processing.

### Example 1

For example, if the first image capture conditions and the second image capture conditions only differ in ISO sensitivity with the ISO sensitivity of the first image capture conditions being 100 while the ISO sensitivity of the second image capture conditions is 800, then, as the second correction processing, the correction unit 322 corresponding to the block 111a to which the reference pixel Pr to which the second image capture conditions were applied belongs multiplies the main image data for this reference pixel Pr by 100/800. By doing this, the disparity between the main image data items due to discrepancy in the image capture conditions is reduced.

### Example 2

For example, if the first image capture conditions and the second image capture conditions only differ in shutter speed with the shutter speed of the first image capture conditions being 1/1000 second while the shutter speed of the second image capture conditions is 1/100 second, then, as the second correction processing, the correction unit 322 corresponding to the block 111a to which the reference pixel Pr to which the second image capture conditions were applied belongs multiplies the main image data for this reference pixel Pr by 1/1000/1/100=1/10. By doing this, the disparity between the main image data item due to discrepancy in the image capture conditions is reduced.

### Example 3

For example, if the first image capture conditions and the second image capture conditions only differ in frame rate (the charge accumulation time being the same) with the frame rate of the first image capture conditions being 30 fps while the frame rate of the second image capture conditions is 60 fps, then, as the second correction processing, for the main image data for the reference pixel Pr, in other words for the main image data captured under the second image capture conditions (i.e. at 60 fps), the correction unit 322 corresponding to the block 111a to which belongs the reference pixel Pr to which the second image capture conditions were applied employs the main image data for a frame image whose starting timing of acquisition is close to that of a frame image which was captured under the first image capture conditions (i.e. at 30 fps). By doing this, the disparity between the main image data items due to discrepancy in the image capture conditions is reduced.

It should be understood that it would also be acceptable to execute, as the second correction processing, interpolation calculation for main image data of a frame image whose starting time of acquisition is close to that of a frame image that was acquired under the first image capture conditions (i.e. at 30 fps), on the basis of a plurality of frame images acquired sequentially under the second image capture conditions (i.e. at 60 fps).

It should be understood the same also applies to the case in which the image capture conditions that are applied to the pixel for attention P are the second image capture conditions, and the image capture conditions that are applied to the reference pixels Pr around the pixel for attention P are the first image capture conditions. In other words, in this case, the correction unit 322 corresponding to the block 111a to which the reference pixel Pr to which the first image capture conditions have been applied performs the second correction processing as described in Example 1 through Example 3 above upon the main image data for this reference pixel Pr.

It should be understood that, as described above, even if there are some moderate differences in the image capture conditions, still they are regarded as being the same image capture conditions.

In a similar manner to the case of the generation unit 33c of the image processing unit 33 of the first embodiment, on the basis of the main image data for the reference pixel Pr to which have been applied the same image capture conditions as the image capture conditions for the pixel for attention P and the main image data for the reference pixel Pr to which the second correction processing has been performed by the correction unit 322, the generation unit 323 performs image processing such as pixel defect correction processing, color interpolation processing, contour enhancement processing, noise reduction processing, and so on.

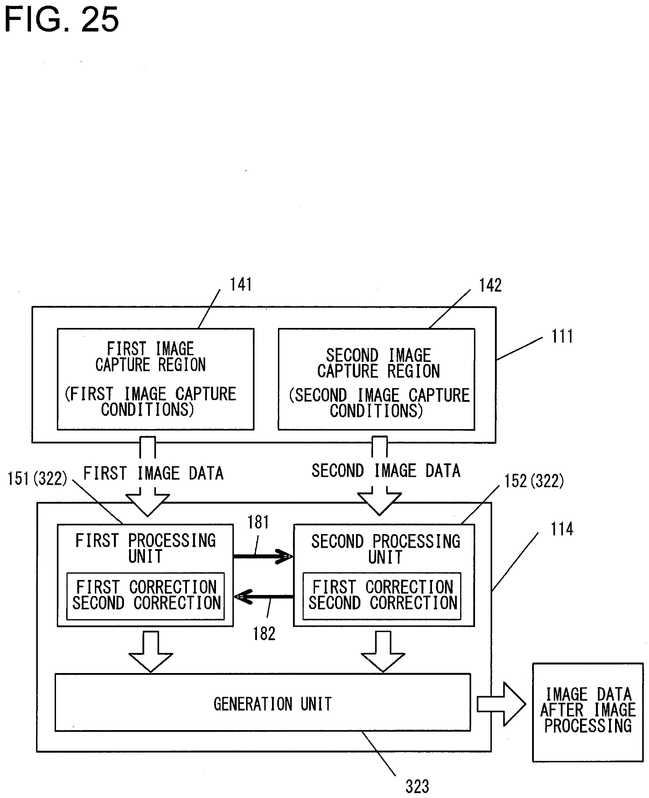

Fig. 25 is a figure schematically showing processing upon main image data (hereinafter referred to as first image data) from pixels included in a partial region of the imaging surface (hereinafter referred to as a first image capture region 141) to which the first image capture conditions have been applied, and upon main image data (hereinafter referred to as second image data) from pixels included in a partial region of the imaging surface (hereinafter referred to as a second image capture region 142) to which the second image capture conditions have been applied.

The first image data captured under the first image capture conditions are respectively outputted from the pixels included in the first image capture region 141, and the second image data captured under the second image capture conditions are respectively outputted from the pixels included in the second image capture region 142. The first image data is outputted to the correction unit 322, among the correction units 322 provided to the processing chip 114, corresponding to the block 111a to which the pixel that generated the first image data belongs. In the following explanation, the plurality of correction units 322 that respectively correspond to the plurality of blocks 111a to which the pixels that have generated the respective first image data belong will be referred to as a first processing unit 151.

According to requirements, the first processing unit 151 performs, upon the first image data, the first correction processing described above and also the second correction processing described above, or alternatively the first correction processing described above or the second correction processing described above.

In a similar manner, the second image data is outputted to the correction unit 322, among the correction units 322 provided to the processing chip 114, corresponding to the block 111a to which the pixel that generated the second image data belongs. In the following explanation, the plurality of correction units 322 that respectively correspond to the plurality of blocks 111a to which the pixels that have generated the respective second image data belong will be referred to as a second processing unit 152.

According to requirements, the second processing unit 152 performs, upon the second image data, the first correction processing described above and also the second correction processing described above, or alternatively the first correction processing described above or the second correction processing described above.

In the first correction processing described above, if for example the block for attention of the main image data is included in the first image capture region 141, then, as shown in Fig. 25, the first correction processing described above, in other words replacement processing, is performed by the first processing unit 151. In this manner, image data in which clipped whites or crushed blacks have occurred within the block for attention of the main image data is replaced with the second image data from the reference block included in the second image capture region 142 of the data for processing. For this purpose, for example, the first processing unit 151 receives the second image data from the reference block of the image data for processing as information 182 from the second processing unit 152.

In the second correction processing described above, if for example the pixel for attention P is included in the first image capture region 141, then as shown in Fig. 25 the second correction processing described above is performed by the second processing unit 152 upon the second image data from reference pixel Pr included in the second image capture region 142. It should be understood that, for example, the second processing unit 152 receives information 181 from the first processing unit 151 related to the first image capture conditions, required for reducing the disparity between sets of the image data due to discrepancy in the image capture conditions.

In a similar manner, for example, if the pixel for attention P is included in the second image capture region 142, then the second correction processing described above is performed upon the first image data from the reference pixels Pr included in the first image capture region 141 by the first processing unit 151. It should be understood that, for example, the first processing unit 151 receives information from the second processing unit 152 related to the second image capture conditions, required for reducing the disparity between sets of the image data due to discrepancy in the image capture conditions.

It should be understood that, if the pixel for attention P and the reference pixels Pr are included in the first image capture region 141, then the first processing unit 151 does not perform the second correction processing upon the first image data from those reference pixels Pr. In a similar manner, if the pixel for attention P and the reference pixels Pr are included in the second image capture region 142, then the second processing unit 152 does not perform the second correction processing upon the second image data from those reference pixels Pr.

Alternatively, it would also be acceptable for both the image data captured under the first image capture conditions and also the image data captured under the second image capture conditions to be corrected by each of the first processing unit 151 and the second processing unit 152. In other words it would be acceptable to reduce the disparity in the image due to discrepancy between the first image capture conditions and the second image capture conditions, by performing the second correction processing upon each of the image data for the position of attention that was captured under the first image capture conditions, and the image data that, among the image data for the reference positions, was captured under the first image conditions, and also upon the image data that, among the image data for the reference positions, was captured under the second image conditions.

For example, in Example 1 described above, the image data for the reference pixels Pr under the first image capture conditions (ISO sensitivity being 100) is multiplied by 400/100 as the second correction processing, while the image data for the reference pixels Pr under the second image capture conditions (ISO sensitivity being 800) is multiplied by 400/800 as the second correction processing. In this manner, the disparity between the image data due to discrepancy in the image capture conditions is reduced. It should be understood that second correction processing is performed upon the pixel data of the pixel for attention by applying multiplication by 100/400 after color interpolation processing. By this second correction processing, it is possible to change the pixel data of the pixel for attention after color interpolation processing to a value similar to the value in the case of image capture under the first image capture conditions. Furthermore, in Example 1 described above, it would also be acceptable to change the level of the second correction processing according to the distance from the boundary between the first region and the second region. And it is possible to reduce the rate by which the image data increases or decreases due to the second correction processing as compared to the case of Example 1 described above, and to reduce the noise generated due to the second correction processing. Although the above explanation has referred to the previously described Example 1, it could be applied in a similar manner to the previously described Example 2.

On the basis of the image data from the first processing unit 151 and from the second processing unit 152, the generation unit 323 performs image processing such as pixel defect correction processing, color interpolation processing, contour enhancement processing, noise reduction processing, and so on, and outputs the image data after image processing.

It should be understood that, when the pixel for attention P is positioned in the second image capture region 142, it would be acceptable to arrange for the first processing unit 151 to perform the second correction processing upon the first image data from all of the pixels that are included in the first image capture region 141; or, alternatively, it would also be acceptable to arrange for the second correction processing to be performed only upon the first image data from those pixels which, among the pixels included in the first image capture region 141, may be employed in interpolation of the pixel for attention P in the second image capture region 142. In a similar manner, when the pixel for attention P is positioned in the first image capture region 141, it would be acceptable to arrange for the second processing unit 152 to perform the second correction processing upon the second image data from all of the pixels that are included in the second image capture region 142; or, alternatively, it would also be acceptable to arrange for the second correction processing to be performed only upon the second image data from those pixels which, among the pixels included in the second image capture region 142, may be employed in interpolation of the pixel for attention P in the first image capture region 141.

### 2. When Performing Focus Detection Processing

In a similar manner to the case with the first embodiment, the lens movement control unit 34d of the control unit 34 performs focus detection processing by employing the signal data (i.e. the image data) corresponding to a predetermined position (i.e. the point of focusing) upon the imaging screen. It should be understood that, if different image capture conditions are set for different ones of the various subdivided regions, and if the point of focusing for A/F operation is positioned at a boundary portion between several subdivided regions, in other words if the point of focusing is divided into two by the first region and the second region, then, in this embodiment, as explained in 2 2 below, the lens movement control unit 34d of the control unit 34 causes the correction units 322 to perform the second correction processing upon the signal data for focus detection of at least one of those regions.
2-1. The Case in which Signal Data to which the First Image Capture Conditions have been Applied and Signal Data to which the Second Image Capture Conditions have been Applied are Not Mixed Together in the Signal Data from the Pixels within the Frame 170 in Fig. 15
   In this case, the correction unit 322 does not perform the second correction processing, and the lens movement control unit 34d of the control unit 34 performs focus detection processing by employing the signal data from the pixels for focus detection shown by the frame 170 just as it is without modification.
2-2. The Case in which Signal Data to which the First Image Capture Conditions have been Applied and Signal Data to which the Second Image Capture Conditions have been Applied are Mixed Together in the Signal Data from the Pixels within the Frame 170 in Fig. 15

In this case, the lens movement control unit 34d of the control unit 34 instructs to perform the second correction processing with the correction unit 322 that corresponds to the block 111a of the pixels to which, among the pixels within the frame 170, the second image capture conditions have been applied, as shown in Example 1 through Example 3 below. And the lens movement control unit 34d of the control unit 34 performs focus detection processing by employing the signal data from the pixels to which the first image capture conditions have been applied, and the above signal data after the second correction processing.

### Example 1

For example, if the first image capture conditions and the second image capture conditions only differ by ISO sensitivity, with the ISO sensitivity of the first image capture conditions being 100 while the ISO sensitivity of the second image capture conditions is 800, then the correction unit 322 corresponding to the block 111a of the pixels to which the second image capture conditions have been applied performs the second correction processing by multiplying the signal data that was captured under the second image capture conditions by 100/800. By doing this, disparity between the signal data due to discrepancy in the image capture conditions is reduced.

### Example 2

For example, if the first image capture conditions and the second image capture conditions only differ by shutter speed, with the shutter speed of the first image capture conditions being 1/1000 second while the shutter speed of the second image capture conditions is 1/100 second, then the correction unit 322 corresponding to the block 111a of the pixels to which the second image capture conditions have been applied may perform the second correction processing by multiplying the signal data that was captured under the second image capture conditions by 1/1000/1/100=1/10. By doing this, disparity between the signal data due to discrepancy in the image capture conditions is reduced.

### Example 3

For example, if the first image capture conditions and the second image capture conditions only differ by frame rate (the charge accumulation time being the same), with the frame rate of the first image capture conditions being 30 fps while the frame rate of the second image capture conditions is 60 fps, then for example, as the second correction processing for the signal data that was captured under the second image conditions (i.e. at 60 fps), the correction unit 322 corresponding to the block 111a of the pixels to which the second image capture conditions have been applied employs signal data for a frame image whose starting timing of acquisition is close to that of a frame image that was acquired under the first image capture conditions (at 30 fps). By doing this, disparity between the signal data due to discrepancy in the image capture conditions is reduced.

It should be understood that, for the second correction processing, it would also be acceptable to calculate the signal data for a frame image whose starting timing of acquisition is close to that of a frame image acquired under the first image capture conditions (i.e. at 30 fps) through interpolation based on a plurality of previous and subsequent frame images acquired under the second image capture conditions (i.e. at 60 fps).

It should be noted that, as mentioned above, even if there are some moderate differences in the image capture conditions, still they are regarded as being the same image capture conditions.

Furthermore while, in the examples described above, explanation was made in which the second correction processing was performed upon the signal data that, among the signal data, was captured according to the second image capture conditions, it would also be acceptable to perform the second correction processing upon the signal data that, among the signal data, was captured according to the first image capture conditions.

Yet further, it would also be acceptable to arrange to reduce the difference between the two sets of signal data after the second correction processing, by performing the second correction processing upon, among the signal data, both the signal data that was captured under the first image capture conditions and also the signal data that was captured under the second image conditions.

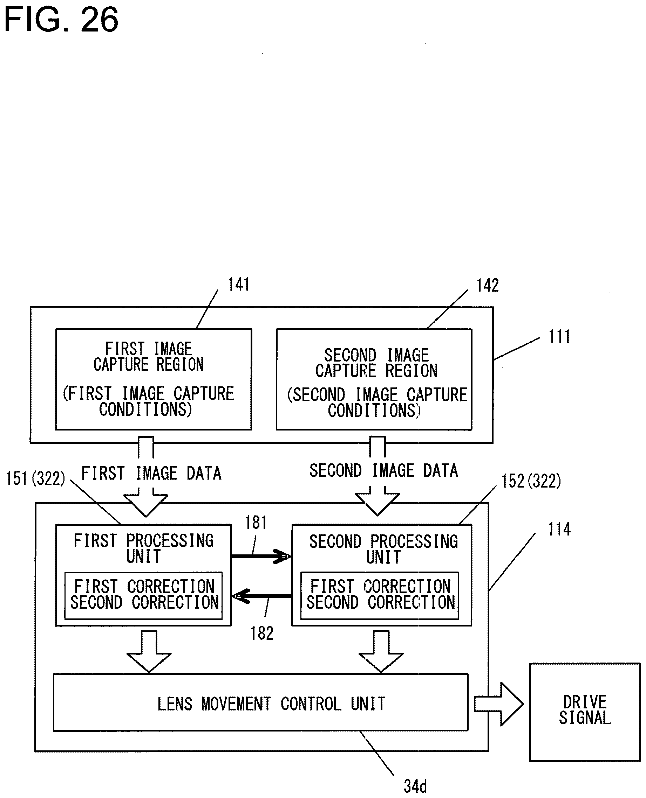

Fig. 26 is a figure relating to the focus detection processing, schematically showing the processing of the first signal data and the second signal data.

The first image data captured under the first image capture conditions is outputted from each of the pixels included in the first image capture region 141, and the second image data captured under the second image capture conditions is outputted from each of the pixels included in the second image capture region 142. The first signal data from the first image capture region 141 is outputted to the first processing unit 151. In a similar manner, the second signal data from the second image capture region 142 is outputted to the second processing unit 152.

According to requirements, the first processing unit 151 performs, upon the first signal data of the main image data, the first correction processing described above and also the second correction processing described above, or alternatively the first correction processing described above or the second correction processing described above. And, according to requirements, the second processing unit 152 performs, upon the second signal data of the main image data, the first correction processing described above and also the second correction processing described above, or alternatively the first correction processing described above or the second correction processing described above.

In the first correction processing described above, if for example the block for attention of the main image data is included in the first image capture region 141, then, as shown in Fig. 26, the first correction processing described above, in other words replacement processing, is performed by the first processing unit 151. In this manner, the first signal data in which clipped whites or crushed blacks have occurred within the block for attention of the main image data is replaced with the second signal data from the reference block included in the second image capture region 142 of the data for processing. For this purpose, for example, the first processing unit 151 receives the second signal data from the reference block of the image data for processing as information 182 from the second processing unit 152.

In the second correction processing described above, if the second correction processing is to be performed upon the signal data that, among the signal data, was captured under the second image capture conditions in order to reduce the difference between the signal data after the second correction processing and the signal data that was captured under the first image capture conditions is reduced, then the second processing unit 152 takes charge of the processing. The second processing unit 152 performs the second processing described above upon the second signal data from the pixels included in the second image capture region 142. It should be understood that, for example, the second processing unit 152 receives information 181 from the first processing unit 151 related to the first image capture conditions, required for reducing the disparity between the signal data due to discrepancy in the image capture conditions.

It should be understood that if the second correction processing is performed upon that signal data that, among the signal data, was captured under the second image capture conditions in order to reduce the difference between the signal data after the second correction processing and the signal data that was captured under the first image capture conditions, then the first processing unit 151 does not perform the second correction processing upon the first signal data.

Moreover if the second correction processing is to be performed upon the signal data that, among the signal data, was captured under the first image capture conditions in order to suppress the difference between the signal data after the second correction processing and the signal data that was captured under the first image capture conditions, then the first processing unit 151 takes charge of the processing. The first processing unit 151 performs the second correction processing described above upon the first signal data from the pixels that are included in the first image capture region 141. It should be understood that the first processing unit 151 receives information from the second processing unit 152 related to the second image capture conditions that is required for reducing disparity between the signal data due to discrepancy in the image capture conditions.

It should be understood if the second correction processing is performed upon the signal data that, among the signal data, was captured under the first image capture conditions in order to reduce the difference between the signal data after the second correction processing and the signal data that was captured under the first image capture conditions, then the second processing unit 152 does not perform the second correction processing upon the second signal data.

Even further when the second correction processing is performed both upon the signal data that, among the signal data, was captured under the first image capture conditions and also upon the signal data that was captured under the second image capture conditions in order to suppress the difference between both sets of signal data after the second correction processing, then the first processing unit 151 and the second processing unit 152 both perform the processing. The first processing unit 151 performs the second correction processing described above upon the first signal data from the pixels included in the first image capture region 141, and the second processing unit 152 performs the second correction processing described above upon the second signal data from the pixels included in the second image capture region 142.

The lens movement control unit 34d performs focus detection processing on the basis of the signal data from the first processing unit 151 and from the second processing unit 152, and outputs a drive signal for shifting the focusing lens of the image capture optical system 31 to its focusing position on the basis of the calculation result of the processing.

### 3. When Performing Photographic Subject Detection Processing

If different image capture conditions are set for the different subdivided regions and the search range 190 includes a boundary between the subdivided regions, then, in this embodiment, as explained in 3-2. below, the object detection unit 34a of the control unit 34 causes the correction unit 322 to perform the second correction processing upon the image data for at least one of the regions within the search range 190.
3-1. When Image Data to which the First Image Capture Conditions have been Applied and Image Data to which the Second Image Capture Conditions have been Applied are Not Mixed Together in the Image Data for the Search Range 190
   In this case, the correction unit 322 does not perform the second correction processing, and the object detection unit 34a of the control unit 34 performs photographic subject detection processing by employing the image data that constitutes the search range 190 just as it is without modification.
3-2. When Image Data to which the First Image Capture Conditions have been Applied and Image Data to which the Second Image Capture Conditions have been Applied are Mixed Together in the Image Data for the Search Range 190

In this case, the object detection unit 34a of the control unit 34 causes the correction unit 322 corresponding to the block 111a of the pixels, in the image for the search range 190, to which the second image capture conditions have been applied to perform the second control processing as in Example 1 through Example 3 described above in association with the focus detection processing. And the object detection unit 34a of the control unit 34 performs photographic subject detection processing by employing the image data for the pixels to which the first conditions were applied, and the image data after the second correction processing.

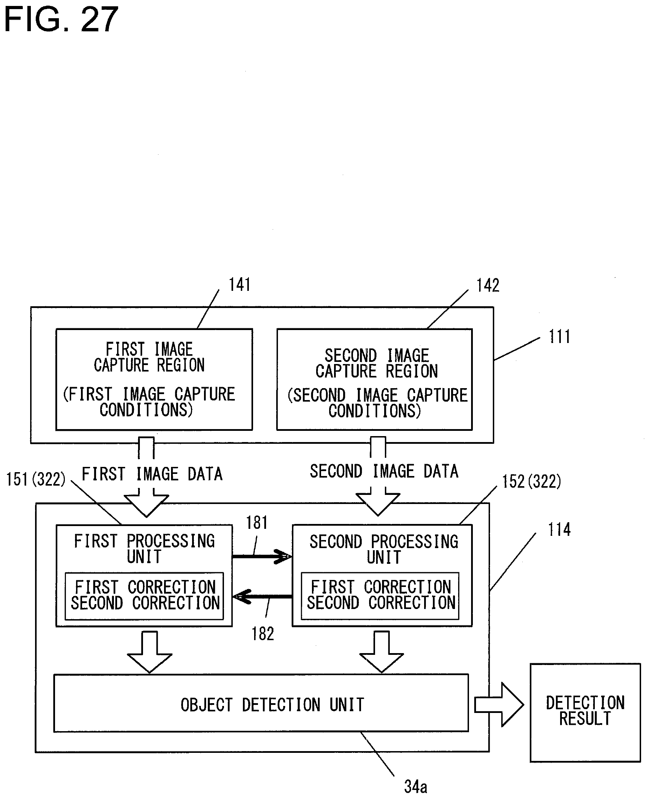

Fig. 27 is a figure relating to the photographic subject detection processing, schematically showing the processing of the first image data and the second image data.

According to requirements, the first processing unit 151 performs, upon the first image data of the main image data, the first correction processing described above and also the second correction processing described above, or alternatively the first correction processing described above or the second correction processing described above. And, according to requirements, the second processing unit 152 performs, upon the second image data of the main image data, the first correction processing described above and also the second correction processing described above, or alternatively the first correction processing described above or the second correction processing described above.

In the first correction processing described above, if for example the block for attention of the main image data is included in the first image capture region 141, then, as shown in Fig. 27, the first correction processing described above, in other words replacement processing, is performed by the first processing units 151. In this manner, the first image data in which clipped whites or crushed blacks have occurred within the block for attention of the main image data is replaced with the second image data from the reference block included in the second image capture region 142 of the image data for processing. For this purpose, for example, the first processing unit 151 receives the second image data from the reference block of the image data for processing as information 182 from the second processing unit 152.

In the second correction processing, the second correction processing performed by the first processing unit 151 and/or by the second processing unit 152 is the same as the second correction processing in Fig. 26 described above in the case of performing the focus detection processing.

The object detection unit 34a performs processing to detect the elements of the photographic subject on the basis of the image data from the first processing unit 151 and from the second processing units 152, and outputs the results of this detection.

### 4. When Performing Setting of the Image Capture Conditions

Cases will now be explained in which the imaging screen is subdivided into regions for which different image capture conditions are set, and exposure conditions are determined by newly performing photometry.
4-1. When Image Data to which the First Image Capture Conditions have been applied and Image Data to which the Second Image Capture Conditions have been Applied are Not Mixed Together in the Image Data for the Photometric Range
   In this case, the correction unit 322 does not perform the second correction processing, and the setting unit 34b of the control unit 34 performs the exposure calculation processing by employing the image data for the photometric range just as it is without alteration.
4-2. When Image Data to which the First Image Capture Conditions have been applied and Image Data to which the Second Image Capture Conditions have been Applied are Mixed Together in the Image Data for the Photometric Range

In this case, the setting unit 34b of the control unit 34 instructs the correction unit 322 corresponding to the block 111a of the pixels, among the image data for the photometric range, to which the second image capture conditions have been applied to perform the second correction processing as described above in Example 1 through Example 3 in association with the focus detection processing. And the setting unit 34b of the control unit 34 performs the exposure calculation processing by employing the image data after this second correction processing.

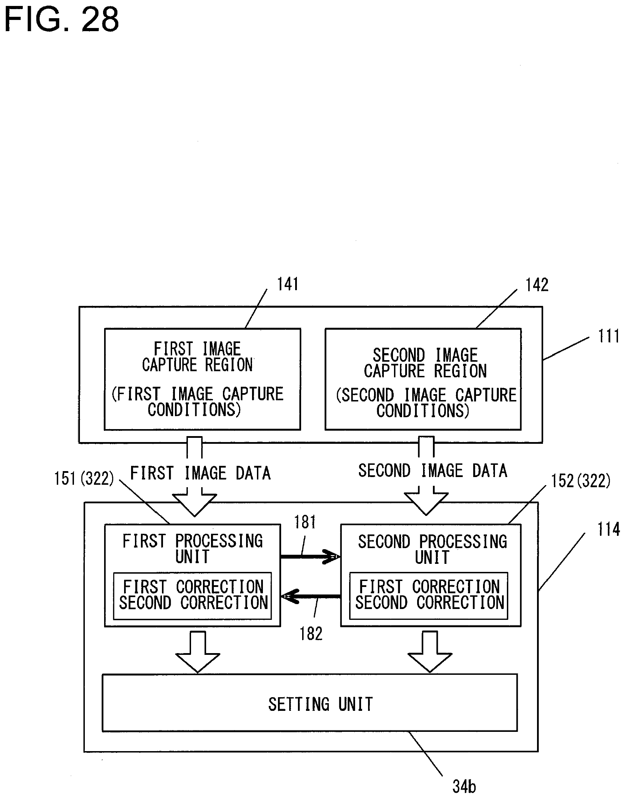

Fig. 28 is a figure relating to setting of the image capture conditions such as exposure calculation processing and so on, schematically showing the processing of the first image data and the second image data.

In the first correction processing described above, if for example the block for attention of the main image data is included in the first image capture region 141, then, as shown in Fig. 28, the first correction processing described above, in other words replacement processing, is performed by the first processing unit 151. In this manner, first image data in which clipped whites or crushed blacks have occurred within the block for attention of the main image data is replaced with the second image data from the reference block included in the second image capture region 142 of the image data for processing. For this purpose, for example, the first processing unit 151 receives the second image data from the reference block of the image data for processing as information 182 from the second processing unit 152.

In this second correction processing, the second correction processing that is performed by the first processing unit 151 and/or the second processing unit 152 is the same as the second correction processing for the case of performing the focus detection processing in Fig. 26 described above.

On the basis of the image data from the first processing unit 151 and from the second processing unit 152, the setting unit 34b performs calculation processing for image capture conditions, such as exposure calculation processing and so on, subdivides, on the basis of the result of this calculation, the imaging screen of the image capture unit 32 into a plurality of regions including elements of the photographic subject that have been detected, and re-sets the image capture conditions for this plurality of regions.

According to the second embodiment as explained above, the following advantageous operational effects are obtained.
(1) Since it is possible for the pre-processing (i.e. the first correction processing and the second correction processing) upon the image data to be performed in parallel by the plurality of correction units 322, accordingly it is possible to alleviate the processing burden upon the correction units 322.
(2) Since the pre-processing of the image data can be performed in parallel by the plurality of correction units 322, it is possible to alleviate the processing burden upon the correction units 322. Also, since the pre-processing is performed in a short time period by parallel processing by the plurality of correction units 322, it is possible to shorten the time period until focus detection processing by the lens movement control unit 34d starts, and this makes a contribution towards increasing the speed of the focus detection processing.
(3) Since the pre-processing of the image data can be performed by the plurality of correction units 322 by parallel processing, it is possible to alleviate the processing burden upon the correction units 322. Also, since the pre-processing is performed in a short time period by parallel processing by the plurality of correction units 322, it is possible to shorten the time period until photographic subject detection processing by the object detection unit 34a starts, and this makes a contribution towards increasing the speed of the photographic subject detection processing.
(4) Since the pre-processing of the image data can be performed by the plurality of correction units 322 by parallel processing, it is possible to alleviate the processing burden upon the correction units 322. Also, since the pre-processing is performed in a short time period by parallel processing by the plurality of correction units 322, it is possible to shorten the time period until image capture condition setting processing by the setting unit 34b starts, and this makes a contribution towards increasing the speed of the image capture condition setting processing.

### Variants of Second Embodiment

The following modifications also come within the range of the present invention, and one or a plurality of the following variants could also be combined with the embodiments described above.

### Variant 13

Explanation will be made for the processing of the first image data and the second image data when the first image capture region and the second image capture region are disposed in the imaging surface of the imaging element 32a as shown in Fig. 19(a) through Fig. 19(c) in Variant 1 of the first embodiment.

In this Variant, in a similar manner to the case with Variant 1, in any of Fig. 19(a) through Fig. 19(c), a first image is generated on the basis of the image signal read out from the first image capture region, and a second image is generated on the basis of the image signal read out from the second image capture region, according to the pixel signals read out from the imaging element 32a that has performed image capture of one frame. Also in this Variant, in a similar manner to the case with Variant 1, the control unit 34 employs the first image for display, and employs the second image for detection.

The image capture conditions that are set for the first image capture region that captures the first image will be referred to as the "first image capture conditions", and the image capture conditions that are set for the second image capture region that captures the second image will be referred to as the "second image capture conditions". The control unit 34 may make the first image capture conditions and the second image capture conditions be different.

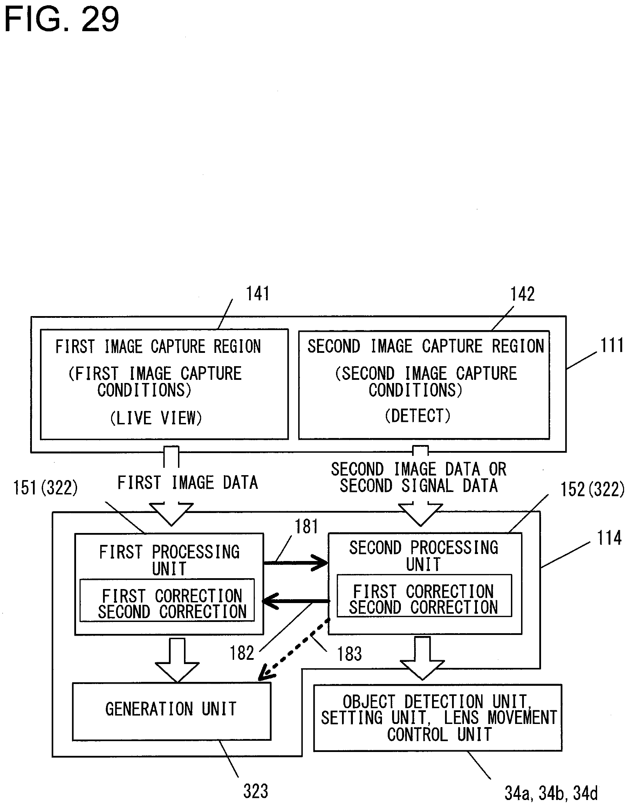

1. As one example, a case will be explained with reference to Fig. 29 in which the first image capture conditions that are set for the first image capture region are the same over the entire extent of the first image capture region of the imaging screen, and the second image capture conditions that are set for the second image capture region are the same over the entire extent of the second image capture region of the imaging screen. Fig. 29 is a figure schematically showing the processing of the first image data and of the second image data.

The first image data captured under the first image capture conditions is outputted from the pixels included in the first image capture region 141, and the second image data captured under the second image capture conditions is outputted from the pixels included in the second image capture region 142. The first image data from the first image capture region 141 is outputted to the first processing unit 151. In a similar manner, the second image data from the second image capture region 142 is outputted to the second processing unit 152.

According to requirements, the first processing unit 151 performs both the first correction processing described above and also the second correction processing described above upon the first image data, or performs either the first correction processing or the second correction processing.

And, according to requirements, the second processing unit 152 performs both the first correction processing described above and also the second correction processing described above upon the second image data, or performs either the first correction processing or the second correction processing.

In this example, since the first image capture conditions are the same over the entire first image capture region of the imaging screen, accordingly the first processing unit 151 does not perform the second correction processing upon the first image data from the reference pixels Pr that are included in the first image capture region. Moreover, since the second image capture conditions are the same over the entire second image capture region of the imaging screen, accordingly the second processing unit 152 does not perform the second correction processing upon the second image data to be employed in focus detection processing, photographic subject detection processing, or exposure calculation processing. However, for the second image data that is to be employed for interpolation of the first image data, the second processing unit 152 does perform the second correction processing in order to reduce disparity between the image data due to discrepancy between the first image capture conditions and the second image capture conditions. The second processing unit 152 outputs the second image data after the second correction processing to the first processing unit 151, as shown by an arrow sign 182. It should be understood that it would also be acceptable for the second processing unit 152 to output the second image data after the second correction processing to the generation unit 323, as shown by a dashed line arrow sign 183.

For example, the second processing unit 152 receives information 181 from the first processing unit 151 related to the first image capture conditions that are necessary for reducing disparity between the image data due to discrepancy in the image capture conditions.

On the basis of the first image data from the first processing unit 151 and the second image data that has been subjected to the second correction processing by the second processing units 152, the generation unit 323 performs image processing such as pixel defect correction processing, color interpolation processing, contour enhancement processing, noise reduction processing, and so on, and outputs the image data after this image processing.

The object detection unit 34a performs processing for detecting the elements of the photographic subject on the basis of the second image data from the second processing unit 152, and outputs the results of this detection.

The setting unit 34b performs calculation processing for image capture conditions such as exposure calculation processing and the like on the basis of the second image data from the second processing unit 152, and, on the basis of the results of this calculation, along with subdividing the imaging screen of the image capture unit 32 into a plurality of regions including the photographic subject elements that have been detected, also re-sets the image capture conditions for this plurality of regions.

And the lens movement control unit 34d performs focus detection processing on the basis of the second signal data from the second processing unit 152, and outputs a drive signal for causing the focusing lens of the image capture optical system 31 to shift to a focusing position on the basis of the results of this calculation.

2. As another example, a case will be explained with reference to Fig. 29 in which the first image capture conditions that are set for the first image capture region are different for different regions of the imaging screen, while the second image capture conditions that are set for the second image capture region are the same over the entire extent of the second image capture region of the imaging screen.

First image data captured under the first image capture conditions, which are different for different regions of the imaging screen, is outputted from the pixels included in the first image capture region 141, and second image data that has been captured under the same second image capture conditions over the entire extent of the second image capture region of the imaging screen is outputted from each of the pixels of the second image capture region 142. The first image data from the first image capture region 141 is outputted to the first processing unit 151. In a similar manner, the second image data from the second image capture region 142 is outputted to the second processing unit 152.

According to requirements, the first processing unit 151 performs both the first correction processing described above and also the second correction processing described above upon the first image data, or performs either the first correction processing or the second correction processing.

And, according to requirements, the second processing unit 152 performs both the first correction processing described above and also the second correction processing described above upon the second image data, or performs either the first correction processing or the second correction processing.

As described above, in this example, the first image capture conditions that are set for the first image capture region 141 vary according to different parts of the imaging screen. In other words, the first image capture conditions vary depending upon a partial region within the first image capture region 141. When different first image capture conditions are set for the pixel for attention P and for reference pixels Pr that are positioned within the first image capture region 141, the first processing unit 151 performs the second correction processing upon the first image data from those reference pixels Pr, similar to the second correction processing that was described in 1-2. above. It should be understood that, if the same first image capture conditions are set for the pixel for attention P and the reference pixels Pr, then the first processing unit 151 does not perform the second correction processing upon the first image data from those reference pixels Pr.

In this example, since the second image capture conditions for the second image capture region 142 of the imaging screen are the same over the entire second image capture region, accordingly the second processing unit 152 does not perform the second correction processing upon the second image data that is used for the focus detection processing, the photographic subject detection processing, and the exposure calculation processing. And, for the second image data that is used for interpolation of the first image data, the second processing unit 152 performs the second correction processing in order to reduce the disparity in the image data due to discrepancy between the image capture conditions for the pixel for attention P that is included in the first image capture region 141 and the second image capture conditions. And the second processing unit 152 outputs the second image data after this second correction processing to the first processing unit 151 (as shown by the arrow sign 182). It should be understood that it would also be acceptable for the second processing unit 152 to output the second image data after this second correction processing to the generation unit 323 (as shown by the arrow 183).

The second processing unit 152, for example, receives from the first processing unit 151 the information 181 relating to the image capture conditions for the pixel for attention P included in the first image capture region that is required in order to reduce the disparity between the image data due to discrepancy in the image capture conditions.

On the basis of the first image data from the first processing unit 151 and the second image data that has been subjected to the second correction processing by the second processing unit 152, the generation unit 323 performs image processing such as pixel defect correction processing, color interpolation processing, contour enhancement processing, noise reduction processing, and so on, and outputs the image data after this image processing.

The object detection unit 34a performs processing for detecting the elements of the photographic subject on the basis of the second image data from the second processing unit 152, and outputs the results of this detection.

The setting unit 34b performs calculation processing for image capture conditions such as exposure calculation processing and the like on the basis of the second image data from the second processing unit 152, and, on the basis of the results of this calculation, along with subdividing the imaging screen at the image capture unit 32 into a plurality of regions including the photographic subject elements that have been detected, also re sets the image capture conditions for this plurality of regions.

And the lens movement control unit 34d performs focus detection processing on the basis of the second signal data from the second processing unit 152, and outputs a drive signal for causing the focusing lens of the image capture optical system 31 to shift to a focusing position on the basis of the results of this calculation.

3. As yet another example, a case will be explained with reference to Fig. 29 in which the first image capture conditions that are set for the first image capture region 141 are the same over the entire extent of the first image capture region 141 of the imaging screen, while the second image capture conditions that are set for the second image capture region 142 are different for different regions of the imaging screen.

First image data captured under the same first image capture conditions for the whole of the first image capture region 141 of the imaging screen is outputted from respective pixels included within the first image capture region 141, and second image data captured under fourth image capture conditions that are different for different parts of the imaging screen is outputted from respective pixels included in the second image capture region 142. The first image data from the first image capture region 141 is outputted to the first processing unit 151. In a similar manner, the second image data from the first image capture region 142 is outputted to the second processing unit 152.

According to requirements, the first processing unit 151 performs both the first correction processing described above and also the second correction processing described above upon the first image data, or performs either the first correction processing described above or the second correction processing described above.

And, according to requirements, the second processing unit 152 performs both the first correction processing described above and also the second correction processing described above upon the second image data, or performs either the first correction processing described above or the second correction processing described above.

In this example, since the first image capture conditions that are set for the first image capture region 141 of the imaging screen are the same over the entire extent of the first image capture region 141, accordingly the first processing unit 151 does not perform the second correction processing upon the first image data from the reference pixels Pr that are included in the first image capture region 141.

Moreover, in this example, since the second image capture conditions that are set for the second image capture region 142 of the imaging screen are different for different regions of the imaging screen, accordingly the second processing unit 152 performs the second correction processing upon the second image data, as will now be described. For example, by performing the second correction processing upon some of the second image data, among the second image data, that was captured under certain image capture conditions, the second processing unit 152 is able to reduce the difference between the second image data after that second correction processing, and the second image data that was captured under image capture conditions different from the certain image capture conditions mentioned above.

In this example, for the second image data to be employed for interpolation of the first image data, the second processing unit 152 performs the second correction processing in order to reduce disparity in the image data due to discrepancy between the image capture conditions for the pixel for attention P included in the first image capture region 141 and the second image capture conditions. The second processing unit 152 outputs the second image data after this second correction processing to the first processing unit 151 (refer to the arrow sign 182). It should be understood that it would also be acceptable for the second processing unit 152 to output the second image data after the second correction processing to the generation unit 323 (refer to the arrow sign 183).

The second processing unit 152, for example, receives from the first processing unit 151 the information 181 relating to the image capture conditions for the pixel for attention P included in the first region, required in order to reduce disparity between the signal data due to discrepancy in the image capture conditions.

On the basis of the first image data from the first processing unit 151 and the second image data that has been subjected to the second correction processing by the second processing unit 152, the generation unit 323 performs image processing such as pixel defect correction processing, color interpolation processing, contour enhancement processing, noise reduction processing, and so on, and outputs the image data after this image processing.

And, on the basis of the second image data that was captured under the certain image capture conditions and that has been subjected to the second correction processing by the second processing unit 152 and the second image data that was captured under the other image capture conditions, the object detection unit 34a performs processing for detection of the elements of the photographic subject, and outputs the results of this detection.

The setting unit 34b performs calculation processing for image capture conditions, such as exposure calculation processing and so on, on the basis of the second image data that was captured under the certain image capture conditions and that has been subjected to the second correction processing by the second processing unit 152, and the second image data that was captured under the other image capture conditions. And, on the basis of the results of this calculation, the setting unit 34b subdivides the imaging screen of the image capture unit 32 into a plurality of regions including the photographic subject elements that have been detected, and re-sets the image capture conditions for this plurality of regions.

Moreover, the lens movement control unit 34d performs focus detection processing on the basis of the second image data that was captured under the certain image capture conditions and that has been subjected to the second correction processing by the second processing unit 152, and the second image data that was captured under the other image capture conditions. On the basis of the result of this calculation, the lens movement control unit 34d outputs a drive signal for shifting the focusing lens of the image capture optical system 31 to its focusing position.

4. As still another example, a case will be explained with reference to Fig. 29 in which the first image capture conditions that are set for the first image capture region 141 are different for different regions of the imaging screen, and also the second image capture conditions that are set for the second image capture region 142 are different for different regions of the imaging screen.

The first image data captured under the first image capture conditions that are different for different regions of the image screen are outputted from the pixels included in the first image capture region 141, and the second image data captured under the second image capture conditions that are different for different regions of the image screen are outputted from the pixels included in the second image capture region 142. The first image data from the first image capture region 141 are outputted to the first processing unit 151. In a similar manner, the second image data from the second image capture region 142 are outputted to the second processing unit 152.

According to requirements, the first processing unit 151 performs, upon the first image data, the first correction processing described above and also the second correction processing described above, or alternatively the first correction processing described above or the second correction processing described above.

And, according to requirements, the second processing unit 152 performs, upon the second image data, the first correction processing described above and also the second correction processing described above, or alternatively the first correction processing described above or the second correction processing described above.

In this example, as described above, the first image capture conditions that are set for the first image capture region 141 are different for different regions of the imaging screen. In other words, the first image capture conditions are different depending upon the partial region of the first image capture region 141. If the pixel for attention P and the reference pixel Pr are position in the first image capture region 141 and the different first image capture conditions are set for the pixel for attention P and for the reference pixel Pr, then the first processing unit 151 performs the second correction processing upon the first image data from this reference pixel Pr, similar to the second correction processing described in 1-2 above. It should be understood that, if the same first image capture conditions are set for the pixel for attention P and for the reference pixel Pr, then the first processing unit 151 does not perform the second correction processing upon the first image data from the reference pixel Pr.

In addition, in this example, since the second image capture conditions that are set for the second image capture region 142 are different for different regions of the imaging screen, accordingly the second processing unit 152 performs the second correction processing upon the second image data, as in Example 3 described above.

On the basis of the first image data from the first processing unit 151 and the second image data upon which the second correction processing has been performed by the second processing unit 152, the generation unit 323 performs image processing such as pixel defect correction processing, color interpolation processing, contour enhancement processing, noise reduction processing, and so on, and outputs image data after this image processing.

On the basis of the second image data that was captured under certain image capture conditions and has been subjected to the second correction processing by the second processing unit 152, and the second image data that was captured under other image capture conditions, the object detection unit 34a performs processing to detect the elements of the photographic subject, and outputs the results of detection.

And, on the basis of the second image data that was captured under certain image capture conditions and has been subjected to the second correction processing by the second processing unit 152, and the second image data that was captured under other image capture conditions, the setting unit 34b performs calculation processing for image capture conditions, such as exposure calculation processing and so on. On the basis of the result of this calculation, the setting unit 34b subdivides the imaging screen of the image capture unit 32 into a plurality of regions including the elements of the photographic subject that have been detected, and also resets the image capture conditions for this plurality of regions.

Yet further, on the basis of the second image data that was captured under certain image capture conditions and has been subjected to the second correction processing by the second processing unit 152, and the second image data that was captured under other image capture conditions, the lens movement control unit 34d performs focus detection processing. And, on the basis of the results of that calculation, the lens movement control unit 34d outputs a drive signal for causing the focusing lens of the image capture optical system 31 to shift to its focusing position.

### Variant 14

In the second embodiment described above, it was arranged for each one of the correction units 322 to correspond to one of the blocks 111a (i.e. the unit subdivisions). However, it would also be acceptable to arrange for each one of the correction units 322 to correspond to one compound block (i.e. a compound subdivision) that includes a plurality of the blocks 111a (i.e. the unit subdivisions). In this case, the correction unit 322 corrects the image data from the pixels included in the plurality of blocks 111a that belong to one compound block sequentially. Even in a caser where a plurality of correction units 322 are provided to respectively correspond to compound blocks each of which include a plurality of the blocks 111a, since the second correction processing of the image data can be performed by the plurality of correction units 322 by parallel processing, accordingly it is possible to alleviate the burden of processing upon the correction units 322, and it is possible to generate an appropriate image in a short time period from the image data respectively generated by each of the regions whose image capture conditions are different.

### Variant 15

In the second embodiment described above, the generation unit 323 was provided internally to the image capture unit 32A. However it would also be acceptable to provide the generation unit 323 externally to the image capture unit 32A. Even if the generation unit 323 is provided externally to the image capture unit 32A, it is still possible to obtain advantageous operational effects similar to the advantageous operational effects described above.

### Variant 16

In the second embodiment described above, in addition to the backside illuminated type image capture chip 111, the signal processing chip 112, and the memory chip 113, the laminated type imaging element 100A also further included the image processing chip 114 that performed the pre processing and the image processing described above. However, it would also be acceptable not to provide such an image processing chip 114 to the laminated type imaging element 100A, but instead to provide the image processing unit 32c to the signal processing chip 112.

### Variant 17

In the second embodiment described above, the second processing unit 152 receive , from the first processing unit 151, the information relating to the first image capture conditions that is required for reducing the disparity between sets of the image data due to discrepancy in the image capture conditions. Moreover, the first processing unit 151 receives, from the second processing unit 152, the information relating to the second image capture conditions that is required for reducing the disparity between sets of the image data due to discrepancy in the image capture conditions. However, it would also be acceptable for the second processing unit 152 to receive information relating to the first image capture conditions, required for reducing the disparity between sets of the image data due to discrepancy in the image capture conditions, from the drive unit 32b and/or from the control unit 34. In a similar manner, it would also be acceptable for the first processing unit 151 to receive information relating to the second image capture conditions, required for reducing the disparity between sets of the image data due to discrepancy in the image capture conditions, from the drive unit 32b and/or from the control unit 34.

It should be understood that it would be acceptable to combine any of the various embodiments with any of variant embodiments described above.

The image capture optical system 31 described above may also include a zoom lens and/or a tilt-shift lens. The lens movement control unit 34d adjusts the angle of view by the image capture optical system 31 by shifting the zoom lens in the direction of the optical axis. In other words, by shifting the zoom lens, it is possible to perform adjustment of the image produced by the image capture optical system 31 so as to obtain an image of the photographic subject over a wide range, to obtain a large image for a faraway photographic subject, and the like.

Furthermore, the lens movement control unit 34d is able to adjust for distortion of the image due to the image capture optical system 31 by shifting the tilt-shift lens in the direction orthogonal to the optical axis.

The pre processing described above is performed on the basis of the consideration that it is preferable to employ the image data after the pre processing described above for adjusting the state of the image produced by the image capture optical system 31 (for example, the state of the angle of view, or the state of image distortion).

While, in the above description, various embodiments and variant embodiments have been explained, the present invention is not to be considered as being limited to the details thereof. Other modes of implementation that are conceivable within the range of the technical concept of the present invention are also included within its scope.

In the first embodiment and the second embodiment described above, the correction unit 33b performs correction of the main image data item of a block for attention in which clipped whites or crushed blacks have occurred in the main image data on the basis of the image data for processing. However, it would also be acceptable for the correction unit 33b to take a block in which clipped whites or crushed blacks have not occurred as being the block for attention. For example, in Fig. 8 in the first embodiment, the first correction processing may also be performed upon the main image data items outputted by the pixels 85b and 85d where no clipped whites or crushed blacks are present. In the first embodiment and the second embodiment described above, the first correction processing replaced a part of the main image data by employing the image data for processing, but, if no clipped whites or crushed blacks have occurred in the outputs of the pixels 85b and 85d, then, as the first correction processing, it would also be acceptable to correct the outputs of the pixels 85b and 85d that have outputted main image data by employing the image capture conditions under which the image data for processing was captured. Furthermore, if no clipped whites or crushed blacks have occurred in the outputs of the pixels 85b and 85d, then, as the first correction processing, it would be acceptable to correct the outputs of the pixels 85b and 85d that have outputted main image data by employing a signal value (i.e. a pixel value) of the image data for processing. This correction is performed so that, by correcting the signal values of the pixels 85b and 85d of the block 85 for which the first image capture conditions have been set in capture of the main image data, the difference between the signal values after correction and a signal value of a pixel of a block for which the fourth image capture conditions were set may be reduced (smoothed) to become smaller than the difference between the signal values before correction and the signal value of the pixel of the block for which the fourth image capture conditions were set.

As explained in connection with the first embodiment and the second embodiment described above, the control unit 34 determines, based on the image data (i.e. the signal value of the pixel) of the block 85 for which the main image data has been outputted, whether or not to perform correction (i.e. replacement) of the image data of the block 85 by employing a value of the pixel of the image data for processing. In other words, if clipped whites or crushed blacks occur in the image data for the block 85 that has outputted the main image data, then the control unit 34 selects a pixel that has outputted the image data for processing, and replaces the image data in which clipped whites or crushed blacks have occurred with the image data of the selected pixel (i.e. the signal value of the pixel). It should be understood that it would also be acceptable to impose, as a condition for employing the values of the pixels of the image data for processing, that the image data of the block 85 which has outputted the main image data (i.e. the signal value of the pixel) should be greater than or equal to a first threshold value or less than or equal to a second threshold value. Moreover, if clipped whites or crushed blacks have not occurred in the image data for the block 85, then the control unit 34 employs the image data of the block 85 (i.e. the pixel value of its pixel). In this case, as the first correction processing as described above, it would also be acceptable to perform correction by employing the image capture conditions under which the image data for processing was captured, or to correct the outputs of the pixels 85b and 85d that outputted the main image data by employing the signal values (i.e. the pixel values) of the image data for processing. Furthermore, even if there are no clipped whites or crushed blacks in the image data for the block 85 that has outputted the main image data, still it will be acceptable for the control unit 34 to select the pixel from which the image data for processing has been outputted, ant to replace the image data in which clipped whites or crushed blacks have occurred with the image data of the selected pixel (i.e. with the signal value of the pixel). Yet further, it will also be acceptable for the control unit 34 to perform recognition of the photographic subject, and to perform the first correction processing on the basis of the result of that recognition. For example, before the main image capture, the setting unit 34b may set image capture conditions that are different from the first image capture conditions, and the object detection unit 34a may perform photographic subject recognition. And it would also be acceptable to employ signal values of pixels that have captured an image of the same photographic subject as the region (for example, the pixels 85b and 85d) that captured the image under the first image capture conditions and upon which correction is performed. In this manner, as explained in connection with the first embodiment and the second embodiment, for the photographic subject whose image was captured by setting the first image capture conditions, the correction processing is performed so that as if it was captured by setting the fourth image capture conditions.

The content of the disclosure of the following application, upon which priority is claimed, is hereby incorporated herein by reference.
Japanese Patent Application No. 2016-71974 (filed on March 31, 2016).

### REFERENCE SIGNS LIST

1, 1C: cameras
1B: image capturing system
31: image capture optical system
32: image capture unit
32a, 100: imaging element
33: image processing unit
33a, 321: input unit
33b, 322: correction unit
33c, 323: generation unit
34: control unit
34a: object detection unit
34b: setting unit
34c: image capture control unit
34d: lens movement control unit
35: display unit
38: photometric sensor
80: predetermined range
90: region for attention
1001: imaging device
1002: display device
P: pixel for attention

## Claims

1. An imaging device, comprising:
an image capture unit having a first image capture region that performs image capture under first image capture conditions, and a second image capture region that performs image capture under second image capture conditions that are different from the first image capture conditions; and
a generation unit that generates an image of a photographic subject captured in the first image capture region according to image data based on light captured under the second image capture conditions.

2. An imaging device, comprising:
an image capture unit having a first image capture region that performs image capture under first image capture conditions, and a second image capture region that performs image capture under second image capture conditions that are different from the first image capture conditions; and
a generation unit that generates image data for a photographic subject captured in the first image capture region according to image data based on light captured under the second image capture conditions.

3. The imaging device according to claim 1 or claim 2, wherein:
the generation unit generates an image of the photographic subject captured in the first image capture region according to image data based on light captured by the image capture unit under the second image capture conditions; and
image data based on light captured by the image capture unit under the second image capture conditions is different from image data according to which an image of the photographic subject captured in the first image capture region is generated by the generation unit.

4. The imaging device according to claim 3, wherein
the generation unit generates an image of the photographic subject captured in the first image capture region according to image data based on light incident upon the first image capture region and captured by the image capture unit under the second image capture conditions.

5. The imaging device according to claim 3, wherein
the generation unit generates an image of the photographic subject captured in the first image capture region according to image data based on light incident upon the second image capture region and captured by the image capture unit under the second image captured conditions.

6. The imaging device according to any one of claims 3 through 5, wherein
image data based on light captured by the image capture unit under the second image capture conditions is captured by the image capture unit before image data according to which an image of the photographic subject captured in the first image capture region is generated by the generation unit.

7. The imaging device according to any one of claims 3 through 5, wherein
image data based on light captured by the image capture unit under the second image capture conditions is captured by the image capture unit after image data according to which an image of the photographic subject captured in the first image capture region is generated by the generation unit.

8. The imaging device according to claim 1 or claim 2, wherein
the generation unit generates an image of the photographic subject captured in the first image capture region according to image data based on light captured under the second image conditions by another image capture unit that is different from the image capture unit.

9. The imaging device according to claim 1 or claim 2, further comprising:
a storage unit that stores image data based on light captured under the second image capture conditions, wherein
the generation unit generates an image of the photographic subject captured in the first image capture region according to image data based on light captured under the second image capture conditions that are stored in the storage unit.

10. The imaging device according to claim 1 or claim 2, wherein
the generation unit generates an image of a part of the photographic subject captured in the first image capture region according to image data based on light captured under the second image capture conditions.

11. The imaging device according to claim 1 or claim 2, wherein
the generation unit generates an image of the photographic subject captured in the first image capture region according to image data based on light of the photographic subject captured under the second image capture conditions.

12. The imaging device according to claim 1 or claim 2, wherein
the generation unit generates an image of the photographic subject captured in the first image capture region that would have been captured under the second image capture conditions, according to image data based on light from the photographic subject captured under the second image capture conditions.

13. The imaging device according to claim 5, wherein
an area of the second image capture region is greater than an area of the first image capture region.

14. The imaging device according to claim 5, wherein
an area of the second image capture region is less than or equal to an area of the first image capture region.

15. The imaging device according to claim 14, wherein
the area of the second image capture region is smaller than the area of the first image capture region.

16. The imaging device according to claim 5, wherein
the generation unit generates an image of the photographic subject captured in the first image capture region according to image data for the photographic subject captured in a partial region of the second image capture region.

17. The imaging device according to claim 5, wherein:
the second image capture region comprises a first region including a photoelectric conversion unit that converts light to charge, and a second region, different from the first region, including a photoelectric conversion unit that converts light to charge; and
the generation unit generates an image of the photographic subject captured in the first image capture region according to image data for the photographic subject captured in one of the first region and the second region.

18. The imaging device according to claim 17, wherein
if an interval between the first image capture region and the first region is shorter than an interval between the first image capture region and the second region, the generation unit generates an image of the photographic subject captured in the first image capture region according to light from the photographic subject captured in the first region, among the first region and the second region.

19. The imaging device according to claim 5, wherein
the generation unit generates an image of the photographic subject captured in the first image capture region according to data calculated from image data for the photographic subject captured in the second image capture region.

20. The imaging device according to claim 19, wherein
the generation unit generates an image of the photographic subject captured in the first image capture region according to data calculated by averaging image data for the photographic subject captured in the second image capture region.

21. The imaging device according to claim 5, wherein:
the generation unit comprises a first generation unit that generates an image of the photographic subject incident upon the first image capture region, and a second generation unit that generates an image of the photographic subject incident upon the second image capture region; and
the first generation unit generates an image of the photographic subject captured in the first image capture region according to light from the photographic subject incident upon the second image capture region.

22. An imaging device, comprising:
an image capture unit having a first image capture region that performs image capture under first image capture conditions, and a second image capture region that performs image capture under second image capture conditions that are different from said first image capture conditions; and
a generation unit that generates an image of a photographic subject captured in the first image capture region according to image data based on light captured under image capture conditions that are different from the first image capture conditions.

23. The imaging device according to any one of claims 1 through 22, wherein
the image capture unit comprises an image capture chip that includes the first image capture region and the second image capture region, and a processing chip, connected to the image capture chip, and including a conversion unit that converts image data outputted from the image capture chip to digital data.

24. The imaging device according to claim 23, wherein:
the image capture unit comprises a memory chip, connected to the processing chip, and including a storage unit that stores image data that has been converted to digital data by the processing chip; and
the processing chip is disposed between the image capture chip and the memory chip.

25. An image processing device, comprising:
an input unit that receives image data from an image capture unit having a first image capture region that performs image capture under first image capture conditions, and a second image capture region that performs image capture under second image capture conditions that are different from the first image capture conditions; and
a generation unit that generates an image of a photographic subject captured in the first image capture region according to image data based on light captured under the second image capture conditions.

26. An image processing device, comprising:
an input unit that receives image data from an image capture unit having a first image capture region that performs image capture under first image capture conditions, and a second image capture region that performs image capture under second image capture conditions that are different from the first image capture conditions; and
a generation unit that generates image data for a photographic subject captured in the first image capture region according to image data based on light captured under the second image capture conditions.

27. The image processing device according to claim 25 or claim 26, wherein:
the generation unit generates an image of the photographic subject captured in the first image capture region according to image data based on light captured by the image capture unit under the second image capture conditions; and
image data based on light captured by the image capture unit under the second image capture conditions is different from image data according to which an image of the photographic subject captured in the first image capture region is generated by the generation unit.

28. The image processing device according to claim 27, wherein
the generation unit generates an image of the photographic subject captured in the first image region according to image data based on light incident upon the first image capture region, captured by the image capture unit under the second image capture conditions.

29. The image processing device according to claim 27, wherein
the generation unit generates an image of the photographic subject captured in the first image region according to image data based on light incident upon the second image capture region, captured by the image capture unit under the second image capture conditions.

30. The image processing device according to any one of claims 27 through 29, wherein
image data based on light captured by the image capture unit under the second image capture conditions is captured by the image capture unit before image data according to which an image of the photographic subject captured in the first image capture region is generated by the generation unit.

31. The image processing device according to any one of claims 27 through 29, wherein
image data based on light captured by the image capture unit under the second image capture conditions is captured by the image capture unit after image data according to which an image of the photographic subject captured in the first image capture region is generated by the generation unit.

32. The image processing device according to claim 25 or claim 26, wherein
the generation unit generates an image of the photographic subject captured in the first image capture region according to image data based on light captured under the second image capture conditions by another image capture unit that is different from the image capture unit.

33. The image processing device according to claim 25 or claim 26, further comprising:
a storage unit that stores image data based on light captured under the second image capture conditions, wherein
the generation unit generates an image of the photographic subject captured in the first image capture region according to image data based on light captured under the second image capture conditions that are stored in the storage unit.

34. The image processing device according to claim 25 or claim 26, wherein
the generation unit generates an image of a part of the photographic subject captured in the first image capture region according to image data based on light captured under the second image capture conditions.

35. The image processing device according to claim 25 or claim 26, wherein
the generation unit generates an image of said photographic subject captured in the first image capture region according to image data based on light from the photographic subject captured under the second image capture conditions.

36. The image processing device according to claim 25 or claim 26, wherein
the generation unit generates an image of the photographic subject captured in the first image capture region that would have been captured under the second image capture conditions, according to image data based on light from the photographic subject captured under the second image capture conditions

37. The image processing device according to claim 29, wherein
an area of the second image capture region is greater than an area of the first image capture region.

38. The image processing device according to claim 29, wherein
an area of the second image capture region is less than or equal to an area of the first image capture region.

39. The image processing device according to claim 38, wherein
the area of the second image capture region is smaller than the area of the first image capture region.

40. The image processing device according to claim 29, wherein
the generation unit generates an image of the photographic subject captured in the first image capture region according to image data for the photographic subject captured in a partial region of the second capture region.

41. The image processing device according to claim 29, wherein:
the second image capture region includes a first region including a photoelectric conversion unit that converts light to charge, and a second region, different from the first region, including a photoelectric conversion unit that converts light to charge; and
the generation unit generates an image of the photographic subject captured in the first image capture region according to image data for the photographic subject captured in one of the first region and the second region.

42. The image processing device according to claim 41, wherein
the generation unit generates an image of the photographic subject captured in the first image capture region according to light from the photographic subject captured in the first region, among the first region and the second region, if an interval between the first image capture region and the first region is shorter than an interval between the first image capture region and the second region.

43. The image processing device according to claim 29, wherein
the generation unit generates an image of the photographic subject captured in the first image capture region according to data calculated from image data for the photographic subject captured in the second image capture region.

44. The image processing device according to claim 43, wherein
the generation unit generates an image of the photographic subject captured in the first image capture region according to data calculated by averaging image data for the photographic subject captured in the second image capture region.

45. The image processing device according to claim 29, wherein:
the generation unit comprises a first generation unit that generates an image of the photographic subject incident upon the first image capture region, and a second generation unit that generates an image of the photographic subject incident upon the second image capture region; and
the first generation unit generates an image of the photographic subject captured in the first image capture region according to light from the photographic subject incident upon the second image capture region.

46. An image processing device, comprising:
an input unit that receives image data from an image capture unit having a first image capture region that performs image capture under first image capture conditions, and a second image capture region that performs image capture under second image capture conditions that are different from the first image capture conditions; and
a generation unit that generates an image of a photographic subject captured in the first image capture region according to image data based on light captured under image capture conditions that are different from the first image capture conditions.

47. An electronic apparatus, comprising:
a first imaging element having a plurality of image capture regions that capture a photographic subject;
a second imaging element that captures a photographic subject;
a setting unit that sets for a first image capture region image capture conditions that are different from those set for a second image capture region among the plurality of image capture regions of the first imaging element; and
a generation unit that generates an image by correcting a part of an image signal of the photographic subject from the first image capture region, among the plurality of image capture regions, captured under first image capture conditions, according to an image signal of the photographic subject captured by the second imaging element so that as if it was captured under second image capture conditions.

48. An electronic apparatus, comprising:
a first imaging element in which a plurality of pixels are arranged, and having a first image capture region and a second image capture region that capture a photographic subject;
a second imaging element in which a plurality of pixels are arranged, and that captures a photographic subject;
a setting unit that sets for the first image capture region image capture conditions that are different from image capture conditions set for the second image capture region; and
a generation unit that generates an image of the photographic subject captured in the first image capture region, according to a signal from a pixel, among the pixels arranged in the first image capture region of the first imaging element and the pixels arranged in the second imaging element, that is selected by employing a signal from the pixels arranged in the first image capture region.

49. The electronic apparatus according to claim 48, wherein
the generation unit generates an image of the photographic subject captured in the first image capture region according to a signal from the pixels arranged in the second imaging element.

50. The electronic apparatus according to claim 49, wherein
the generation unit generates an image of the photographic subject captured in the first image capture region according to a signal from the pixels that are arranged in the second imaging element and have captured an image, from among a plurality of images captured by the second imaging element under different image capture conditions and generated, selected by employing a signal from the pixels arranged in the first image capture region.

51. The electronic apparatus according to any one of claims 47 through 49, wherein
at least a part of an image capture range of the first imaging element is the same as at least a part of an image capture range of the second imaging element.

52. The electronic apparatus according to any one of claims 47 through 51, wherein
image capture of the photographic subject by the first imaging element and image capture of the photographic subject by the second imaging element are performed substantially simultaneously.

53. An electronic apparatus, comprising:
an imaging element having a plurality of image capture regions that capture a photographic subject;
a setting unit that sets for a first image capture region image capture conditions that are different from those set for a second image capture region among the plurality of image capture regions of the imaging element; and
a generation unit that generates an image by correcting a part of an image signal of the photographic subject from the first image capture region, among the plurality of image capture regions, captured under first image capture conditions, according to an image signal of the photographic subject from the first image capture region captured under second image capture conditions so that as if it was captured under the second image capture conditions.

54. An electronic apparatus, comprising:
an imaging element upon which a plurality of pixels are arranged, and having a first image capture region and a second image capture region that capture a photographic subject;
a setting unit that sets for the first image capture region image capture conditions that are different from image capture conditions set for the second image capture region; and
a generation unit that generates an image of the photographic subject captured in the first image capture region according to a signal from a pixel selected from among the pixels arranged in the first image capture region for which first image capture conditions are set by the setting unit and the pixels arranged in the first image capture region for which second image capture conditions have been set by the setting unit by employing a signal from the pixels arranged in the first image capture region for which the first image capture conditions are set by the setting unit.

55. The electronic apparatus according to claim 54, wherein
the generation unit generates an image of the photographic subject captured in the first image capture region according to a signal from the pixels arranged in the first image capture region for which the second image capture conditions are set by the setting unit.

56. The electronic apparatus according to claim 54, wherein
the generation unit generates an image of the photographic subject captured in at least a part of the first image capture region according to a signal from the pixels arranged in the first image capture region for which the second image capture conditions are set by the setting unit.

57. The electronic apparatus according to any one of claims 53 through 56, wherein
a first image captured in the first image capture region for which the first image capture conditions are set and a second image captured in the first image capture region for which the second image capture conditions are set are different from one another.

58. The electronic apparatus according to claim 57, wherein
the second image is captured before the first image.

59. The electronic apparatus according to claim 57, wherein
the second image is captured after the first image.
